# EUROPEAN PATENT APPLICATION

(11) **EP 4 804 403 A1**
(43) Date of publication of application: **09.09.2026**
(21) Application number: 26161300.4
(22) Date of filing: 27.02.2026
(51) Int. Cl.: H03F 1/32, H03F 3/24, H04B 1/04, H03F 3/189, H04L 27/36

(54) **INFORMATION PROCESSING DEVICE, COMMUNICATION DEVICE, AND INFORMATION PROCESSING METHOD**

(30) Priority: 07.03.2025 JP 2025036892
(71) Applicant: 1FINITY INC., Kawasaki-shi, Kanagawa 211-8588 (JP)
(72) Inventor: OTA, Tomoya, Kawasaki-shi, 211-8588 (JP); OKAWA, Yasuhiro, Kawasaki-shi, 211-8588 (JP); LOZHKIN, Alexander Nikolaevich, Kawasaki-shi, 211-8588 (JP); HAMANO, Mitsuharu, Kawasaki-shi, 211-8588 (JP); KAWANO, Yoichi, Kawasaki-shi, 211-8588 (JP); ISHIKAWA, Hiroyoshi, Kawasaki-shi, 211-8588 (JP)
(74) Representative: Haseltine Lake Kempner LLP

(57) **Abstract**

A first determination unit (212, 222) determines a first distortion compensation coefficient, based on a power or amplitude of a first signal and a power or amplitude of a second signal. A first signal generation unit (131) generates a third signal, based on the first signal and the first distortion compensation coefficient. A second signal generation unit (132) generates a fourth signal, based on the second signal and the first distortion compensation coefficient. A third signal generation unit (15) configured to generate a fifth signal, based on the third signal and the fourth signal.

## Description

### FIELD

The embodiments discussed herein are related to an information processing device, a communication device, and an information processing method.

### BACKGROUND

Wireless communication devices such as base stations are equipped with power amplifiers to amplify the power of transmission signals. A wireless communication device typically allows the power amplifier to operate near the saturation region to increase the power efficiency of the power amplifier. However, when the power amplifier is operated near the saturation region, nonlinear distortion produced by the power amplifier increases. Therefore, in order to suppress this nonlinear distortion and satisfy standards such as adjacent channel leakage ratio (ACLR) and spectrum emission mask (SEM), a distortion compensator is provided in a wireless transmission device to compensate for the nonlinear distortion.

In the field of wireless mobile communications, technologies have been proposed to compensate for nonlinear distortion in power amplifiers used in base stations and the like. One of distortion compensation methods used in distortion compensators is a pre-distortion method. In a distortion compensator employing the pre-distortion method, a transmission signal to be input to a power amplifier is multiplied in advance by a distortion compensation coefficient having the inverse characteristic of nonlinear distortion of the power amplifier. This processing increases the linearity of an output from the power amplifier and suppresses nonlinear distortion of an output from the power amplifier. Known pre-distortion methods include a look-up table (LUT)-type pre-distortion method and a series-type pre-distortion method.

In recent years, communication traffic has continued to increase, and as a countermeasure, wireless communication devices that support wide-band and multiband transmission have become increasingly popular. A conventional wireless communication device that supports single-band transmission has an individual device for each band. In contrast, a wireless communication device that supports multiband transmission can support multiple bands with a single device, thus saving installation space and improving installation efficiency.

In wireless communication devices that support multiband transmission, there are two configurations of power amplifiers that amplify the power of multiband signals: an individual amplification configuration in which the power is individually amplified by an individual power amplifier for each band; and a common amplification configuration in which a multiband signal is commonly amplified by a single power amplifier. In the individual amplification configuration, distortion compensation units that each generate a pre-distortion signal corresponding to the individual power amplifier for each band are used according to the number of bands. In the common amplification configuration, the wireless communication device can use a distortion compensation unit that generates a pre-distortion signal by collective processing for a multiband signal. In this case, the sampling rate of the distortion compensation unit is typically set to provide a digital processing bandwidth that is three to five times the instantaneous bandwidth (IBW). On the other hand, the common amplification of a multiband signal by a single power amplifier can reduce the number of devices compared with the individual amplification configuration, thus reducing the installation area and making the device smaller.

As a distortion compensation technique in multiband transmission, there is proposed a distortion compensation technique that takes into account the influence of the power itself of other bands for a particular band. A technique has been proposed that estimates an estimation envelope of a composite signal input to an amplifier from a plurality of input signals, and determines a distortion compensation coefficient based on the estimated envelope.
Patent Literature 1: Japanese National Publication of International Patent Application No. 2017-503381
Patent Literature 2: International Publication Pamphlet No. WO 2015/045709
Patent Literature 3: Japanese Laid-open Patent Publication No. 2017-208753

In a wireless communication device with the common amplification configuration, if the IBW is approximately below 100 MHz, the nonlinear characteristic of the power amplifier (PA) is relatively similar between bands. Therefore, even if a distortion compensation process for generating a pre-distortion signal is performed by collective processing for a multiband signal, the degradation of distortion compensation performance is not a problem. However, for example, in a case where the distortion compensation process for generating a pre-distortion signal is performed by collective processing for a wide-band multiband signal with IBW of approximately several hundred MHz to several GHz, average compensation is performed even when the nonlinear characteristic of the PA is different for each band. As a result, a portion corresponding to the difference from the average may fail to be compensated and remain as an error, which may degrade distortion compensation performance. In other words, the adjacent channel leakage ratio (ACLR) may deteriorate.

Another possible configuration is to use as many distortion compensation units as the number of bands to generate a pre-distortion signal for each band, so that optimal compensation can be made for distortion in each band even when the nonlinear characteristic of the PA is different for each band. However, it may be possible to compensate for the nonlinear distortion for a particular band that occurs in the power in the particular band, but it may be difficult to suppress the leakage power of adjacent channels, for example. In other words, it may be difficult to compensate for the nonlinear distortion for a particular band that occurs under the influence of other bands.

In addition, the distortion compensation technique that takes into account the influence of the power itself of other bands for a particular band may have difficulty in suppressing the influence of the combined power of the particular band and the other bands, thus deteriorating the adjacent channel leakage ratio. Similarly, the technique that determines a distortion compensation coefficient from the estimation envelope of the composite signal may have difficulty in suppressing the influence of the combined power, for example, in the processing at low sampling rates, thus deteriorating the adjacent channel leakage power ratio.

Accordingly, it is an object in one aspect of an embodiment of the invention to provide an information processing device, a communication device, and an information processing method that suppress leakage power of adjacent channels.

### SUMMARY

According to an aspect of an embodiment, an information processing device includes a memory, and a processor coupled to the memory and configured to determine a first distortion compensation coefficient, based on a power or amplitude of a first signal and a power or amplitude of a second signal, generate a third signal, based on the first signal and the first distortion compensation coefficient, generate a fourth signal, based on the second signal and the first distortion compensation coefficient, and generate a fifth signal, based on the third signal and the fourth signal.

### BRIEF DESCRIPTION OF DRAWINGS

FIG. 1 is a schematic diagram of a wireless communication system;
FIG. 2 is a block diagram of radio equipment according to a first embodiment;
FIG. 3 is a flowchart of a radio signal output process by the radio equipment according to the first embodiment;
FIG. 4 is a hardware configuration diagram of the radio equipment;
FIG. 5 is a block diagram of the radio equipment according to a second embodiment;
FIG. 6 is a block diagram of the radio equipment according to a third embodiment;
FIG. 7 is a block diagram of the radio equipment according to a fourth embodiment;
FIG. 8 is a block diagram of the radio equipment according to modification 4-2;
FIG. 9 is a block diagram of the radio equipment according to modification 4-3;
FIG. 10 is a block diagram of the radio equipment according to a fifth embodiment;
FIG. 11 is a block diagram of the radio equipment according to a sixth embodiment;
FIG. 12 is a block diagram of the radio equipment according to modification 6-1;
FIG. 13 is a block diagram of the radio equipment according to modification 6-2;
FIG. 14 is a block diagram of the radio equipment according to a seventh embodiment;
FIG. 15 is a diagram illustrating a relationship between bands and carriers; and
FIG. 16 is a diagram illustrating suppression of unnecessary waves outside the band of a transmission signal.

### DESCRIPTION OF EMBODIMENTS

Preferred embodiments of the present invention will be explained with reference to accompanying drawings. The following embodiments are not intended to limit the information processing device, the communication device, and the information processing method disclosed in this application.

### (a) First Embodiment

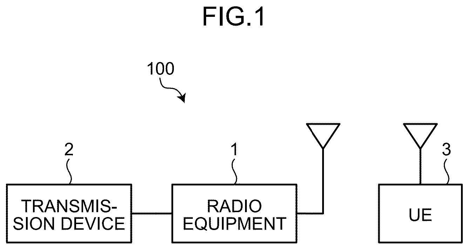

FIG. 1 is a schematic diagram of a wireless communication system. A wireless communication system 100 includes radio equipment 1, a transmission device 2, and user equipment (UE) 3. The transmission device 2 generates a baseband signal based on transmission data. For example, the transmission device 2 generates two baseband signals for two-band multiband transmission. The transmission device 2 then outputs the generated baseband signals to the radio equipment 1. The transmission device 2 is also called a central unit/distributed unit (CU/DU).

The radio equipment 1 receives inputs of baseband signals from the transmission device 2. The radio equipment 1 performs inverse fast Fourier transform (IFFT) for each of the received baseband signals to convert the baseband signal from a frequency domain to a time domain. The radio equipment 1 also performs oversampling to increase the sampling rate of each baseband signal. The radio equipment 1 also performs a peak suppression process on each baseband signal.

In addition, the radio equipment 1 performs a distortion compensation process for each baseband signal. Next, the radio equipment 1 performs frequency shifting on each of the distortion-compensated baseband signals to match each band of multiband transmission. Next, the radio equipment 1 combines the frequency-shifted transmission signals, converts the combined transmission signal from a digital signal to an analog signal, further converts the converted signal to a carrier wave by modulation, and emits the carrier wave into space as a radio wave from an antenna. The radio equipment 1 is also called a radio unit (RU) .

The UE 3 receives a signal transmitted by multiband transmission from the radio equipment 1. The UE 3 then, for example, demodulates the received signal, separates the signal for each band using a low pass filter (LPF) or the like, and then processes each signal.

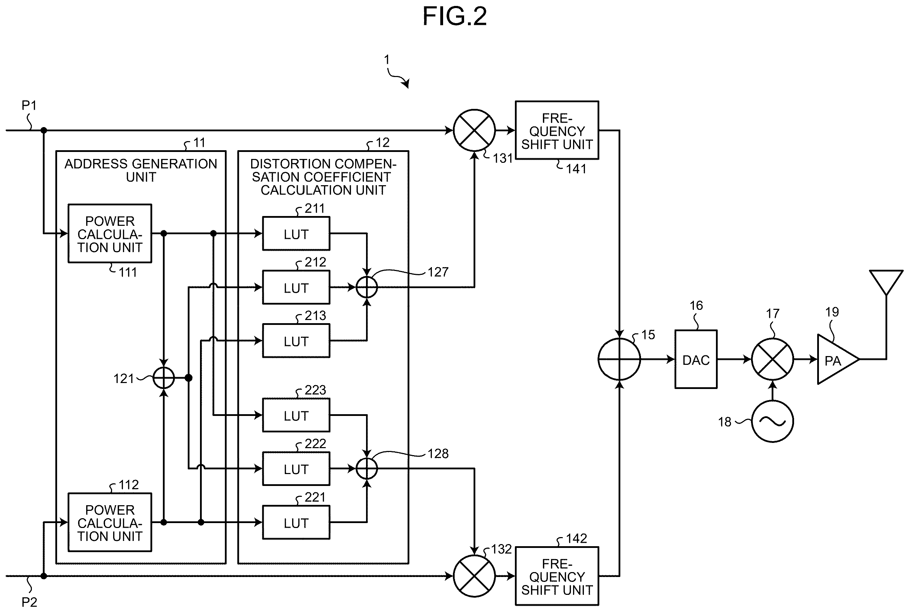

FIG. 2 is a block diagram of the radio equipment according to a first embodiment. Referring to FIG. 2, the details of the distortion compensation process by the radio equipment 1 will be described. In FIG. 2, the functions used for the distortion compensation process and signal transmission in the radio equipment 1 are depicted for the sake of explanation, and other functions are omitted. As illustrated in FIG. 2, the radio equipment 1 includes an address generation unit 11, a distortion compensation coefficient calculation unit 12, multipliers 131 and 132, frequency shift units 141 and 142, and an adder 15. The radio equipment 1 also includes a digital analog convertor (DAC) 16, an up-converter 17, a local oscillator 18, and a power amplifier (PA) 19.

In the present embodiment, a case where the radio equipment 1 performs multiband transmission using two bands, a first band and a second band, will be explained. This radio equipment 1 is an example of "information processing device" and "communication device". The radio equipment 1 has a signal path P1 that receives input of a baseband signal of a first transmission signal to be transmitted in the first band, and a signal path P2 that receives input of a baseband signal of a second transmission signal to be transmitted in the second band.

The address generation unit 11 performs address generation for calculating a distortion compensation coefficient. The address generation unit 11 includes power calculation units 111 and 112 and an adder 121.

The power calculation unit 111 receives input of the baseband first transmission signal input to the signal path P1. The power calculation unit 111 then obtains the power of the first transmission signal by calculating the square of the absolute value of the complex number of the first transmission signal for each sample. The power calculation unit 111 then outputs the calculated power of the first transmission signal as an address to look up tables (LUTs) 211 and 223 in the distortion compensation coefficient calculation unit 12. Hereafter, the address represented by the power of the first transmission signal is referred to as "address of the first transmission signal". The power calculation unit 111 outputs the calculated power of the first transmission signal to the adder 121.

The power calculation unit 112 receives input of the baseband second transmission signal input to the signal path P2. The power calculation unit 112 then obtains the power of the second transmission signal by calculating the square of the absolute value of the complex number of the second transmission signal for each sample. The power calculation unit 112 then outputs the calculated power of the second transmission signal as an address to LUTs 213 and 221 in the distortion compensation coefficient calculation unit 12. Hereafter, the address represented by the power of the second transmission signal is referred to as "address of the second transmission signal". The power calculation unit 112 outputs the calculated power of the second transmission signal to the adder 121.

In the present embodiment, the example of generating addresses based on power has been described. However, the address generation unit 11 may generate addresses using the amplitudes of the first and second transmission signals. The address generation unit 11 may generate addresses using dB obtained by converting power to a logarithmic representation.

The adder 121 receives input of the power of the first transmission signal from the power calculation unit 111. The adder 121 also receives input of the power of the second transmission signal from the power calculation unit 112. The adder 121 then adds the power of the first transmission signal and the power of the second transmission signal to calculate a composite power of the first and second transmission signals. The adder 121 then outputs the added composite power as an address to a LUTs 212 and 222 in the distortion compensation coefficient calculation unit 12. Hereafter, the address represented by the composite power is referred to as "address of the composite power".

The distortion compensation coefficient calculation unit 12 includes three LUTs 211 to 213 for calculating a distortion compensation coefficient for the first transmission signal. The distortion compensation coefficient calculation unit 12 includes three LUTs 221 to 223 for calculating a distortion compensation coefficient for the second transmission signal. The distortion compensation coefficient calculation unit 12 further includes adders 127 and 128.

The LUT 211 is, for example, a table in which a distortion compensation coefficient for distortion compensation for the first transmission signal with respect to the power of the first transmission signal itself is stored in association with the address of the first transmission signal. The LUT 212 is, for example, a table in which a distortion compensation coefficient for distortion compensation for the first transmission signal with respect to the composite power is stored in association with the address of the composite power. The LUT 213 is, for example, a table in which a distortion compensation coefficient for distortion compensation for the first transmission signal with respect to the power of the second transmission signal is stored in association with the address of the second transmission signal.

The LUT 221 is, for example, a table in which a distortion compensation coefficient for distortion compensation for the second transmission signal with respect to the power of the second transmission signal itself is stored in association with the address of the second transmission signal. The LUT 222 is, for example, a table in which a distortion compensation coefficient for distortion compensation for the second transmission signal with respect to the composite power is stored in association with the address of the composite power. The LUT 223 is, for example, a table in which a distortion compensation coefficient for distortion compensation for the second transmission signal with respect to the power of the first transmission signal is stored in association with the address of the first transmission signal.

The LUT 211, for example, reads the distortion compensation coefficient corresponding to the address of the first transmission signal input from the power calculation unit 111 and outputs the read distortion compensation coefficient to the adder 127 as a distortion compensation coefficient for distortion compensation for the first transmission signal with respect to the power of the first transmission signal itself. The LUT 212, for example, reads the distortion compensation coefficient corresponding to the address of the composite power input from the adder 121 and outputs the read distortion compensation coefficient to the adder 127 as a distortion compensation coefficient for distortion compensation for the first transmission signal with respect to the composite power. The LUT 213, for example, reads the distortion compensation coefficient corresponding to the address of the second transmission signal input from the power calculation unit 112 and outputs the read distortion compensation coefficient to the adder 127 as a distortion compensation coefficient for distortion compensation for the first transmission signal with respect to the power of the second transmission signal.

The LUT 221 reads the distortion compensation coefficient corresponding to the address of the second transmission signal input from the power calculation unit 112 and outputs the read distortion compensation coefficient to the adder 128 as a distortion compensation coefficient for distortion compensation for the second transmission signal with respect to the power of the second transmission signal itself. The LUT 222 reads the distortion compensation coefficient corresponding to the address of the composite power input from the adder 121 and outputs the read distortion compensation coefficient to the adder 128 as a distortion compensation coefficient for distortion compensation for the second transmission signal with respect to the composite power. The LUT 223 reads the distortion compensation coefficient corresponding to the address of the first transmission signal input from the power calculation unit 111 and outputs the read distortion compensation coefficient to the adder 128 as a distortion compensation coefficient for distortion compensation for the second transmission signal with respect to the power of the first transmission signal.

Here, the first transmission signal is an example of "first signal", and the second transmission signal is an example of "second signal". The LUTs 212 and 222 are examples of "first determination unit". Furthermore, the distortion compensation coefficient for distortion compensation for the first transmission signal with respect to the composite power and the distortion compensation coefficient for distortion compensation for the second transmission signal with respect to the composite power are examples of "first distortion compensation coefficient". In other words, the first determination unit determines the first distortion compensation coefficient based on the power or amplitude of the first signal and the power or amplitude of the second signal. The first determination unit determines the first distortion compensation coefficient using a look-up table.

The adder 127 receives inputs of the respective distortion compensation coefficients for the first transmission signal from the LUTs 211 to 213. The adder 127 then adds the input three distortion compensation coefficients to calculate a distortion compensation coefficient of the first transmission signal that collectively compensates for nonlinear distortion due to the power of the first transmission signal itself, the power of the composite signal, and the power of the second transmission signal, for the first transmission signal. The adder 127 then outputs the calculated distortion compensation coefficient of the first transmission signal to the multiplier 131.

The adder 128 receives inputs of the respective distortion compensation coefficients for the second transmission signal from the LUTs 221 to 223. The adder 128 then adds the input three input distortion compensation coefficients to calculate a distortion compensation coefficient of the second transmission signal that collectively compensates for nonlinear distortion due to the power of the second transmission signal itself, the power of the composite signal, and the power of the first transmission signal, for the second transmission signal. The adder 128 then outputs the calculated distortion compensation coefficient of the second transmission signal to the multiplier 132.

Here, a combination of the LUT 211 or 213 and the adder 127, and a combination of the LUT 221 or 223 and the adder 128 are examples of "second determination unit". The distortion compensation coefficient for distortion compensation for the first transmission signal with respect to the power of the first transmission signal itself or the distortion compensation coefficient for distortion compensation for the first transmission signal with respect to the power of the second transmission signal are examples of "second distortion compensation coefficient". The distortion compensation coefficient for distortion compensation for the second transmission signal with respect to the power of the second transmission signal itself or the distortion compensation coefficient for distortion compensation for the second transmission signal with respect to the power of the first transmission signal are examples of "second distortion compensation coefficient". The "distortion compensation coefficient of the first transmission signal" generated by the adder 127 and the "distortion compensation coefficient of the second transmission signal" generated by the adder 128 are examples of "third distortion compensation coefficient". In other words, the second determination unit determines the second distortion compensation coefficient based on the first signal or the second signal, and determines the third distortion compensation coefficient based on the first distortion compensation coefficient and the second distortion compensation coefficient.

A combination of the LUTs 211 and 213 and the adder 127, and a combination of the LUTs 221 and 223 and the adder 128 are examples of "third determination unit". The distortion compensation coefficient for distortion compensation for the first transmission signal with respect to the power of the first transmission signal itself and the distortion compensation coefficient for distortion compensation for the second transmission signal with respect to the power of the first transmission signal are examples of "fourth distortion compensation coefficient". The distortion compensation coefficient for distortion compensation for the first transmission signal with respect to the power of the second transmission signal and the distortion compensation coefficient for distortion compensation for the second transmission signal with respect to the power of the second transmission signal itself are examples of "fifth distortion compensation coefficient". The "distortion compensation coefficient of the first transmission signal" generated by the adder 127 and the "distortion compensation coefficient of the second transmission signal" generated by the adder 128 are examples of "sixth distortion compensation coefficient". In other words, the third determination unit determines the fourth distortion compensation coefficient based on the first signal, determines the fifth distortion compensation coefficient based on the second signal, and determines the sixth distortion compensation coefficient based on the first distortion compensation coefficient, the fourth distortion compensation coefficient, and the fifth distortion compensation coefficient.

The multiplier 131 receives input of the first transmission signal input to the signal path P1. The multiplier 131 also receives input of the distortion compensation coefficient of the first transmission signal from the adder 127. The multiplier 131 then performs distortion compensation for the first transmission signal by multiplying the first transmission signal and the distortion compensation coefficient of the first transmission signal. In this way, the multiplier 131 performs distortion compensation for the first transmission signal with respect to the power of the first transmission signal itself, the power of the composite signal, and the power of the second transmission signal. The multiplier 131 then outputs the distortion-compensated first transmission signal as a pre-distortion signal in the first band to the frequency shift unit 141.

This multiplier 131 is an example of "first signal generation unit". The pre-distortion signal in the first band calculated by the multiplier 131 is an example of "third signal". In other words, the first signal generation unit generates the third signal based on the first signal and the first distortion compensation coefficient. The first signal generation unit also generates the third signal based on the first signal and the third distortion compensation coefficient. The first signal generation unit also generates the third signal based on the first signal and the sixth distortion compensation coefficient.

The multiplier 132 receives input of the second transmission signal input to the signal path P2. The multiplier 132 also receives input of the distortion compensation coefficient of the second transmission signal from the adder 128. The multiplier 132 then performs distortion compensation for the second transmission signal by multiplying the second transmission signal and the distortion compensation coefficient of the second transmission signal. In this way, the multiplier 132 performs distortion compensation for the second transmission signal with respect to the power of the second transmission signal itself, the power of the composite signal, and the power of the first transmission signal. The multiplier 132 then outputs the distortion-compensated second transmission signal as a pre-distortion signal in the second band to the frequency shift unit 142.

This multiplier 132 is an example of "second signal generation unit". The pre-distortion signal in the second band calculated by the multiplier 132 is an example of "fourth signal". In other words, the second signal generation unit generates the fourth signal based on the second signal and the first distortion compensation coefficient. The second signal generation unit also generates the fourth signal based on the second signal and the third distortion compensation coefficient. The second signal generation unit also generates the fourth signal based on the second signal and the sixth distortion compensation coefficient.

The frequency shift unit 141 receives input of the first transmission signal, which is the pre-distortion signal in the first band. The frequency shift unit 141 then shifts the frequency of the first transmission signal to a frequency band assigned to the first band. The frequency shift unit 141 then outputs the frequency-shifted first transmission signal to the adder 15.

The frequency shift unit 142 receives input of the second transmission signal, which is the pre-distortion signal in the second band. The frequency shift unit 142 then shifts the frequency of the second transmission signal to a frequency band assigned to the second band. The frequency shift unit 142 then outputs the frequency-shifted second transmission signal to the adder 15.

The adder 15 receives input of the first transmission signal, which is the pre-distortion signal with a frequency shifted to the frequency band of the first band, from the frequency shift unit 141. The adder 15 also receives input of the second transmission signal, which is the pre-distortion signal with a frequency shifted to the frequency band of the second band, from the frequency shift unit 142. The adder 15 then adds the first and second transmission signals to generate a composite signal of the first and second transmission signals, which is a pre-distortion signal. The adder 15 then outputs the generated composite signal, which is a pre-distortion signal, to the DAC 16.

This adder 15 is an example of "third signal generation unit", and the composite signal of the first and second transmission signals, which is the pre-distortion signal generated by the adder 15, is an example of "fifth signal". In other words, the adder 15, which is the third signal generation unit, generates the fifth signal based on the third and fourth signals.

The DAC 16 receives input of the composite signal, which is a pre-distortion signal, from the adder 15. The DAC 16 then converts the composite signal from a digital signal to an analog signal. The DAC 16 then outputs the composite signal, which is the pre-distortion signal converted to an analog signal, to the up-converter 17.

The up-converter 17 receives input of the composite signal, which is the pre-distortion signal converted to an analog signal, from the DAC 16. The up-converter 17 then multiplies the composite signal and a local signal input from the local oscillator 18 to convert the composite signal to a radio frequency. The up-converter 17 then outputs the composite signal, which is the pre-distortion signal converted to a radio frequency, to the PA 19.

The PA 19 receives input of the composite signal, which is the pre-distortion signal converted to a radio frequency, from the up-converter 17. The PA 19 then amplifies the power of the composite signal, which is a pre-distortion signal. The radio equipment 1 then emits the power-amplified composite signal into space from the antenna as a radio wave.

The entire process will now be explained using an example of the first and second transmission signals. For example, let f_{L} be the frequency of the first band and f_{H} be the frequency of the second band. Letting x₁(n) be the first transmission signal and x₂(n) be the second transmission signal, a signal transition will be described.

The address generation unit 11 generates, for the first transmission signal, an address A₁₁ = |x₁(n)|² of the first transmission signal, an address A₁₂ = |x₁(n)|²+|x₂(n)|² of the composite power, and an address A₁₃ = |x₂(n)|² of the second transmission signal.

The address generation unit 11 also generates, for the second transmission signal, an address A₂₁ = |x₂(n)|² of the second transmission signal, an address A₂₂ = |x₁(n)|² + |x₂(n)|² of the composite power, and an address A₂₃ = |x₁(n)|² of the first transmission signal.

The LUT 211 receives input of the address A₁₁ of the first transmission signal from the address generation unit 11 and outputs LUT_{1,1}(A₁₁) as a distortion compensation coefficient. LUT_{1,1}(A₁₁) is the distortion compensation coefficient for distortion compensation for the first transmission signal with respect to the power of the first transmission signal itself. The LUT 212 receives input of the address A₁₂ of the composite signal from the address generation unit 11 and outputs LUT_{1,2}(A₁₂) as a distortion compensation coefficient. LUT_{1,2}(A₁₂) is the distortion compensation coefficient for distortion compensation for the first transmission signal with respect to the composite power. The LUT 213 receives input of the address A₁₃ of the second transmission signal from the address generation unit 11 and outputs LUT_{1,3}(A₁₃) as a distortion compensation coefficient. LUT_{1,3}(A₁₃) is the distortion compensation coefficient for distortion compensation for the first transmission signal with respect to the power of the second transmission signal.

The LUT 221 receives input of the address A₂₁ of the second transmission signal from the address generation unit 11 and outputs LUT_{2,1}(A₂₁) as a distortion compensation coefficient. LUT_{2,1}(A₂₁) is the distortion compensation coefficient for distortion compensation for the second transmission signal with respect to the power of the second transmission signal itself. The LUT 222 receives input of the address A₂₂ of the composite signal from the address generation unit 11 and outputs LUT_{2,2}(A₂₂) as a distortion compensation coefficient. LUT_{2,2}(A₂₂) is the distortion compensation coefficient for distortion compensation for the second transmission signal with respect to the composite power. The LUT 223 receives input of the address A₂₃ of the first transmission signal from the address generation unit 11 and outputs LUT_{2,3}(A₂₃) as a distortion compensation coefficient. LUT_{2,3}(A₂₃) is the distortion compensation coefficient for distortion compensation for the second transmission signal with respect to the power of the first transmission signal.

The adder 127 calculates the distortion compensation coefficient of the first transmission signal as LUT_{SUM-1} = LUT_{1,1}(A₁₁) + LUT_{1,2}(A₁₂) + LUT_{1,3}(A₁₃). The adder 128 calculates the distortion compensation coefficient of the second transmission signal as LUT_{SUM-2} = LUT_{2,1}(A₂₁) + LUT_{2,2}(A₂₂) + LUT_{2,3}(A₂₃).

The multiplier 131 calculates u₁(n), which is the pre-distortion signal in the first band, by multiplying the first transmission signal x₁(n) and the distortion compensation coefficient LUT_{SUM-1} of the first transmission signal. In other words, the multiplier 131 obtains u₁(n), which is the pre-distortion signal in the first band, by u₁(n) = x₁(n) × LUT_{SUM-1}. The multiplier 132 also calculates u₂(n), which is the pre-distortion signal in the second band, by multiplying the second transmission signal x₂(n) and the distortion compensation coefficient LUT_{SUM-2} of the second transmission signal. In other words, the multiplier 132 obtains u₂(n), which is the pre-distortion signal in the second band, by u₂(n) = x₂(n) × LUT_{SUM-2}.

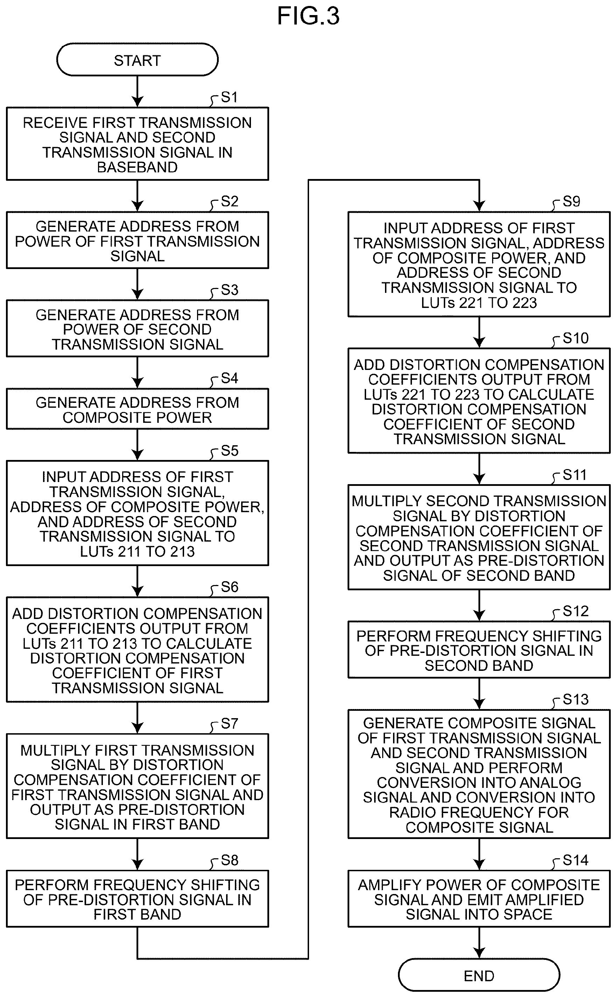

FIG. 3 is a flowchart of a radio signal output process by the radio equipment according to the first embodiment. Referring now to FIG. 3, the flow of the radio signal output process by the radio equipment 1 according to the first embodiment will be described.

The radio equipment 1 receives the baseband first and second transmission signals (step S1).

The power calculation unit 111 receives input of the baseband first transmission signal via the signal path P1. The power calculation unit 111 then calculates the power of the first transmission signal and generates the address of the first transmission signal (step S2).

The power calculation unit 112 receives input of the baseband second transmission signal via the signal path P2. The power calculation unit 112 then calculates the power of the second transmission signal and generates the address of the second transmission signal (step S3).

The adder 121 generates the address of the composite power by adding the power of the first transmission signal input from the power calculation unit 111 and the power of the second transmission signal input from the power calculation unit 112 (step S4).

The LUT 211 receives input of the address of the first transmission signal from the power calculation unit 111. The LUT 212 receives input of the address of the composite power from the adder 121. The LUT 213 receives input of the address of the second transmission signal from the power calculation unit 112 (step S5).

The LUT 211 outputs to the adder 127 the distortion compensation coefficient for distortion compensation for the first transmission signal with respect to the power of the first transmission signal itself, corresponding to the address of the first transmission signal. The LUT 212 outputs to the adder 127 the distortion compensation coefficient for distortion compensation for the first transmission signal with respect to the composite power, corresponding to the address of the composite power. The LUT 213 outputs to the adder 127 the distortion compensation coefficient for distortion compensation for the first transmission signal with respect to the power of the second transmission signal, corresponding to the address of the second transmission signal. The adder 127 adds the input three distortion compensation coefficients to calculate the distortion compensation coefficient of the first transmission signal (step S6).

The multiplier 131 performs distortion compensation for the first transmission signal by multiplying the first transmission signal sent via the signal path P1 by the distortion compensation coefficient of the first transmission signal and outputs the result as a pre-distortion signal in the first band to the frequency shift unit 141 (step S7).

The frequency shift unit 141 performs frequency shifting of the pre-distortion signal in the first band (step S8).

The LUT 221 receives input of the address of the second transmission signal from the power calculation unit 112. The LUT 222 receives input of the address of the composite power from the adder 121. The LUT 223 receives input of the address of the first transmission signal from the power calculation unit 111 (step S9).

The LUT 223 outputs to the adder 128 the distortion compensation coefficient for distortion compensation for the second transmission signal with respect to the power of the first transmission signal, corresponding to the address of the first transmission signal. The LUT 222 outputs to the adder 128 the distortion compensation coefficient for distortion compensation for the second transmission signal with respect to the composite power, corresponding to the address of the composite power. The LUT 221 outputs to the adder 128 the distortion compensation coefficient for distortion compensation for the second transmission signal with respect to the power of the second transmission signal itself, corresponding to the address of the second transmission signal. The adder 128 adds the input three distortion compensation coefficients to calculate the distortion compensation coefficient of the second transmission signal (step S10).

The multiplier 132 performs distortion compensation for the second transmission signal by multiplying the second transmission signal sent via the signal path P2 by the distortion compensation coefficient of the second transmission signal and outputs the result as a pre-distortion signal in the second band to the frequency shift unit 142 (step S11).

The frequency shift unit 142 performs frequency shifting of the pre-distortion signal in the second band (step S12).

The adder 15 adds the first transmission signal, which is a pre-distortion signal having a frequency in a frequency band of the first band, and the second transmission signal, which is a pre-distortion signal having a frequency in a frequency band of the second band, to generate a composite signal of the first and second transmission signals. The DAC 16 converts the composite signal, which is a pre-distortion signal, from a digital signal to an analog signal. The up-converter including the up-converter 17 and the local oscillator 18 converts the frequency of the composite signal, which is a pre-distortion signal, to a radio frequency (step S13).

The PA 19 amplifies the power of the composite signal, which is the pre-distortion signal converted to a radio frequency. The radio equipment 1 then emits the power-amplified composite signal into space from an antenna as a radio wave (step S14).

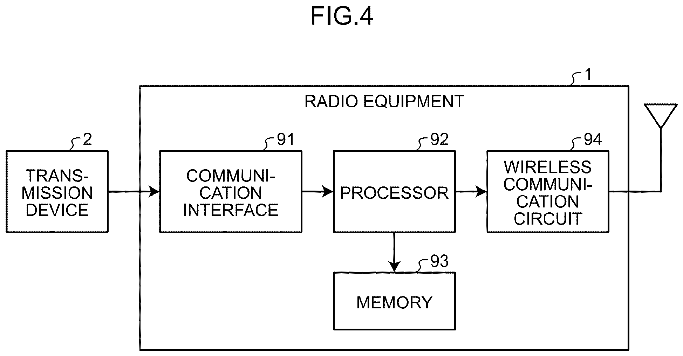

FIG. 4 is a hardware configuration diagram of the radio equipment. As illustrated in FIG. 4, the radio equipment 1 includes, for example, a communication interface 91, a processor 92, a memory 93, and a wireless communication circuit 94.

The communication interface 91 mediates communication between the processor 92 and an external device. For example, the communication interface 91 outputs the first and second transmission signals input from the transmission device 2 to the processor 92.

The memory 93 is a storage device such as a dynamic random access memory (DRAM), a hard disk, or a read only memory (ROM). The memory 93 can store therein the LUTs 211 to 213 and 221 to 223, which are one-dimensional LUTs, three for each of the first and second transmission signals illustrated in FIG. 2. The memory 93 also stores therein various computer programs, including a computer program for implementing the functions of the address generation unit 11, the distortion compensation coefficient calculation unit 12, the multipliers 131 and 132, and the frequency shift units 141 and 142. The memory 93 is used by the processor 92 to read and write data.

The processor 92 is, for example, a central processing unit (CPU) or a field programmable gate array (FPGA). The processor 92 operates with the memory 93 to implement the functions of the address generation unit 11, the distortion compensation coefficient calculation unit 12, the multipliers 131 and 132, and the frequency shift units 141 and 142 illustrated in FIG. 2. Specifically, the processor 92 performs a process to generate three types of address information for each of the first and second transmission signals, based on the power or amplitude of the first transmission signal and the power or amplitude of the second transmission signal. The processor 92 inputs an address to each of the LUTs 211 to 213 and 221 to 223 to read a distortion compensation coefficient from each LUT. Then, for each of the first and second transmission signals, the processor 92 multiplies the transmission signal and the sum of the read three distortion compensation coefficients to generate a pre-distortion signal for each band. In addition, the processor 92 adds the pre-distortion signals for each band to generate a composite signal, which is a pre-distortion signal.

The wireless communication circuit 94 includes the DAC 16, the up-converter including the up-converter 17 and the local oscillator 18, and the PA 19. The wireless communication circuit 94 converts a digital transmission signal output from the processor 92 to an analog radio signal and outputs the analog radio signal to the antenna. The wireless communication circuit 94 may include a down-converter and an analog to digital converter (ADC). In this case, a portion of an amplifier output signal can be fed back to the processor 92.

The comparison with a configuration that uses a two-dimensional LUT for each band will now be described. In the present embodiment, the LUTs 211 to 213 and 221 to 223 are one-dimensional LUTs. In contrast, a configuration that uses a two-dimensional LUT for each band is also possible. The two-dimensional LUT outputs one distortion compensation coefficient according to the address of the first transmission signal and the address of the second transmission signal. In other words, the two-dimensional LUT can take into account the influence of the power of both the address of the first transmission signal and the address of the second transmission signal, for each of the first and second transmission signals.

For example, when the first transmission signal is x₁(n) and the second transmission signal is x₂(n), let u₁' (n) and u₂'(n) be pre-distortion signals for each band output from a distortion compensation unit for each band using a two-dimensional LUT. In this case, the pre-distortion signals u₁'(n) and u₂' (n) are expressed as u₁' (n) = x₁(n) × LUT_{2D-1}{|x₁(n)|², |x₂(n)|²}, and u₂'(n) = x₂(n) × LUT_{2D-2}{|x₁(n)|², |x₂(n)|²|}. Here, LUT_{2D-1}{x(n)|², |x₂(n)|²} is a distortion compensation coefficient output from the two-dimensional LUT for the first transmission signal. LUT_{2D-2}{|x₁(n)|², |x₂(n)|²} is a distortion compensation coefficient output from the two-dimensional LUT for the second transmission signal.

In the case of the configuration using a two-dimensional LUT for each band, for example, a distortion compensation coefficient is output according to both the address of the first transmission signal and the address of the second transmission signal, so that the accurately approximated distortion compensation coefficient is calculated. However, the circuit scale of a digital section becomes large, making implementation difficult and impractical. The digital section is, for example, a section of the radio equipment 1 that performs processing prior to the DAC 16, including the address generation unit 11 and the distortion compensation coefficient calculation unit 12.

Here, the pre-distortion signal u₁'(n) in the first band is approximately expanded as in the following equation (1), for example, when the approximation is limited to fifth- and lower order distortion. The approximation here, for example, is limited to fifth- and lower order distortion because the seventh- and higher order distortion compensation terms have little influence on distortion compensation. By using the compensation coefficients for the fifth- and lower order approximation, the radio equipment 1 can satisfy the adjacent channel power leakage ratio (ACLR) > 45 dB in the 3GPP (registered trademark) (3rd Generation Partnership Project) standard. It is noted that u₂'(n) can be expanded in the same way.$\begin{matrix}u {′}_{1} \left(n\right) = {x}_{1} \left(n\right) ⋅ {LUT}_{2 D - 1} \left\{{\left|{x}_{1}\left(n\right)\right|}^{2}, {\left|{x}_{2}\left(n\right)\right|}^{2}\right\} \\ ≅ {x}_{1} \left(n\right) ⋅ {LUT}_{1} \left\{{\left|{x}_{1}\left(n\right)\right|}^{2}\right\} ⋅ {LUT}_{2} \left\{{\left|{x}_{2}\left(n\right)\right|}^{2}\right\} \\ = {x}_{1} \left(n\right) ⋅ \left\{{\sum }_{k = 0}^{K} {α}_{k} {\left|{x}_{1}\left(n\right)\right|}^{2 k}\right\} \left\{{\sum }_{k = 0}^{K} {β}_{k} {\left|{x}_{2}\left(n\right)\right|}^{2 k}\right\} \\ ≅ {x}_{1} \left(n\right) ⋅ \left\{{\sum }_{k = 0}^{2} {α}_{k} {\left|{x}_{1}\left(n\right)\right|}^{2 k}\right\} \left\{{\sum }_{k = 0}^{2} {β}_{k} {\left|{x}_{2}\left(n\right)\right|}^{2 k}\right\} \\ ≅ {x}_{1} \left(n\right) ⋅ \left(\begin{matrix}{α}_{0} {β}_{0} + \left\{{α}_{1}{β}_{0}{\left|{x}_{1}\left(n\right)\right|}^{2}+{α}_{0}{β}_{1}{\left|{x}_{2}\left(n\right)\right|}^{2}\right\} \\ + \left\{\begin{matrix}{α}_{2} {β}_{0} {\left|{x}_{1}\left(n\right)\right|}^{4} + {α}_{1} {β}_{1} {\left|{x}_{1}\left(n\right)\right|}^{2} {\left|{x}_{2}\left(n\right)\right|}^{2} \\ + {α}_{0} {β}_{2} {\left|{x}_{2}\left(n\right)\right|}^{4}\end{matrix}\right\}\end{matrix}\right)\end{matrix}$

In this case, there are compensation terms from first to sixth terms in the expanded signal. The coefficient of each compensation term can be expressed independently. Therefore, the distortion compensation coefficient used in equation (1) is expressed by the distortion compensation coefficients from the LUTs 211 to 213 and 221 to 223, which are one-dimensional LUTs, obtained according to three types of address for each band. Here, for example, if there are three types of address for each band, and if a value indicating how many levels each address is expressed by is NA, then the number of distortion compensation coefficients for each band is NA×3. In contrast, for example, when two-dimensional LUTs are used, the number of distortion compensation coefficients for each band is NA×NA. Therefore, the memory capacity for the LUTs 211 to 213 and 221 to 223 for storing distortion compensation coefficients can be kept small, so that the circuit scale and memory capacity of the digital section can be reduced compared with using two-dimensional LUTs.

For example, when seventh- or higher order distortion is taken into consideration, the radio equipment 1 can calculate the distortion compensation coefficients by increasing the number of LUTs 211 to 213 and 221 to 223 for each band.

As explained above, by performing the distortion compensation process for each band, the radio equipment 1 according to the present embodiment can make optimal compensation for distortion in each band even when the nonlinear characteristic of the PA 19 is different for each band. Furthermore, by using one-dimensional LUTs 211 to 213 and 223 to 221, three for each band, the radio equipment 1 can compensate for three types of nonlinear distortion that occur in the common amplification configuration. The radio equipment 1 thus can improve distortion compensation performance and achieve a better ACLR.

Furthermore, by performing the distortion compensation process for each band, the radio equipment 1 only need to provide a digital processing bandwidth that is three to five times the transmission signal bandwidth for each band, so that the amount of computation can be reduced by processing at a low sampling rate, thus reducing the circuit scale of the digital section. In addition, by performing common amplification of a multiband signal with PA 19 as the single power amplifier, the radio equipment 1 can reduce the number of devices compared with using the individual amplification configuration in which individual amplification is performed by an individual power amplifier for each band. As a result, the radio equipment 1 can reduce the installation area and the cost by the reduced number of components.

### (b) Second Embodiment

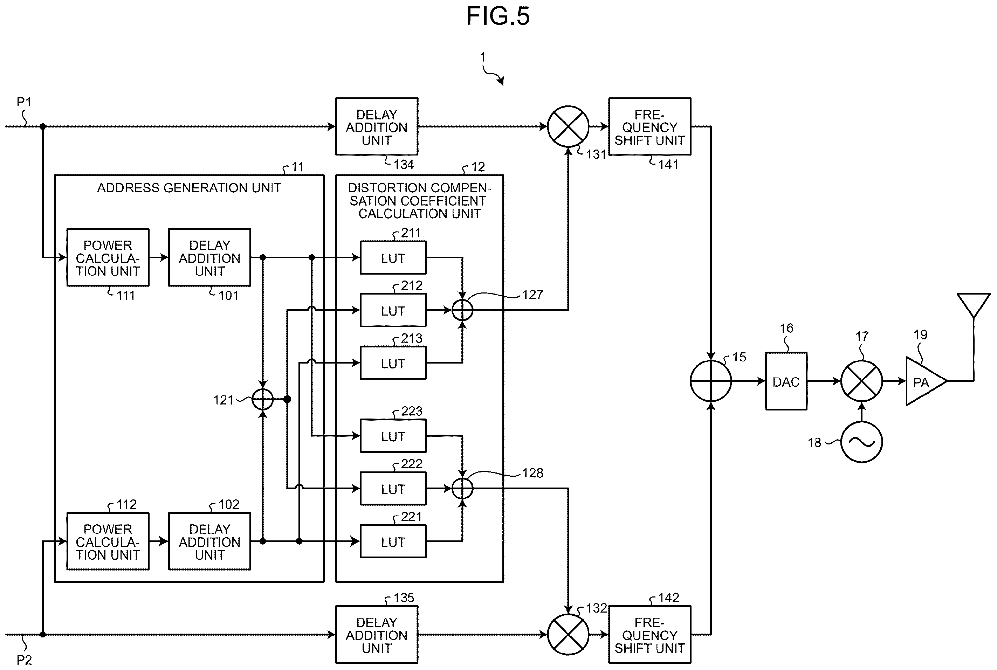

FIG. 5 is a block diagram of the radio equipment according to a second embodiment. The radio equipment 1 according to the present embodiment changes a combination of the delay amounts, for the delay amount in the power of each of the transmission signals in the first and second bands, and the delay amount in the transmission of the first and second transmission signals, to compensate for a memory effect in which the nonlinear distortion of the PA 19 is affected even by a state in the past. In the following, the description of the operation of each unit similar to that of the first embodiment may be omitted.

The address generation unit 11 includes delay addition units 101 and 102. The delay addition unit 101 applies a delay to the power of the first transmission signal output from the power calculation unit 111. The delay addition unit 102 applies a delay to the power of the second transmission signal output from the power calculation unit 112. For example, the delay addition unit 101 applies a delay amount qpw1, and the delay addition unit 102 applies a delay amount qpw2.

In the following, a case where the first transmission signal is x₁(n) and the second transmission signal is x₂(n) will be described. In this case, the delay addition unit 101 applies the delay amount qpw1 to the power |x₁(n)|²of the first transmission signal and outputs |x₁(n-qpw1)|². The delay addition unit 102 applies the delay amount qpw2 to the power |x₂(n)|²of the second transmission signal and outputs |x₂(n-qpw2)|². In the following, the delay amount qpw1 may be referred to as the delay amount of the power of the first transmission signal, and the delay amount qpw2 may be referred to as the delay amount of the power of the second transmission signal.

The delay addition units 101 and 102 are examples of "second delay addition unit". The delay applied by the delay addition unit 101 to the power of the first transmission signal and the delay applied by the delay addition unit 102 to the power of the second transmission signal are examples of "second delay".

The address generation unit 11 generates, for the first transmission signal, an address A_{11,qpw1} = |x₁(n-qpw1)|² of the first transmission signal. The address generation unit 11 also generates, for the first transmission signal, an address A_{12,qpw1,qpw2} = |x₁(n-qpw1)|²+ |x₂(n-qpw2)|² of the composite power. The address generation unit 11 also generates, for the first transmission signal, an address A_{13,qpw2} = |x₂(n-qpw2)|² of the second transmission signal.

The address generation unit 11 generates, for the second transmission signal, an address A_{21,qpw2} = |x₂(n-qpw2)|² of the second transmission signal. The address generation unit 11 also generates, for the second transmission signal, an address A_{22,qpw1,qpw2} = |x₁(n-qpw1)|² + |x₂(n-qpw2)|² of the composite power. The address generation unit 11 also generates, for the second transmission signal, an address A_{23,qpw1} = |x₁(n-qpw1)|² of the first transmission signal.

The LUT 211 outputs LUT_{1,1,qpw1,qtx1}(A_{11,qpw1}) for input of the address A_{11,qpw1}. The LUT 212 outputs LUT_{1,2,qpw1,qtx1,qpw2}(A_{12,qpw1,qpw2}) for input of the address A_{12,qpw1,qpw2}. The LUT 213 outputs LUT_{1,3,qtx1,qpw2}(A_{13,qpw2}) for input of the address A_{13,qpw2}.

The LUT 221 outputs LUT_{2,1,qpw2,qtx2}(A_{21,qpw2}) for input of the address A_{21,qpw2}. The LUT 222 outputs LUT_{2,2,qpw2,qtx2,qpw1}(A_{22,qpw1,qpw2}) for input of the address A_{22,qpw1,qpw2}. The LUT 223 outputs LUT_{2,3,qtx2,qpw1}(A_{23,qpw1}) for input of the address A_{23,qpw1}.

The adder 127 calculates a distortion compensation coefficient LUT_{SUM-1,qtx1} of the first transmission signal as LUT_{SUM-1,qtx1} = LUT_{1,1,qpw1,qtx1}(A_{11,qpw1}) + LUT_{1,2,qpwl,qtx1,qpw2}(A_{12,qpw1,qpw2}) + LUT_{1,3,qtx1,qpw2}(A_{13,qpw2}). The adder 128 calculates a distortion compensation coefficient LUT_{SUM-2,qtx2} of the second transmission signal as LUT_{SUM-2,qtx2} = LUT_{2,1,qpw2,qtx2}(A_{21,qpw2}) + LUT_{2,2,qpw2,qtx2,qpw1}(A_{22,qpw1,qpw2}) + LUT_{2,3,qtx2,qpw1}(A_{23,qpw1}).

A delay addition unit 134 applies a delay to the first transmission signal. For example, when the delay amount is qtx1, the delay addition unit 134 applies the delay amount qtx1 to the first transmission signal x₁(n) and outputs x₁(n-qtx1).

A delay addition unit 135 applies a delay to the second transmission signal. For example, when the delay amount is qtx2, the delay addition unit 135 applies the delay amount qtx2 to the second transmission signal x₂(n) and outputs x₂(n-qtx2).

The delay addition units 134 and 135 are examples of "first delay addition unit". The delay applied by the delay addition unit 134 to the first transmission signal and the delay applied by the delay addition unit 135 to the second transmission signal are examples of "first delay".

The multiplier 131 multiplies x₁(n-qtx1) output from the delay addition unit 134 and LUT_{SUM-1,qtx1} output from the distortion compensation coefficient calculation unit 12 and outputs a pre-distortion signal u1(n) = x₁(n-qtx1) × LUT_{SUM-1,qtx1} in the first band.

The multiplier 132 multiplies x₂(n-qtx2) output from the delay addition unit 135 and LUT_{SUM-2,qtx2} output from the distortion compensation coefficient calculation unit 12 and outputs a pre-distortion signal u2(n) = x₂(n-qtx2) × LUT_{SUM-2,qtx2} in the second band.

In the above description, one pattern of delay amount combination is formulated. The radio equipment 1 can compensate for the memory effect by varying each of the delay amounts qtx1, qtx2, qpw1, and qpw2 and adding the signals, for example, by an adder (not illustrated in the drawing) to produce a pre-distortion signal, thereby further improving the distortion compensation performance. Some examples of combinations of delay amounts qtx1, qtx2, qpw1, and qpw2 will be described below.

As a first example, a case where the delay amount pqw1 of the power |x₁(n)|² of the first transmission signal and the delay amount pqw2 of the power |x₂(n)|² of the second transmission signal are the same in each of the first and second transmission signals will be described. In other words, pqw1 = pqw2 = pqw in each of the first and second transmission signals. However, the delay amount pqw in the first transmission signal may be different from the delay amount pqw in the second transmission signal. Here, suppose that pqw, which is the delay amount of the power |x₁(n)|² of the first transmission signal and the delay amount of the power |x₂(n)|² of the second transmission signal, in the first transmission signal, is a changeable delay amount q11. Suppose that, pqw, which is the delay amount of the power |x₁(n)|² of the first transmission signal and the delay amount of the power |x₂(n)|² of the second transmission signal, in the second transmission signal, is a changeable delay amount q21. Suppose that the delay amount qtx1 of the first transmission signal is a changeable delay amount q12, and the delay amount qtx2 of the second transmission signal is a changeable delay amount q22.

The delay addition unit 134 applies the delay amount q12 to the first transmission signal x₁(n) and outputs x₁(n-q12). The delay addition unit 135 applies the delay amount q22 to the second transmission signal x₂(n) and outputs x₂(n-q22).

The address generation unit 11 generates, for the first transmission signal, an address A_{11,q11} = |x₁(n-q11)|² of the first transmission signal. The address generation unit 11 also generates, for the first transmission signal, an address A_{12,q11} = |x₁(n-q11)|² + |x₂(n-q11)|² of the composite power. The address generation unit 11 also generates, for the first transmission signal, an address A_{13,q11} = |x₂(n-q11)|² of the second transmission signal.

The address generation unit 11 generates, for the second transmission signal, an address A_{21,q21} = |x₂(n-q21)|² of the second transmission signal. The address generation unit 11 also generates, for the second transmission signal, an address A_{22,q21} = |x₁(n-q21)|² + |x₂(n-q21)|² of the composite power. The address generation unit 11 also generates, for the second transmission signal, an address A_{23,q21} = |x₁(n-q21)|² of the first transmission signal.

The LUT 211 outputs LUT_{1,1,q11,q12}(A_{11,q11}) for input of the address A_{11,q11}. The LUT 212 outputs LUT_{1,2,q11,q12}(A_{12,q11}) for input of the address A_{12,q11.} The LUT 213 outputs LUT_{1,3,q11,q12}(A_{13,q11}) for input of the address A_{13,q11}.

The LUT 221 outputs LUT_{2,1,q21,q22}(A_{21,q21}) for input of the address A_{21,q21}. The LUT 222 outputs LUT_{2,2,q21,q22}(A_{22,q21}) for input of the address A_{22,q21.} The LUT 223 outputs LUT_{2,3,q21,q22}(A_{23,q21}) for input of the address A_{23,q21}.

The adder 127 calculates a distortion compensation coefficient LUT_{SUM-1,q12} of the first transmission signal according to the following equation (2). Here, the radio equipment 1 varies q11 from -Q_{1,1} to +Q_{1,1}.$\begin{matrix}{LUT}_{SUM - 1 , {q}_{12}} \\ = {\sum }_{{q}_{11} = - {Q}_{1 , 1}}^{+ {Q}_{1 , 1}} \left\{{LUT}_{1 , 1 , {q}_{11} , {q}_{12}}\left[{A}_{11 , {q}_{11}}\right]+{LUT}_{1 , 2 , {q}_{11} , {q}_{12}}\left[{A}_{12 , {q}_{11}}\right]+{LUT}_{1 , 3 , {q}_{11} , {q}_{12}}\left[{A}_{13 , {q}_{11}}\right]\right\}\end{matrix}$

The adder 128 calculates a distortion compensation coefficient LUT_{SUM-2,q22} of the second transmission signal according to the following equation (3). Here, the radio equipment 1 varies q21 from -Q_{2,1} to +Q_{2,1}. $\begin{matrix}{LUT}_{SUM - 2 , {q}_{22}} \\ = {\sum }_{{q}_{21} = - {Q}_{2 , 1}}^{+ {Q}_{2 , 1}} \left\{{LUT}_{2 , 1 , {q}_{21} , {q}_{22}}\left[{A}_{21 , {q}_{21}}\right]+{LUT}_{2 , 2 , {q}_{21} , {q}_{22}}\left[{A}_{22 , {q}_{21}}\right]+{LUT}_{2 , 3 , {q}_{21} , {q}_{22}}\left[{A}_{23 , {q}_{21}}\right]\right\}\end{matrix}$

The multiplier 131 multiplies x₁(n-q12) output from the delay addition unit 134 and LUT_{SUM-1,q12} output from the distortion compensation coefficient calculation unit 12 and outputs a pre-distortion signal expressed by the following equation (4). Here, the radio equipment 1 varies q12 from -Q_{1,2} to +Q_{1,2}. Although one multiplier 131 is depicted in FIG. 5, a plurality of multipliers 131 are disposed according to the number of multiplications in equation (4), and the respective results output from the multipliers 131 are added, for example, by an adder (not illustrated in the drawing) to calculate equation (4).${u}_{1} \left(n\right) = {\sum }_{{q}_{12} = - {Q}_{1 , 2}}^{+ {Q}_{1 , 2}} {x}_{1} \left(n-{q}_{12}\right) ⋅ {LUT}_{SUM - 1 , {q}_{12}}$

The multiplier 132 multiplies x₂(n-q22) output from the delay addition unit 135 and LUT_{SUM-2,q22} output from the distortion compensation coefficient calculation unit 12 and outputs a pre-distortion signal expressed by the following equation (5). Here, the radio equipment 1 varies q22 from -Q_{2,2} to +Q_{2,2}. Although one multiplier 132 is depicted in FIG. 5, a plurality of multipliers 132 are disposed according to the number of multiplications in equation (5), and the respective results output from the multipliers 132 are added, for example, by an adder (not illustrated in the drawing) to calculate equation (5).${u}_{2} \left(n\right) = {\sum }_{{q}_{22} = - {Q}_{2 , 2}}^{+ {Q}_{2 , 2}} {x}_{2} \left(n-{q}_{22}\right) ⋅ {LUT}_{SUM - 2 , {q}_{22}}$

Next, as a second example, a case where the delay amount pqw1 of the power |x₁(n)|² of the first transmission signal and the delay amount pqw2 of the power |x₂(n)|² of the second transmission signal are different from each other in each of the first and second transmission signals will be described. In other words, pqw1 ≠ pqw2 in each of the first and second transmission signals. Here, let q11 be the variable delay amount of the power |x₁(n)|² of the first transmission signal, and q13 be the variable delay amount of the power |x₂(n)|² of the second transmission signal, in the first transmission signal. Let q21 be the variable delay amount of the power |x₂(n)|² of the second transmission signal, and q23 be the variable delay amount of the power |x₁(n)|² of the first transmission signal, in the second transmission signal. Let q12 be the variable delay amount qtx1 of the first transmission signal, and q22 be the variable delay amount qtx2 of the second transmission signal.

The delay addition unit 134 applies the delay amount q12 to the first transmission signal x₁(n) and outputs x₁(n-q12). The delay addition unit 135 applies the delay amount q22 to the second transmission signal x₂(n) and outputs x₂(n-q22).

The address generation unit 11 generates, for the first transmission signal, an address A_{11,q11} = |x₁(n-q11)|² of the first transmission signal. The address generation unit 11 also generates, for the first transmission signal, an address A_{12,q11,q13} = |x₁(n-q11)|² + |x₂(n-q13)|² of the composite power. The address generation unit 11 also generates, for the first transmission signal, an address A_{13,q13} = |x₂(n-q13)|² of the second transmission signal.

The address generation unit 11 generates, for the second transmission signal, an address A_{21,q21} = |x₂ (n-q21)|² of the second transmission signal. The address generation unit 11 also generates, for the second transmission signal, an address A_{22,q21,q23} = |x₂(n-q21)|² + |x₁(n-q23)|² of the composite power. The address generation unit 11 also generates, for the second transmission signal, an address A_{23,q23} = |x₁(n-q23)|² of the first transmission signal.

The LUT 211 outputs LUT_{1,1,q11,q12,q13}(A_{11,411}) for input of the address A_{11,q11}. The LUT 212 outputs LUT_{1,2,q11,q12,q13}(A_{12,q11,q13}) for input of the address A_{12,q11,q13}. The LUT 213 outputs LUT_{1,3,q11,q12,q13}(A_{13,q13}) for input of the address A_{13,q13}.

The LUT 221 outputs LUT_{2,1,q21,q22,q23}(A_{21,q21}) for input of the address A_{21,q21}. The LUT 222 outputs LUT_{2,2,q21,q22,q23}(A_{22,q21,q23}) for input of the address A_{22,q21,q23}. The LUT 223 outputs LUT_{2,3,q21,q22,q23}(A_{23,q23}) for input of the address A_{23,q23}.

The adder 127 calculates a distortion compensation coefficient LUT_{SUM-1,q12} of the first transmission signal according to the following equation (6). Here, the radio equipment 1 varies q11 from -Q_{1,1} to +Q_{1,1} and varies q13 from -Q_{1,3} to +Q_{1,3}.${LUT}_{SUM - 1 , {q}_{12}} = {\sum }_{{q}_{11} = - {Q}_{1 , 1}}^{+ {Q}_{1 , 1}} {\sum }_{{q}_{13} = - {Q}_{1 , 3}}^{+ {Q}_{1 , 3}} \left\{\begin{matrix}{LUT}_{1 , 1 , {q}_{11} , {q}_{12} , {q}_{13}} \left[{A}_{11 , {q}_{11}}\right] + {LUT}_{1 , 2 , {q}_{11} , {q}_{12} , {q}_{13}} \left[{A}_{12 , {q}_{11} , {q}_{13}}\right] \\ + {LUT}_{1 , 3 , {q}_{11} , {q}_{12} , {q}_{13}} \left[{A}_{13 , {q}_{13}}\right]\end{matrix}\right\}$

The adder 128 calculates a distortion compensation coefficient LUT_{SUM-2,q22} of the second transmission signal according to the following equation (7). Here, the radio equipment 1 varies q21 from -Q_{2,1} to +Q_{2,1} and varies q23 from -Q_{2,3} to +Q_{2,3}. ${LUT}_{SUM - 2 , {q}_{22}} = {\sum }_{{q}_{21} = - {Q}_{2 , 1}}^{+ {Q}_{2 , 1}} {\sum }_{{q}_{23} = - {Q}_{2 , 3}}^{+ {Q}_{2 , 3}} \left\{\begin{matrix}{LUT}_{2 , 1 , {q}_{21} , {q}_{22} , {q}_{23}} \left[{A}_{21 , {q}_{21}}\right] + {LUT}_{2 , 2 , {q}_{21} , {q}_{22} , {q}_{23}} \left[{A}_{22 , {q}_{21} , {q}_{23}}\right] \\ {LUT}_{2 , 3 , {q}_{21} , {q}_{22} , {q}_{23}} \left[{A}_{23 , {q}_{23}}\right]\end{matrix}\right\}$

The multiplier 131 multiplies x₁(n-q12) output from the delay addition unit 134 and LUT_{SUM-1,q12} output from the distortion compensation coefficient calculation unit 12 and outputs a pre-distortion signal expressed by the above equation (4). Here, the radio equipment 1 varies q12 from -Q_{1,2} to +Q_{1,2}.

The multiplier 132 multiplies x₂(n-q22) output from the delay addition unit 135 and LUT_{SUM-2,q22} output from the distortion compensation coefficient calculation unit 12 and outputs a pre-distortion signal expressed by the above equation (5). Here, the radio equipment 1 varies q22 from -Q_{2,2} to +Q_{2,2}.

Next, as a third example, an example with a different method for determining the sum of three distortion compensation coefficients based on the second example will be described.

Since LUT_{1,1,q11,q12,q13}(A_{11,q11}) does not have to include q13 as a variable, the adder 127 does not have to perform the calculation to obtain the sum from -Q_{1,3} to +Q_{1,3} for LUT _{1,1,q11,q12,q13}(A_{11,q11}). In other words, the adder 127 may obtain the sum from -Q_{1,1} to +Q_{1,1} using LUT_{1,1,q11,q12}(A_{11,q11}) excluding the variable q13 from LUT_{1,1,q11,q12,q13}(A_{11,q11}).

Since LUT_{1,3,q11,q12,q13}(A_{13,q13}) does not have to include q11 as a variable, the adder 127 does not have to perform the calculation to obtain the sum from -Q_{1,1} to +Q_{1,1} for LUT_{1,3,q11,q12,q13}(A_{13,q13}). In other words, the adder 127 may obtain the sum from -Q_{1,3} to +Q_{1,3} using LUT_{1,3,q12,q13}(A_{13,q13}) excluding the variable q11 from LUT_{1,3,q11,q12,q13}(A_{13,q13}).

Since LUT_{2,1,q21,q22,q23}(A_{21,q21}) does not have to include q23 as a variable, the adder 128 does not have to perform the calculation to obtain the sum from -Q_{2,3} to +Q_{2,3} for LUT _{2,1,q21,q22,q23}(A_{21,q21}). In other words, the adder 128 may obtain the sum from -Q_{2,1} to +Q_{2,1} using LUT_{2,1,q21,q22}(A_{21,q21}) excluding the variable q23 from LUT_{2,1,q21,q22,q23}(A_{21,}q₂₁).

Since LUT_{2,3,q21,q22,q23}(A_{23,q23}) does not have to include q21 as a variable, the adder 128 does not have to perform the calculation to obtain the sum from -Q_{2,1} to +Q_{2,1} for LUT_{2,3,q21,q22,q23}(A_{23,q23}). In other words, the adder 128 may obtain the sum from -Q_{2,3} to +Q_{2,3} using LUT_{2,3,q22,q23}(A_{23,q23}) excluding the variable q21 from LUT_{2,3,q21,q22,q23}(A_{23,q23}).

With the changes as described above, the LUTs 211 to 213 and 221 to 223 that store therein distortion compensation coefficients can reduce memory capacity. A process of calculating a distortion compensation coefficient will be described below.

The delay addition unit 134 applies the delay amount q12 to the first transmission signal x₁(n) and outputs x₁(n-q12). The delay addition unit 135 applies the delay amount q22 to the second transmission signal x₂(n) and outputs x₂(n-q22).

The address generation unit 11 generates, for the first transmission signal, an address A_{11,q11} = |x₁(n-q11)|² of the first transmission signal. The address generation unit 11 also generates, for the first transmission signal, an address A_{12,q11,q13} = |x₁(n-q11)|² + |x₂(n-q13)|² of the composite power. The address generation unit 11 also generates, for the first transmission signal, an address A_{13,q13} = |x₂(n-q13)|² of the second transmission signal.

The address generation unit 11 generates, for the second transmission signal, an address A_{21,q21} = |x₂(n-q21)|² of the second transmission signal. The address generation unit 11 also generates, for the second transmission signal, an address A_{22,q21,q23} = |x₂(n-q21)|² + |x₁(n-q23)|² of the composite power. The address generation unit 11 also generates, for the second transmission signal, an address A_{23,q23} = |x₁(n-q23)|² of the first transmission signal.

The LUT 211 outputs LUT_{1,1,q11,q12}(A_{11,q11}) for input of the address A_{11,q11}. The LUT 212 outputs LUT_{1,2,q11,q12,q13}(A_{12,q11,q13}) for input of the address A_{12,q11,q13}. The LUT 213 outputs LUT_{1,3,q12,q13}(A_{13,q13}) for input of the address A_{13,q13}.

The LUT 221 outputs LUT_{2,1,q21,q22}(A₂₁,_{q21}) for input of the address A_{21,q21}. The LUT 222 outputs LUT_{2,2,q21,q22,q23}(A_{22,q21,q23}) for input of the address A_{22,q21,q23}. The LUT 223 outputs LUT_{2,3,q22,q23}(A_{23,q23}) for input of the address A_{23,q23}.

The adder 127 calculates a distortion compensation coefficient LUT_{SUM-1,q12} of the first transmission signal according to the following equation (8). Here, the radio equipment 1 varies q11 from -Q_{1,1} to +Q_{1,1} and varies q13 from -Q_{1,3} to +Q_{1,3}.$\begin{matrix}{LUT}_{SUM - 1 , {q}_{12}} \\ = {\sum }_{{q}_{11} = - {Q}_{1 , 1}}^{+ {Q}_{1 , 1}} \left\{{LUT}_{1 , 1 , {q}_{11} , {q}_{12}}\left[{A}_{11 , {q}_{11}}\right]\right\} + {\sum }_{{q}_{11} = - {Q}_{1 , 1}}^{+ {Q}_{1 , 1}} {\sum }_{{q}_{13} = - {Q}_{1 , 3}}^{+ {Q}_{1 , 3}} \left\{{LUT}_{1 , 2 , {q}_{11} , {q}_{12} , {q}_{13}}\left[{A}_{12 , {q}_{11} , {q}_{13}}\right]\right\} \\ + {\sum }_{{q}_{13} = - {Q}_{1 , 3}}^{+ {Q}_{1 , 3}} \left\{{LUT}_{1 , 3 , {q}_{12} , {q}_{13}}\left[{A}_{13 , {q}_{13}}\right]\right\}\end{matrix}$

The adder 128 calculates a distortion compensation coefficient LUT_{SUM-2,q22} of the second transmission signal according to the following equation (9). Here, the radio equipment 1 varies q21 from -Q_{2,1} to +Q_{2,1} and varies q23 from -Q_{2,3} to +Q_{2,3}.$\begin{matrix}{LUT}_{SUM - 2 , {q}_{22}} \\ = {\sum }_{{q}_{21} = - {Q}_{2 , 1}}^{+ {Q}_{2 , 1}} \left\{{LUT}_{2 , 1 , {q}_{21} , {q}_{22}}\left[{A}_{21 , {q}_{21}}\right]\right\} + {\sum }_{{q}_{21} = - {Q}_{2 , 1}}^{+ {Q}_{2 , 1}} {\sum }_{{q}_{23} = - {Q}_{2 , 3}}^{+ {Q}_{2 , 3}} \left\{{LUT}_{2 , 2 , {q}_{21} , {q}_{22} , {q}_{23}}\left[{A}_{22 , {q}_{21} , {q}_{23}}\right]\right\} \\ + {\sum }_{{q}_{23} = - {Q}_{2 , 3}}^{+ {Q}_{2 , 3}} \left\{{LUT}_{2 , 3 , {q}_{22} , {q}_{23}}\left[{A}_{23 , {q}_{23}}\right]\right\}\end{matrix}$

The multiplier 131 multiplies x₁(n-q12) output from the delay addition unit 134 and LUT_{SUM-1,q12} output from the distortion compensation coefficient calculation unit 12 and outputs a pre-distortion signal expressed by the above equation (4). Here, the radio equipment 1 varies q12 from -Q_{1,2} to +Q_{1,2}.

The multiplier 132 multiplies x₂(n-q22) output from the delay addition unit 135 and LUT_{SUM-2,q22} output from the distortion compensation coefficient calculation unit 12 and outputs a pre-distortion signal expressed by the above equation (5). Here, the radio equipment 1 varies q22 from -Q_{2,2} to +Q_{2,2}.

Here, in the first to three examples according to the first embodiment described above, the radio equipment 1 does not have to use distortion compensation coefficients or compensation terms corresponding to a combination of all delay amounts for q11, q12, q13 and q21, q22, q23. In other words, the radio equipment 1 can select a combination of one or some delay amounts that have a relatively large influence on distortion compensation performance and use the distortion compensation coefficients or compensation terms corresponding to them. As a result, the radio equipment 1 can reduce the memory capacity of the LUTs 211 to 213 and 221 to 223 that store therein distortion compensation coefficients, and the number of multipliers 131 and 132 that multiply the distortion compensation coefficient and the transmission signal, while minimizing deterioration of distortion compensation performance.

### (c) Third Embodiment

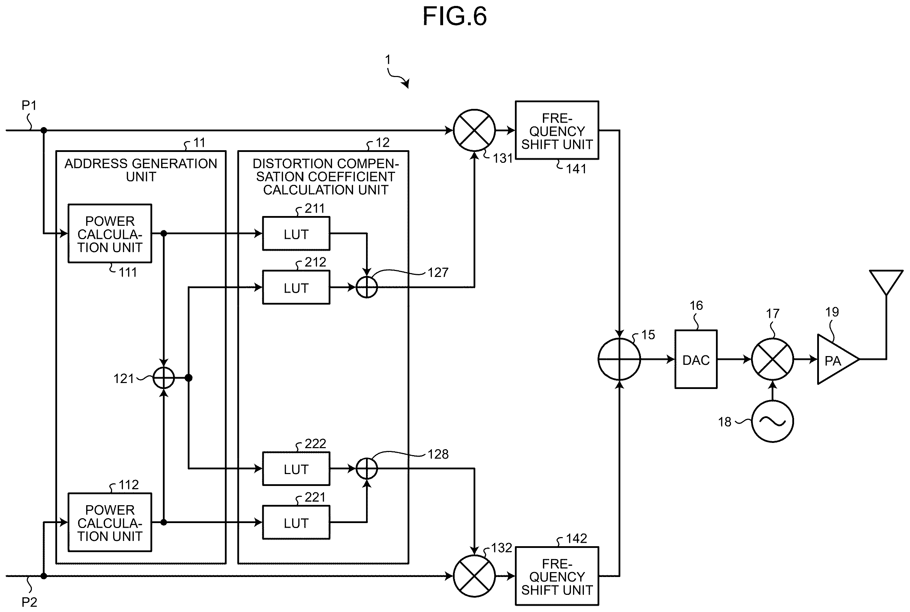

A third embodiment will now be described. In the first embodiment, three tables for calculating distortion compensation coefficients are used for each of the first and second bands, but the number of tables may be two or one for each band. FIG. 6 is a block diagram of the radio equipment according to the third embodiment. The radio equipment 1 according to the present embodiment uses two tables for calculating distortion compensation coefficients for each of the first and second bands. In the following, the description of the operation of each unit similar to that of the first embodiment may be omitted.

The radio equipment 1 according to the present embodiment includes two LUTs 211 and 212 for the first band. The LUT 211 is a table in which a distortion compensation coefficient for distortion compensation for the first transmission signal with respect to the power of the first transmission signal itself is stored in association with the address of the first transmission signal. The LUT 212 is a table in which a distortion compensation coefficient for distortion compensation for the first transmission signal with respect to the composite power is stored in association with the address of the composite power.

The radio equipment 1 also includes two LUTs 221 and 222 for the second band. The LUT 221 is a table in which a distortion compensation coefficient for distortion compensation for the second transmission signal with respect to the power of the second transmission signal itself is stored in association with the address of the second transmission signal. The LUT 222 is a table in which a distortion compensation coefficient for distortion compensation for the second transmission signal with respect to the composite power is stored in association with the address of the composite power.

Here, a case where the first transmission signal is x₁(n) and the second transmission signal is x₂(n) will be described.

The address generation unit 11 generates, for the first transmission signal, an address A₁₁ = |x₁(n)|² of the first transmission signal and an address A₁₂ = |x₁(n)|² + |x₂(n)|² of the composite power.

The address generation unit 11 generates, for the second transmission signal, an address A₂₁ = |x₂(n)|² of the second transmission signal and an address A₂₂ = |x₁(n)|² + |x₂(n)|² of the composite power.

The LUT 211 then outputs LUT_{1,1}(A₁₁) as the distortion compensation coefficient corresponding to the address A11 of the first transmission signal. LUT_{1,1}(A₁₁) is the distortion compensation coefficient for distortion compensation for the first transmission signal with respect to the power of the first transmission signal itself. The LUT 212 outputs LUT_{1,2}(A₁₂) as the distortion compensation coefficient corresponding to the address A12 of the composite power. LUT_{1,2}(A₁₂) is the distortion compensation coefficient for distortion compensation for the first transmission signal with respect to the composite power.

The LUT 221 outputs LUT_{2,1}(A₂₁) as the distortion compensation coefficient corresponding to the address A₂₁ of the second transmission signal. LUT_{2,1}(A₂₁) is the distortion compensation coefficient for distortion compensation for the second transmission signal with respect to the power of the second transmission signal itself. The LUT 222 outputs LUT_{2,2}(A₂₂) as the distortion compensation coefficient corresponding to the address A₂₂ of the composite power. LUT_{2,2}(A₂₂) is the distortion compensation coefficient for distortion compensation for the second transmission signal with respect to the composite power.

The adder 127 calculates the distortion compensation coefficient of the first transmission signal as LUT_{SUM-1} = LUT_{1,1}(A₁₁) + LUT_{1,2}(A₁₂). By using this distortion compensation coefficient, the radio equipment 1 can perform distortion compensation for the first transmission signal with respect to the power of the first transmission signal and the composite power. The adder 128 calculates the distortion compensation coefficient of the second transmission signal as LUT_{SUM-2} = LUT_{2,1}(A₂₁) + LUT_{2,2}(A₂₂). By using this distortion compensation coefficient, the radio equipment 1 can perform distortion compensation for the second transmission signal with respect to the power of the second transmission signal and the composite power.

As described above, the radio equipment 1 according to the present embodiment performs distortion compensation for a transmission signal using a distortion compensation coefficient with respect to the power of a transmission signal in a particular band in multiband transmission and a distortion compensation coefficient with respect to the composite power with a transmission signal in another band. In this way, even if there are two tables for calculating distortion compensation coefficients, for each transmission signal, optimal compensation can be made for distortion in each band. The radio equipment 1 thus can improve distortion compensation performance and achieve a better ACLR.

### Modification 3-1

The radio equipment 1 may include two LUTs 211 and 213 for the first band and two LUTs 221 and 223 for the second band. The LUT 211 is a table in which a distortion compensation coefficient for distortion compensation for the first transmission signal with respect to the power of the first transmission signal itself is stored in association with the address of the first transmission signal. The LUT 213 is a table in which a distortion compensation coefficient for distortion compensation for the first transmission signal with respect to the power of the second transmission signal is stored in association with the address of the second transmission signal. The LUT 221 is a table in which a distortion compensation coefficient for distortion compensation for the second transmission signal with respect to the power of the second transmission signal itself is stored in association with the address of the second transmission signal. The LUT 223 is a table in which a distortion compensation coefficient for distortion compensation for the second transmission signal with respect to the power of the first transmission signal is stored in association with the address of the first transmission signal.

The address generation unit 11 generates, for the first transmission signal, an address A₁₁ = |x₁(n)|² of the first transmission signal and an address A₁₃ = |x₂(n)|² of the second transmission signal.

The address generation unit 11 generates, for the second transmission signal, an address A₂₁ = |x₂(n)|² of the second transmission signal and an address A₂₃ = |x₁(n)|² of the first transmission signal.

The LUT 211 then outputs LUT_{1,1}(A₁₁) as the distortion compensation coefficient corresponding to the address A11 of the first transmission signal. LUT_{1,1}(A₁₁) is the distortion compensation coefficient for distortion compensation for the first transmission signal with respect to the power of the first transmission signal itself. The LUT 213 outputs LUT_{1,3}(A₁₃) as the distortion compensation coefficient corresponding to the address A₁₃ of the second transmission signal. LUT_{1,3}(A₁₃) is the distortion compensation coefficient for distortion compensation for the first transmission signal with respect to the power of the second transmission signal.

The LUT 221 outputs LUT_{2,1}(A₂₁) as the distortion compensation coefficient corresponding to the address A₂₁ of the second transmission signal. LUT_{2,1}(A₂₁) is the distortion compensation coefficient for distortion compensation for the second transmission signal with respect to the power of the second transmission signal itself. The LUT 223 outputs LUT_{2,3}(A₂₃) as the distortion compensation coefficient corresponding to the address A₂₃ of the first transmission signal. LUT_{2,3}(A₂₃) is the distortion compensation coefficient for distortion compensation for the second transmission signal with respect to the power of the first transmission signal.

The adder 127 calculates the distortion compensation coefficient of the first transmission signal as LUT_{SUM-1} = LUT_{1,1}(A₁₁) + LUT_{1,3}(A₁₃). By using this distortion compensation coefficient, the radio equipment 1 can perform distortion compensation with respect to the power of the first transmission signal and the power of the second transmission signal for the first transmission signal. The adder 128 calculates the distortion compensation coefficient of the second transmission signal as LUT_{SUM-2} = LUT_{2,1}(A₂₁) + LUT_{2,3}(A₂₃). By using this distortion compensation coefficient, the radio equipment 1 can perform distortion compensation with respect to the power of the second transmission signal and the power of the first transmission signal for the second transmission signal.

As described above, the radio equipment 1 according to the present embodiment performs distortion compensation for a transmission signal using a distortion compensation coefficient with respect to the power of a transmission signal in a particular band in multiband transmission and a distortion compensation coefficient with respect to the power of a transmission signal in another band. When there are two transmission signals, the power of each transmission signal may have a relatively large influence on distortion compensation performance. The radio equipment 1 according to the present embodiment therefore can perform more optimal compensation for distortion in each band than when a distortion compensation coefficient with respect to the composite power is used for one of two distortion compensation coefficients. The radio equipment 1 thus can improve distortion compensation performance and achieve a better ACLR.

### Modification 3-2

The radio equipment 1 may include two LUTs 212 and 213 for the first band and two LUTs 222 and 223 for the second band. The LUT 212 is a table in which a distortion compensation coefficient for distortion compensation for the first transmission signal with respect to the composite power is stored in association with the address of the composite power. The LUT 213 is a table in which a distortion compensation coefficient for distortion compensation for the first transmission signal with respect to the power of the second transmission signal is stored in association with the address of the second transmission signal. The LUT 222 is a table in which a distortion compensation coefficient for distortion compensation for the second transmission signal with respect to the composite power is stored in association with the address of the composite power. The LUT 223 is a table in which a distortion compensation coefficient for distortion compensation for the second transmission signal with respect to the power of the first transmission signal is stored in association with the address of the first transmission signal.

The address generation unit 11 generates, for the first transmission signal, an address A₁₂ = |x₁(n)|² + |x₂(n)|² of the composite power and an address A₁₃ = |x₂(n)|² of the second transmission signal.

The address generation unit 11 generates, for the second transmission signal, an address A₂₂ = |x₁(n)|² + |x₂(n)|² of the composite power and an address A₂₃ = |x₁(n)|² of the first transmission signal.

The LUT 212 then outputs LUT_{1,2}(A₁₂) as the distortion compensation coefficient corresponding to the address A₁₂ of the composite signal. LUT_{1,2}(A₁₂) is the distortion compensation coefficient for distortion compensation for the first transmission signal with respect to the composite power. The LUT 213 outputs LUT_{1,3}(A₁₃) as the distortion compensation coefficient corresponding to the address A₁₃ of the second transmission signal. LUT_{1,3}(A₁₃) is the distortion compensation coefficient for distortion compensation for the first transmission signal with respect to the power of the second transmission signal.

The LUT 222 outputs LUT_{2,2}(A₂₂) as the distortion compensation coefficient corresponding to the address A₂₂ of the composite power. LUT_{2,2}(A₂₂) is the distortion compensation coefficient for distortion compensation for the second transmission signal with respect to the composite power. The LUT 223 outputs LUT_{2,3}(A₂₃) as the distortion compensation coefficient corresponding to the address A₂₃ of the first transmission signal. LUT_{2,3}(A₂₃) is the distortion compensation coefficient for distortion compensation for the second transmission signal with respect to the power of the first transmission signal.

The adder 127 calculates the distortion compensation coefficient of the first transmission signal as LUT_{SUM-1} = LUT_{1,2}(A₁₂) + LUT_{1,3}(A₁₃). By using this distortion compensation coefficient, the radio equipment 1 can perform distortion compensation for the first transmission signal with respect to the composite power and the power of the second transmission signal. The adder 128 calculates the distortion compensation coefficient of the second transmission signal as LUT_{SUM-2} = LUT_{2,2}(A₂₂) + LUT_{2,3}(A₂₃). By using this distortion compensation coefficient, the radio equipment 1 can perform distortion compensation for the second transmission signal with respect to the composite power and the power of the first transmission signal.

As described above, the radio equipment 1 according to the present embodiment performs distortion compensation for a transmission signal in a particular band in multiband transmission, using a distortion compensation coefficient with respect to the composite power with a transmission signal in another band and a distortion compensation coefficient with respect to the power of the transmission signal in another band. In this way, in the distortion compensation for a transmission signal in a particular band, compensation can be made for distortion in each band without using a distortion compensation coefficient with respect to the power of the transmission signal itself.

The configurations of the third embodiment and modifications 3-1 and 3-2 each may be used in combination with the configuration of the second embodiment. For example, for a combination of delay amounts q11, q12 and q13 and delay amounts q21, q22 and q23 in the second embodiment, a table to be used can be determined from among the LUTs 211 to 213 and 221 to 223 as follows.

For example, the radio equipment 1 uses the LUTs 211 to 213 and 221 to 223 for a first combination. The radio equipment 1 uses two of the LUTs 211 to 213 and two of the LUTs 221 to 223 for a second combination. The radio equipment 1 uses one of the LUTs 211 to 213 and one of the LUTs 221 to 223 for a third combination.

The tables may be determined as follows. For example, the memory polynomial terms where q11 = q12 = q13 or q21 = q22 = q23 have a relatively large influence on distortion compensation performance, so the radio equipment 1 uses the LUTs 211 to 213 and 221 to 223 for this combination of delay amounts. The radio equipment 1 then uses two or one of the LUTs 211 to 213 and two or one of LUTs 221 to 223 for other combinations of delay amounts.

In addition to this, a combination of delay amounts such as q11 = q12 or q12 = q13 or q13 = q11 or q21 = q22 or q22 = q23 or q23 = q21 has a relatively large influence on distortion compensation performance, similarly to the memory polynomial terms. The radio equipment 1 therefore may use the LUTs 211 to 213 and 221 to 223 for this combination of delay amounts. The radio equipment 1 may then use two or one of the LUTs 211 to 213 and two or one of the LUTs 221 to 223 for the remaining combinations of delay amounts.

### (d) Fourth Embodiment

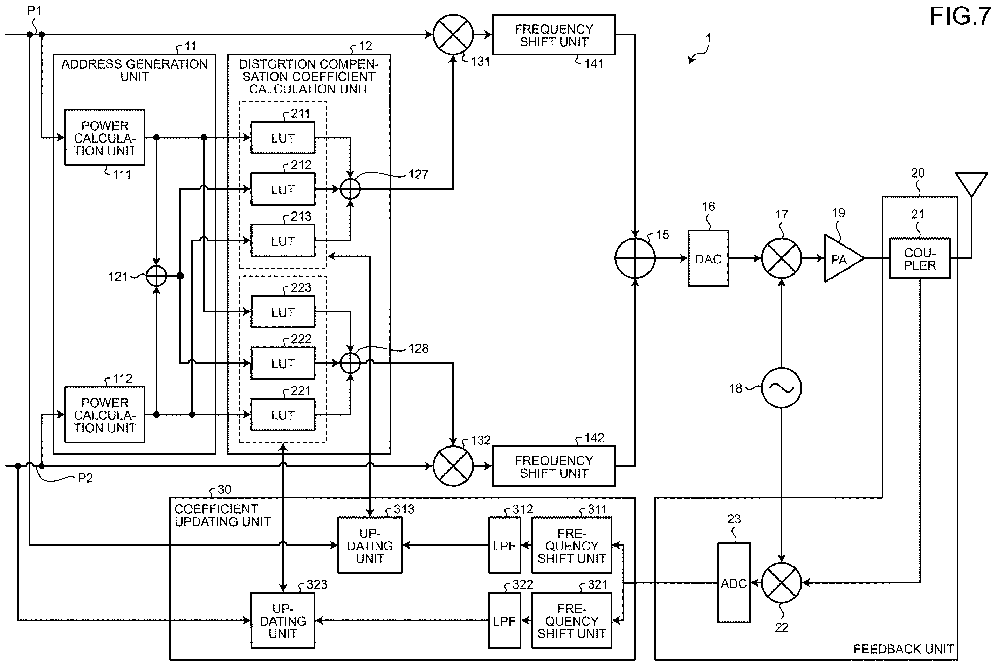

A fourth embodiment will now be described. FIG. 7 is a block diagram of the radio equipment according to a fourth embodiment. The radio equipment 1 according to the present embodiment adaptively updates a distortion compensation coefficient using a feedback signal that feeds back a portion of an amplifier output signal. In the following, the description of the operation of each unit similar to that of the first embodiment may be omitted. The radio equipment 1 according to the present embodiment includes a feedback unit 20 and a coefficient updating unit 30.

The feedback unit 20 feeds back a portion of an output signal from the PA 19 to generate a feedback signal. The feedback unit 20 includes a coupler 21, a multiplier 22, and an analog digital convertor (ADC) 23.

The coupler 21 extracts a portion of an amplifier output signal output from the PA 19 and outputs the extracted signal to the multiplier 22.

The multiplier 22 and the local oscillator 18 are a down-converter. The multiplier 22 receives input of the amplifier output signal from the coupler 21. The multiplier 22 down-converts the amplifier output signal by multiplying the amplifier output signal and the local signal input from the local oscillator 18 to convert the frequency of each of the first and second bands to a baseband or an intermediate frequency. The multiplier 22 then outputs the down-converted amplifier output signal to the ADC 23.

The ADC 23 receives input of the down-converted amplifier output signal from the multiplier 22. The ADC 23 then converts the amplifier output signal from an analog signal to a digital signal. The ADC 23 then outputs the amplifier output signal converted to a digital signal to the coefficient updating unit 30 as a feedback signal.

The coefficient updating unit 30 updates a distortion compensation coefficient using the feedback signal. The coefficient updating unit 30 includes frequency shift units 311 and 321, low pass filters (LPFs) 312 and 322, and updating units 313 and 323.

The frequency shift units 311 and 321 each receive input of a distributed feedback signal. The frequency shift unit 311 then shifts the frequency of the feedback signal so that a signal in the first band in the feedback signal becomes a baseband signal. The frequency shift unit 321 shifts the frequency of the feedback signal so that a signal in the second band in the feedback signal becomes a baseband signal.

The LPFs 312 and 322 are digital filters such as finite impulse response (FIR) filters. The LPFs 312 and 322 are both filters that pass a signal with a frequency near the baseband. The LPF 312 passes the feedback signal frequency-shifted by the frequency shift unit 311 and outputs a feedback signal corresponding to the first transmission signal in the first band. The LPF 322 passes the feedback signal frequency-shifted by the frequency shift unit 321 and outputs a feedback signal corresponding to the second transmission signal in the second band.

The updating unit 313 receives input of the feedback signal corresponding to the first transmission signal in the first band from the LPF 312. The updating unit 313 also receives input of the first transmission signal before distortion compensation that is branched from the signal path P1. In addition, the updating unit 313 receives inputs of the distortion compensation coefficients of the LUTs 211 to 213 before updating. The updating unit 313 then calculates a new distortion compensation coefficient for each of the LUTs 211 to 213 using the feedback signal corresponding to the first transmission signal, the first transmission signal, and the distortion compensation coefficient before updating. The updating unit 313 then updates the distortion compensation coefficient of each of the LUTs 211 to 213 with the calculated new distortion compensation coefficient.

The updating unit 323 receives input of the feedback signal corresponding to the second transmission signal in the second band from the LPF 322. The updating unit 323 also receives input of the second transmission signal before distortion compensation that is branched from the signal path P2. In addition, the updating unit 323 receives inputs of the distortion compensation coefficients of the LUTs 221 to 223 before updating. The updating unit 323 then calculates a new distortion compensation coefficient of each of the LUTs 221 to 223 using the feedback signal corresponding to the second transmission signal, the second transmission signal, and the distortion compensation coefficient before updating. The updating unit 323 then updates the distortion compensation coefficient of each of the LUTs 221 to 223 with the calculated new distortion compensation coefficient.

The updating units 313 and 323 can calculate a new distortion compensation coefficient using a least mean square (LMS) algorithm or the like. For example, a calculation example of distortion compensation coefficients by the updating units 313 and 323 under the following conditions will be described. The first transmission signal is x₁(n), and the second transmission signal is x₂(n). The feedback signal for the first transmission signal is y₁(n), and the feedback signal for the second transmission signal is y₂(n). The addresses input to the LUTs 211 to 213 are A₁₁ to A₁₃, respectively, and the addresses input to the LUTs 221 to 223 are A₂₁ to A₂₃, respectively.

For example, the updating unit 313 calculates a new distortion compensation coefficient LUT_{1,1}(A₁₁) of the LUT 211 as LUT_{1,1}(A₁₁) = LUT_{1,1}(A₁₁) + µ·e₁(n)·(y₁(n))*. Here, µ is a step size parameter of the LMS algorithm, "*" represents complex conjugate, e₁(n) is an error signal with respect to the first transmission signal and expressed as e₁(n) = x₁(n) - y₁(n). The updating unit 313 calculates a new distortion compensation coefficient LUT_{1,2}(A₁₂) of the LUT 212 as LUT_{1,2}(A₁₂) = LUT_{1,2}(A₁₂) + µ·e₁(n)·(y₁(n))*. The updating unit 313 calculates a new distortion compensation coefficient LUT_{1,3}(A₁₃) of the LUT 213 as LUT_{1,3}(A₁₃) = LUT_{1,3}(A₁₃) + µ·e₁(n)·(y₁(n))*.

For example, the updating unit 323 calculates a new distortion compensation coefficient LUT_{2,1}(A₂₁) of the LUT 221 as LUT_{2,1}(A₂₁) = LUT_{2,1}(A₂₁) + µ·e₂(n)·(y₂(n))*. Here, e₂(n) is an error signal with respect to the second transmission signal and expressed as e₂(n) = x₂(n) - y₂(n). The updating unit 323 calculates a new distortion compensation coefficient LUT_{2,2}(A₂₂) of the LUT 222 as LUT_{2,2}(A₂₂) = LUT_{2,2}(A₂₂) + µ·e₂(n)·(y₂(n))*. The updating unit 323 calculates a new distortion compensation coefficient LUT_{2,3}(A₂₃) of the LUT 223 as LUT_{2,3}(A₂₃) = LUT_{2,3}(A₂₃) + µ·e₂(n)·(y₂(n))*.

As explained above, the radio equipment 1 according to the present embodiment adaptively updates a distortion compensation coefficient using a feedback signal that feeds back a portion of an amplifier output signal from the PA 19. As a result, the radio equipment 1 can improve distortion compensation performance even when the nonlinear characteristic of the PA 19 varies over time.

### Modification 4-1

Modification 4-1 of the fourth embodiment will now be described. The configuration according to the fourth embodiment can be combined with the configuration of the second or third embodiment. For example, an example in combination with the first to third examples of the second embodiment will be described below.

In this case, the radio equipment 1 has the delay addition unit 101 between the power calculation unit 111 and the distortion compensation coefficient calculation unit 12. The radio equipment 1 has the delay addition unit 102 between the power calculation unit 112 and the distortion compensation coefficient calculation unit 12. The radio equipment 1 has the delay addition unit 134 between a branch point to the power calculation unit 111 in the signal path P1 and the multiplier 131. The radio equipment 1 has the delay addition unit 135 between a branch point to the power calculation unit 112 in the signal path P2 and the multiplier 132.

In combination with the first example in the second embodiment, the delay amount qpw1 of the power |x₁(n)|² of the first transmission signal in the first band and the delay amount qpw2 of the power |x₂(n)|² of the second transmission signal in the second band are the same, that is, qpw1 = qpw2 = qpw. Here, suppose that qpw, which is the delay amount of the power |x₁(n)|² of the first transmission signal and the delay amount of the power |x₂(n)|² of the second transmission signal in the first transmission signal, is a changeable delay amount q11, in the same manner as in the second embodiment. Suppose that qpw, which is the delay amount of the power |x₁(n)|² of the first transmission signal and the delay amount of the power |x₂(n)|² of the second transmission signal in the second transmission signal, is a changeable delay amount q21. Suppose that the delay amount qtx1 of the first transmission signal is a changeable delay amount q12, and the delay amount qtx2 of the second transmission signal is a changeable delay amount q22.

The updating unit 313 calculates a new distortion compensation coefficient LUT_{1,1,q11,q12}(A_{11,q11}) of the LUT 211 as LUT_{1,1,q11,q12}(A_{11,g11}) = LUT_{1,1,q11,q12}(A_{11,q11}) + µ·e₁(n)·(y₁(n-q12))*. The updating unit 313 calculates a new distortion compensation coefficient LUT_{1,2,q11,q12}(A_{12,q11}) of the LUT 212 as LUT_{1,2,q11,q12}(A_{12,q11}) = LUT_{1,2,q11,q12}(A_{12,q11}) + µ·e₁(n)·(y₁(n-q12))*. The updating unit 313 calculates a new distortion compensation coefficient LUT_{1,3,q11,q12}(A_{13,q11}) of the LUT 213 as LUT_{1,3,q11,q12}(A_{13,q11}) = LUT_{1,3,q11,q12}(A_{13,q11}) + µ·e₁(n)·(y₁₁(n-q12))*.

The updating unit 323 calculates a new distortion compensation coefficient LUT_{2,1,q21,q22}(A_{21,q21}) of the LUT 221 as LUT_{2,1,q21,q22}(A₂₁,_{q21}) = LUT_{2,1,q21,q22}(A₂₁,_{q21}) + µ·e₂(n)·(y₂(n-q22))*. The updating unit 323 calculates a new distortion compensation coefficient LUT_{2,2,q21,q22}(A_{22,q21}) of the LUT 222 as LUT_{2,2,q21,q22}(A_{22,q21}) = LUT_{2,2,q21,q22}(A_{22,q21}) + µ·e₂(n)·(y₂(n-q22))*. The updating unit 323 calculates a new distortion compensation coefficient LUT_{2,3,q21,q22}(A_{23,q21}) of the LUT 223 as LUT_{2,3,q21,q22}(A_{23,q21}) = LUT_{2,3,q21,q22}(A_{23,q21}) + µ·e₂(n)·(y₂(n-q22))*.

In combination with the second example in the second embodiment, the delay amount pqw1 of the power |x₁(n)|² of the first transmission signal and the delay amount pqw2 of the power |x₂(n)|² of the second transmission signal are different from each other in each of the first and second transmission signals. In other words, pqw1 ≠ pqw2 in each of the first and second transmission signals. Here, let q11 be the variable delay amount of the power |x₁(n)|² of the first transmission signal, and q13 be the variable delay amount of the power |x₂(n)| of the second transmission signal, in the first transmission signal. Let q21 be the variable delay amount of the power |x₂(n)|² of the second transmission signal, and q23 be the variable delay amount of the power |x₁(n)|² of the first transmission signal, in the second transmission signal. Let q12 be the variable delay amount qtx1 of the first transmission signal, and q22 be the variable delay amount qtx2 of the second transmission signal.

The updating unit 313 calculates a new distortion compensation coefficient LUT_{1,1,q11,q12,q13}(A_{11,q11}) of the LUT 211 as LUT_{1,1,q11,q12,q13}(A_{11,q11}) = LUT_{1,1,q11,q12,q13}(A_{11,q11}) + µ·e₁(n)·(y₁(n-q12))*. The updating unit 313 calculates a new distortion compensation coefficient LUT_{1,2,q11,q12,q13}(A_{12,q11,q13}) of the LUT 212 as LUT_{1,2,q11,q12,q13}(A_{12,q11,q13}) = LUT_{1,2,q11,q12,q13}(A_{12,q11,q13}) + µ·e₁(n)·(y₁(n-q12))*. The updating unit 313 calculates a new distortion compensation coefficient LUT LUT_{1,3,q11,q12,q13}(A_{13,q13}) of the LUT 213 as LUT_{1,3,q11,q12,q13}(A_{13,q13}) = LUT_{1,3,q11,q12,q13}(A_{13,q13}) + µ·e₁(n)·(y₁(n-q12)) *.

The updating unit 323 calculates a new distortion compensation coefficient LUT_{2,1,q21,q22,q23}(A_{21,q21}) of the LUT 221 as LUT_{2,1,q21,q22,q23}(A₂₁,_{q21}) = LUT_{2,1,q21,q22,q23}(A_{21,q21}) + µ·e₂(n)·(y₂(n-q22)) *. The updating unit 323 calculates a new distortion compensation coefficient LUT_{2,2,q21,q22,q23}(A_{22,q21,q23}) of the LUT 222 as LUT2,2,q21,q22,q23 (A_{22,q21,q23}) = LUT_{2,2,q21,q22,q23}(A_{22,q21,q23}) + µ·e₂(n)·(y₂(n-q22)) *. The updating unit 323 calculates a new distortion compensation coefficient LUT LUT_{2,3,q21,q22,q23}(A₂₃,_{q23}) of the LUT 223 as LUT_{2,3,q21,q22,q23}(A₂₃,_{q23}) = LUT_{2,3,q21,q22,q23}(A₂₃,_{q23}) + µ·e₂(n)·(y₂(n-q22))*.

A case in combination with the third example in the second embodiment will be described. In this case, LUT_{1,1,q11,q12,q13}(A_{11,q11}) in the case in combination with the second example in the second embodiment becomes LUT_{1,1,q11,q12}(A_{11,q11}), which does not include q13 as a variable. LUT_{1,3,q11,q12,q13}(A_{13,q13}) becomes LUT_{1,3,q12,q13}(A_{13,q13}), which does not include q11 as a variable. LUT_{2,1,q21,q22,q23}(A_{21,q21}) becomes LUT_{2,1,q21,q22}(A₂₁,_{q21}), which does not include q23 as a variable. LUT_{2,3,q21,q22,q23}(A_{23,q23}) becomes LUT_{2,3,q22,q23}(A_{23,q23}), which does not include q21 as a variable.

The updating unit 313 calculates a new distortion compensation coefficient LUT_{1,1,q11,q12}(A_{11,q11}) of the LUT 211 as LUT_{1,1,q11,q12} (A_{11,q11}) = LUT_{1,1,q11,q12} (A_{11,q11}) + µ·e₁(n)·(y₁(n-q12))*. The updating unit 313 calculates a new distortion compensation coefficient LUT_{1,2,q11,q12,q13}(A_{12,q11,q13}) of the LUT 212 as LUT_{1,2,q11,q12,q13}(A_{12,q11,q13}) = LUT_{1,2,q11,q12,q13}(A_{12,q11,q13}) + µ·e₁(n)·(y₁(n-q12))*. The updating unit 313 calculates a new distortion compensation coefficient LUT_{1,3,q12,q13}(A_{13,q13}) of the LUT 213 as LUT_{1,3,q12,q13}(A_{13,q13}) = LUT_{1,3,q12,q13}(A_{13,q13}) + µ·e₁(n)·(y₁(n-q12))*.

The updating unit 323 calculates a new distortion compensation coefficient LUT_{2,1,q21,q22}(A_{21,q21}) of the LUT 221 as LUT_{2,1,q21,q22}(A₂₁,_{q21}) = LUT_{2,1,q21,q22}(A₂₁,_{q21}) + µ·e₂(n)·(y₂(n-q22))*. The updating unit 323 calculates a new distortion compensation coefficient LUT_{2,2,q21,q22,q23}(A_{22,q21,q23}) of the LUT 222 as LUT_{2,2,q21,q22,q23}(A_{22,q21,q23}) = LUT_{2,2,q21,q22,q23}(A_{22,q21,q23}) + µ·e₂(n)·(y₂(n-q22))*. The updating unit 323 calculates a new distortion compensation coefficient LUT_{2,3,q22,q23}(A_{23,q23}) of the LUT 223 as LUT_{2,3,q22,q23}(A_{23,q23}) = LUT_{2,3,q22,q23}(A_{23,q23}) + µ·e₂(n)·(y₂(n-q22))*.

### Modification 4-2

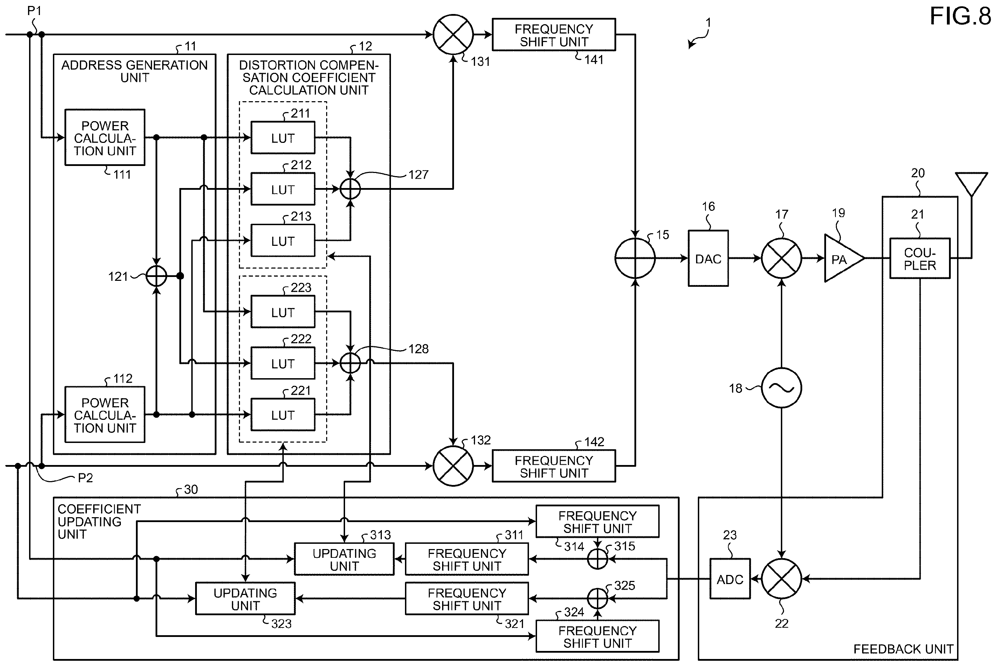

Modification 4-2 of the fourth embodiment will now be described. FIG. 8 is a block diagram of the radio equipment according to modification 4-2. The radio equipment 1 according to the present modification further includes frequency shift units 314 and 324, and adders 315 and 325. In this case, the radio equipment 1 does not have to include the LPFs 312 and 322.

The frequency shift unit 314 receives input of the second transmission signal before distortion compensation that is branched from the signal path P2. The frequency shift unit 314 then applies the same frequency shift as in signal transmission to the second transmission signal. The frequency shift unit 314 then outputs an inverted signal of the second transmission signal with frequency shift to the adder 315.

The frequency shift unit 324 receives input of the first transmission signal before distortion compensation that is branched from the signal path P1. The frequency shift unit 324 then applies the same frequency shift as in signal transmission to the first transmission signal. The frequency shift unit 324 then outputs an inverted signal of the first transmission signal with frequency shift to the adder 325.

The adder 315 receives input of a distributed feedback signal. The adder 315 also receives input of the inverted signal of the frequency-shifted second transmission signal from the frequency shift unit 314. The adder 315 then adds the feedback signal and the inverted signal of the frequency-shifted second transmission signal to remove the component of the second transmission signal from the feedback signal and generates a feedback signal corresponding to the first transmission signal. The adder 315 then outputs the feedback signal corresponding to the first transmission signal to the frequency shift unit 311.

The adder 325 receives input of a distributed feedback signal. The adder 325 also receives input of the inverted signal of the frequency-shifted first transmission signal from the frequency shift unit 324. The adder 325 then adds the feedback signal and the inverted signal of the frequency-shifted first transmission signal to remove the component of the first transmission signal from the feedback signal and generates a feedback signal corresponding to the second transmission signal. The adder 325 then outputs the feedback signal corresponding to the second transmission signal to the frequency shift unit 321.

As explained above, the radio equipment 1 according to the present embodiment extracts a feedback signal for each band by subtracting the frequency-shifted transmission signal in another band after the feedback signal is distributed, instead of using frequency shifting and filtering. In this way, the radio equipment 1 can generate a feedback signal for each band even by subtracting the frequency-shifted transmission signal in another band, and improve the distortion compensation performance even when the nonlinear characteristic of the PA 19 varies over time.

In the feedback signal for each band, nonlinear distortion components in other bands may be included for a particular band, but the linear distortion components in other bands can be considered to be noise because they are generally not correlated with the transmission signal and nonlinear distortion of the particular band. Therefore, as the distortion compensation coefficient is repeatedly updated, the distortion compensation coefficient is averaged, so that the radio equipment 1 according to the present embodiment can nullify the influence of nonlinear distortion components of other bands on the particular band.

### Modification 4-3

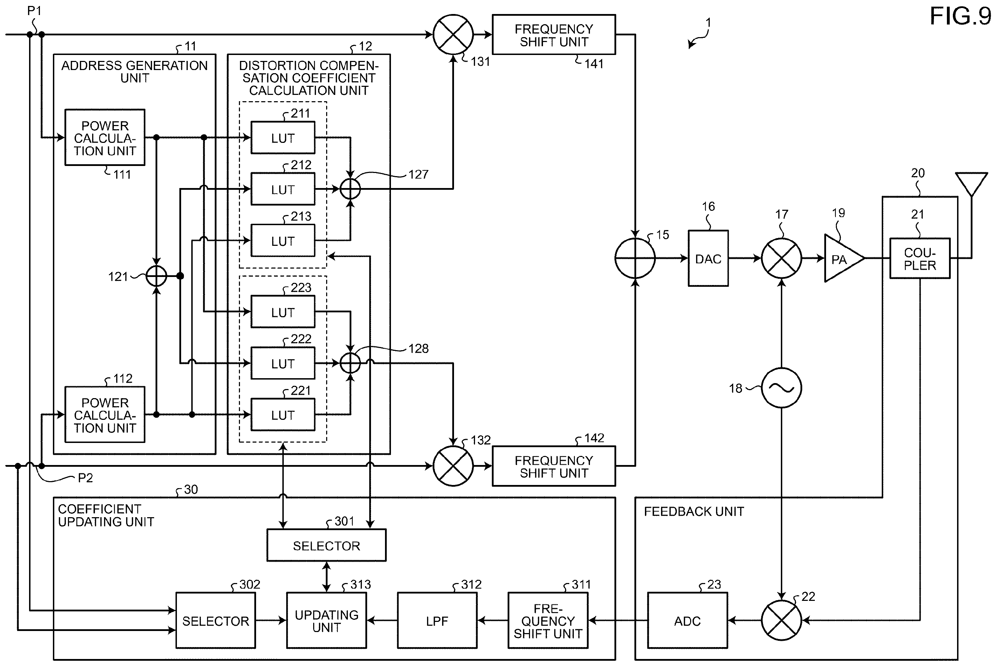

Modification 4-3 of the fourth embodiment will now be described. FIG. 9 is a block diagram of the radio equipment according to modification 4-3. The radio equipment 1 according to the present modification includes selectors 301 and 302. In this case, the radio equipment 1 does not have to include the frequency shift unit 321, the LPF 322, and the updating unit 323. The radio equipment 1 according to the present modification updates a distortion compensation coefficient for each band in a time-division exclusive manner.

The frequency shift unit 311 receives a feedback signal without distribution. The frequency shift unit 311 then outputs either the feedback signal of the first transmission signal in the first band or the feedback signal of the second transmission signal in the second in a time-division manner by changing the frequency to be shifted at a predetermined timing.

The selector 302 receives inputs of the first transmission signal before distortion compensation that is branched from the signal path P1 and the second transmission signal before distortion compensation that is branched from the signal path P2. The selector 302 then selects and outputs the first transmission signal in accordance with the timing of output of the feedback signal of the first transmission signal from the frequency shift unit 311, and selects and outputs the second transmission signal in accordance with the timing of output of the feedback signal of the second transmission signal.

The selector 301 connects the updating unit 313 to the LUTs 211 to 213 when the feedback signal of the first transmission signal is output from the frequency shift unit 311. The selector 301 connects the updating unit 313 to the LUTs 221 to 223 when the feedback signal of the second transmission signal is output from the frequency shift unit 311.

The updating unit 313 calculates new distortion compensation coefficients of the LUTs 211 to 213 when the feedback signal of the first transmission signal is output from the frequency shift unit 311. The updating unit 313 then updates the distortion compensation coefficients of the LUTs 211 to 213 with the calculated distortion compensation coefficients.

The updating unit 313 calculates new distortion compensation coefficients of the LUTs 221 to 223 when the feedback signal of the second transmission signal is output from the frequency shift unit 311. The updating unit 313 then updates the distortion compensation coefficients of the LUTs 221 to 223 with the calculated distortion compensation coefficients.

In this way, the coefficient updating unit 30 according to the present embodiment switches the band for which the distortion compensation coefficient is updated, at a predetermined timing, and switches the frequency to be shifted by the frequency shift unit 311 and the setting of the selectors 301 and 302, in response to the switching. This configuration eliminates the need for the radio equipment 1 to have the frequency shift unit 321, the LPF 322, and the updating unit 323, thereby reducing the circuit scale of the digital section.

### (e) Fifth Embodiment

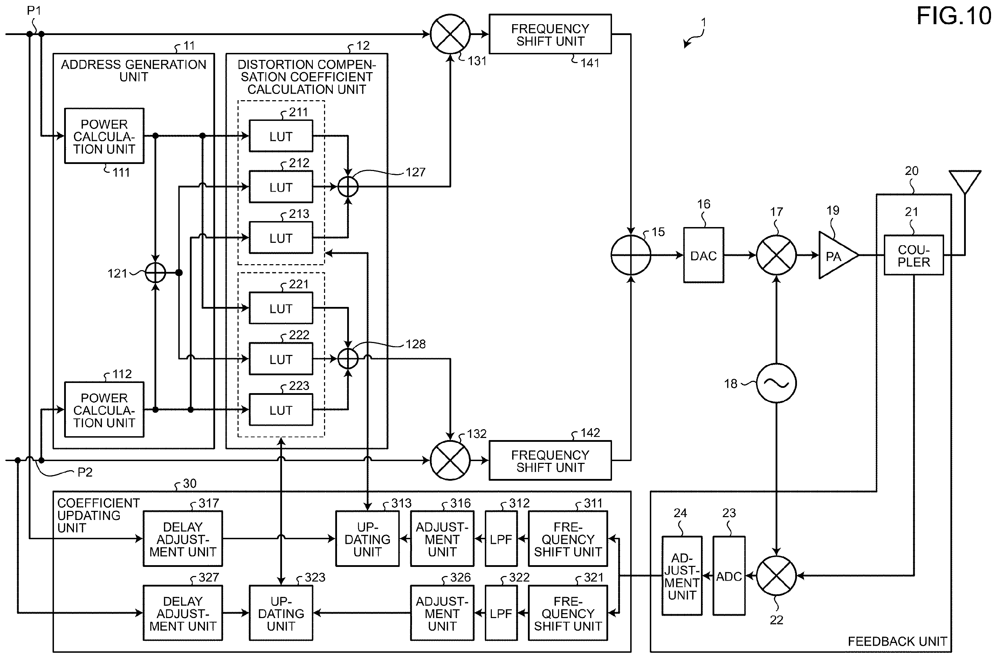

FIG. 10 is a block diagram of the radio equipment according to a fifth embodiment. The radio equipment 1 according to the present embodiment performs delay adjustment for the transmission signal and various adjustments for the feedback signal in the process of updating the distortion compensation coefficient. As illustrated in FIG. 10, the radio equipment 1 according to the present embodiment includes an adjustment unit 24 in the feedback unit 20, and adjustment units 316 and 326 and delay adjustment units 317 and 327 in the coefficient updating unit 30.

The adjustment unit 24 compares a combined transmission signal obtained by combining the first and second transmission signals after frequency shifting with a feedback signal output from the ADC 23. Here, the input path of the combined transmission signal to the adjustment unit 24 is omitted for clarity in FIG. 10, but the adjustment unit 24 can acquire the combined transmission signal, for example, from the adder 15. The adjustment unit 24 then performs various adjustments for the feedback signal according to the comparison result. For example, the adjustment unit 24 can perform all or a combination of gain adjustment, phase adjustment, delay adjustment, and frequency characteristic correction.

When the first transmission signal and the feedback signal of the first transmission signal are compared on the time axis, the feedback signal is delayed compared to the transmission signal because it passes through the path to the PA 19 in the analog section and the path for feedback. This is applicable to the second transmission signal. Therefore, the adjustment units 316 and 326 and the delay adjustment units 317 and 327 perform a delay adjustment as follows to align the timing of the first transmission signal with the feedback signal of the first transmission signal and the timing of the second transmission signal with the feedback signal of the second transmission signal.

The adjustment unit 316 compares the first transmission signal in the first band with the feedback signal of the first transmission signal and makes a delay adjustment for the feedback signal of the first transmission signal to align the timing. The adjustment unit 326 also compares the second transmission signal in the second band with the feedback signal of the second transmission signal and makes a delay adjustment for the feedback signal of the second transmission signal to align the timing. Here, the input path of the first transmission signal to the adjustment unit 316 is omitted for clarity in FIG. 10, but the adjustment unit 316 may receive the first transmission signal from the updating unit 313 or the delay adjustment unit 317. This is applicable to the adjustment unit 326. The adjustment units 316 and 326 may perform all or one or some of gain adjustment, phase adjustment, and frequency characteristic correction.

The delay adjustment unit 317 compares the first transmission signal in the first band with the feedback signal of the first transmission signal and makes a delay adjustment for the first transmission signal to align the timing. The delay adjustment unit 327 also compares the second transmission signal in the second band with the feedback signal of the second transmission signal and makes a delay adjustment for the second transmission signal to align the timing. Here, the input path of the feedback signal of the first transmission signal to the delay adjustment unit 317 is omitted for clarity in FIG. 10, but the delay adjustment unit 317 may receive the feedback signal of the first transmission signal from the updating unit 313 or the adjustment unit 316. This is applicable to the delay adjustment unit 327.

The coefficient updating unit 30 may adjust the delay amount with different resolutions for the delay adjustment for the first transmission signal and the delay adjustment for the feedback signal of the first transmission signal. Similarly, the coefficient updating unit 30 may adjust the delay amount with different resolutions for the delay adjustment for the second transmission signal and the delay adjustment for the feedback signal of the second transmission signal.

The delay adjustment unit 317, for example, performs a delay adjustment in units of sample intervals corresponding to the sampling rate of the digital section, as the delay adjustment for the first transmission signal. The delay adjustment unit 327, for example, performs a delay adjustment in units of sample intervals corresponding to the sampling rate of the digital section, as the delay adjustment for the second transmission signal. The delay adjustment units 317 and 327, which make a delay adjustment for the first and second transmission signals, perform a delay adjustment with a large resolution.

The adjustment unit 316, for example, performs a delay adjustment in fine units smaller than the sample interval corresponding to the sampling rate of the digital section, as the delay adjustment for the feedback signal of the first transmission signal. The adjustment unit 316 may perform a delay adjustment using, for example, an FIR filter. The adjustment unit 316 may perform frequency characteristic correction using an FIR filter or the like.

The adjustment unit 326, for example, performs a delay adjustment in fine units smaller than the sample interval corresponding to the sampling rate of the digital section, as the delay adjustment for the feedback signal of the second transmission signal. The adjustment unit 326 may perform a delay adjustment using, for example, an FIR filter. The adjustment unit 326 may perform frequency characteristic correction using an FIR filter or the like.

Here, an FIR filter can be used as the LPF 312. In this case, the FIR filter of the LPF 312 can be integrated with the FIR filter for delay adjustment in units smaller than the clocks of the feedback signal of the first transmission signal in the adjustment unit 316. In other words, a single FIR filter can serve both the functions of delay adjustment in units smaller the clocks of the feedback signal of the first transmission signal and frequency range limitation. This is applicable to the LPF 322 and the adjustment unit 326.

Here, the delay adjustment units 317 and 327 perform a delay adjustment with a large resolution, while the adjustment units 316 and 326 perform a delay adjustment in fine units, but this may be reversed. The radio equipment 1 may include all or one or some of the adjustment units 316 and 326 and the delay adjustment units 317 and 327. For example, the delay adjustment units 317 and 327 may perform both delay adjustment in units of clocks and delay adjustment in units smaller than the clocks for the first and second transmission signals, and omit delay adjustment for the feedback signals.

Here, the delay added by the adjustment unit 316 to the feedback signal of the first transmission signal and the delay added by the adjustment unit 326 to the feedback signal of the second transmission signal are examples of "third delay". The delay added by the delay adjustment unit 317 to the first transmission signal and the delay added by the delay adjustment unit 327 to the second transmission signal are examples of "fourth delay". In other words, the coefficient updating unit 30 updates the first distortion compensation coefficient by adding the third delay to the feedback signal and/or adding the fourth delay to the first and second signals to align the timing to compare the feedback signal and the first and second signals.

In addition, the configuration of the fifth embodiment described above may be combined with the configuration of the second embodiment. For example, the adjustment unit 316 or the delay adjustment unit 317 compares the first transmission signal in the first band with the feedback signal of the first transmission signal to calculate the delay amount of the first transmission signal. The adjustment unit 326 or the delay adjustment unit 327 calculates the delay amount of the second transmission signal obtained by comparing the second transmission signal in the second band with the feedback signal of the second transmission signal. The delay amount may then be adjusted between the bands by applying to the delay addition units 101 and 134 a delay equal to the difference between the delay amount of the first transmission signal and the delay amount of the second transmission signal, which corresponds to the difference in delay amount between the bands. Conversely, the delay amount may be adjusted between the bands by applying to the delay addition units 102 and 135 a delay equal to the difference between the delay amount of the first transmission signal and the delay amount of the second transmission signal, which corresponds to the difference in delay amount between the bands. As a result, the radio equipment 1 can improve distortion compensation performance even when there is a difference in delay amount between bands.

As explained above, the radio equipment 1 according to the present embodiment performs a delay adjustment for the transmission signal and various adjustments for the feedback signal. As a result, the radio equipment 1 can calculate more optimal distortion compensation coefficients and improve distortion compensation performance.

### (f) Sixth Embodiment

In each of the above embodiments, the radio equipment 1 combines the pre-distortion signals in the first and second bands after frequency shifting and converts the combined pre-distortion signal from digital to analog. The radio equipment 1 then converts the combined pre-distortion signal converted to analog to a radio frequency with an up-converter and amplifies the power. However, the radio equipment 1 is not limited to this configuration.

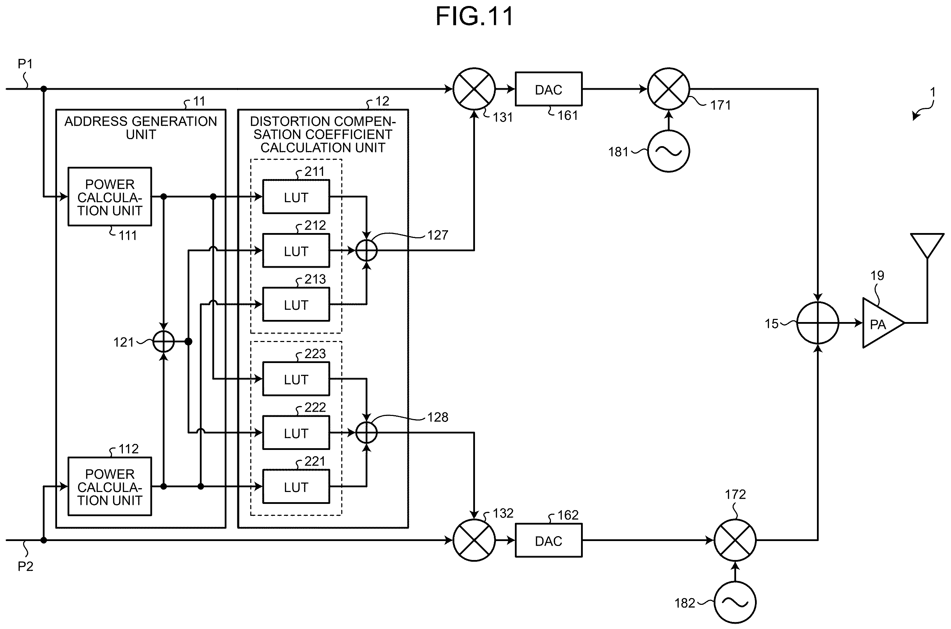

FIG. 11 is a block diagram of the radio equipment according to a sixth embodiment. Instead of combining the pre-distortion signals in the first and second bands in the digital section, the radio equipment 1 according to the present embodiment combines the pre-distortion signals in the first and second bands in the analog section. As illustrated in FIG. 11, the radio equipment 1 according to the present embodiment includes a DAC 161, which is a DAC for the first transmission signal, and an up-converter 171 and a local oscillator 181 for the first transmission signal, as well as a DAC 162, which is a DAC for the second transmission signal, and an up-converter 172 and a local oscillator 182 for the second transmission signal. In the following, the description of the operation of each unit similar to that of the first embodiment may be omitted.

The DAC 161 receives input of the pre-distortion signal of the first transmission signal from the multiplier 131. The DAC 161 converts the pre-distortion signal of the first transmission signal from a digital signal to an analog signal and outputs the converted signal to the up-converter 171.

The local oscillator 181 generates a local signal with frequency f_{L}, which is a frequency for the first band. The local oscillator 181 then outputs the local signal with frequency f_{L} to the up-converter 171.

The up-converter 171 receives input of the pre-distortion signal of the first transmission signal from the DAC 161. The up-converter 171 then converts the pre-distortion signal of the first transmission signal to a radio frequency by up-converting by multiplying the pre-distortion signal of the first transmission signal by the local signal with frequency f_{L}.

The DAC 162 receives input of the pre-distortion signal of the second transmission signal from the multiplier 132. The DAC 162 then converts the pre-distortion signal of the second transmission signal from a digital signal to an analog signal and outputs the converted signal to the up-converter 172.

The local oscillator 182 generates a local signal with frequency f_{H}, which is a frequency for the second band. The local oscillator 182 then outputs the local signal with frequency f_{H} to the up-converter 172.

The up-converter 172 receives input of the pre-distortion signal of the second transmission signal from the DAC 162. The up-converter 172 then converts the pre-distortion signal of the second transmission signal to a radio frequency by up-converting by multiplying the pre-distortion signal of the second transmission signal by the local signal with frequency f_{H}.

The adder 15 receives input of the pre-distortion signal of the first transmission signal converted to frequency f_{L} from the up-converter 171. The adder 15 also receives input of the pre-distortion signal of the second transmission signal converted to frequency f_{H} from the up-converter 172. The adder 15 then adds and combines the pre-distortion signal of the first transmission signal converted to frequency f_{L} and the pre-distortion signal of the second transmission signal converted to frequency f_{H}. The adder 15 then outputs the combined pre-distortion signal to the PA 19.

The PA 19 amplifies the combined pre-distortion signal and emits the amplified signal into space as a radio wave from the antenna.

As explained above, the radio equipment 1 according to the present embodiment combines the pre-distortion signals for each band after conversion to analog signals. Even with this configuration, the radio equipment 1 can improve distortion compensation performance and achieve a better ACLR in multiband transmission.

### Modification 6-1

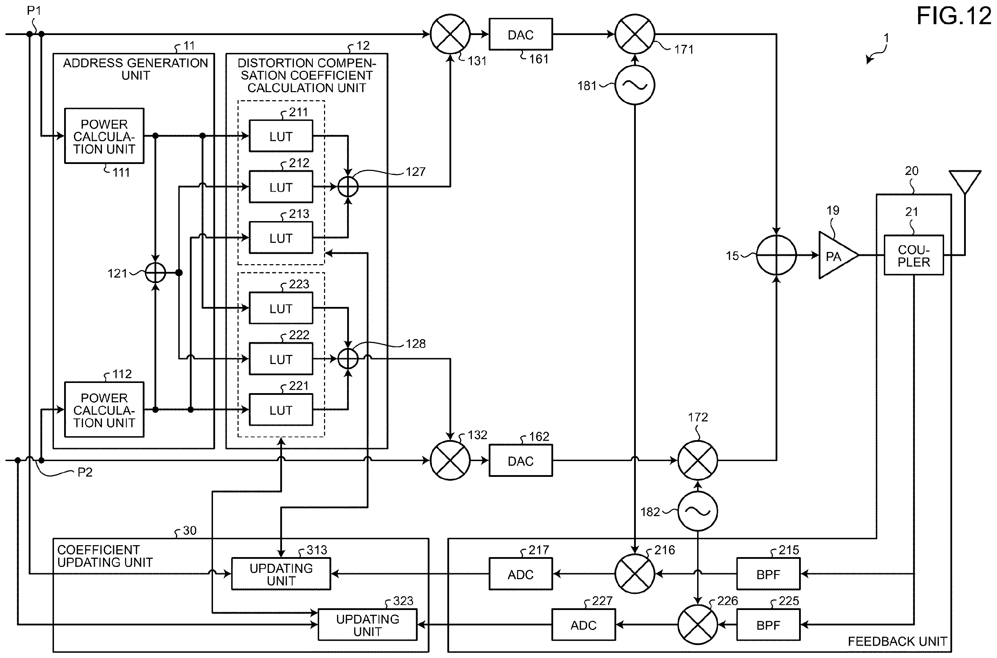

FIG. 12 is a block diagram of the radio equipment according to modification 6-1. The radio equipment 1 according to the present embodiment combines the pre-distortion signals for each band after conversion to analog signals and updates the distortion compensation coefficients using the feedback signals of the first and second transmission signals. As illustrated in FIG. 12, the radio equipment 1 according to the present embodiment includes the feedback unit 20 and the coefficient updating unit 30.

The feedback unit 20 includes a coupler 21, band pass filters (BPFs) 215 and 225, multipliers 216 and 226, and ADCs 217 and 227. The coefficient updating unit 30 includes updating units 313 and 323.

A portion of the amplifier output signal output from the PA 19 is extracted and distributed by the coupler 21. The distributed amplifier output signals after distribution are input to the BPFs 215 and 225.

The BPFs 215 and 225 are analog filters. The BPF 215 receives input of the amplifier output signal and passes a signal in a frequency range of the first band. The BPF 225 receives input of the amplifier output signal and passes a signal in a frequency range of the second band.

The multiplier 216 and the local oscillator 181 are a down-converter. The multiplier 226 and the local oscillator 182 are also a down-converter. The multiplier 216 down-converts the signal passed through the BPF 215 and outputs the down-converted signal. The multiplier 226 down-converts the signal passed through the BPF 225 and outputs the down-converted signal. With the downconversion, each signal is converted to a baseband or an intermediate frequency.

The ADC 217 converts the signal down-converted by the multiplier 216 from an analog signal to a digital signal and outputs the converted signal as a feedback signal of the first transmission signal. The ADC 227 converts the signal down-converted by the multiplier 226 from an analog signal to a digital signal and outputs the converted signal as a feedback signal of the second transmission signal.

The updating unit 313 calculates new distortion compensation coefficients of the LUTs 211 to 213 using the first transmission signal, the feedback signal of the first transmission signal, and the distortion compensation coefficients before updating of the LUTs 211 to 213. The updating unit 313 then updates the distortion compensation coefficients of the LUTs 211 to 213 to the calculated distortion compensation coefficients. The updating unit 323 calculates new distortion compensation coefficients of the LUTs 221 to 223 using the second transmission signal, the feedback signal of the second transmission signal, and the distortion compensation coefficients before updating of the LUTs 221 to 223. The updating unit 323 then updates the distortion compensation coefficients of the LUTs 221 to 223 to the calculated distortion compensation coefficients.

As explained above, the radio equipment 1 according to the present embodiment combines the pre-distortion signals for each band after conversion to analog signals and updates the distortion compensation coefficients using the feedback signals. As a result, the radio equipment 1 can perform more appropriate distortion compensation in the configuration that combines the pre-distortion signals for each band after conversion to analog signals.

### Modification 6-2

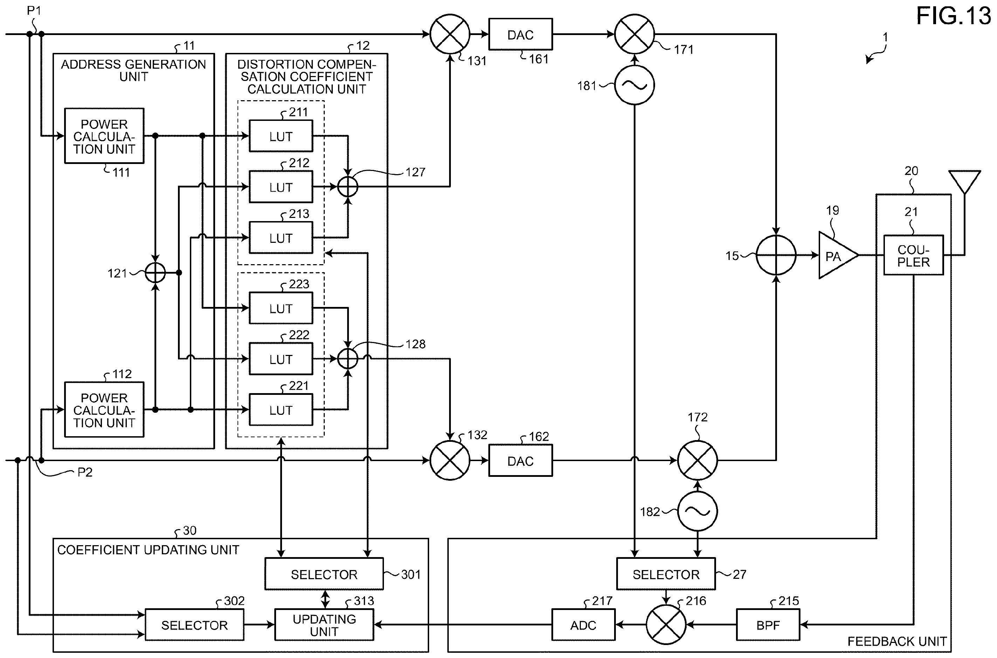

FIG. 13 is a block diagram of the radio equipment according to modification 6-2. The radio equipment 1 according to the present embodiment combines the pre-distortion signals for each band after conversion to analog signals and updates the distortion compensation coefficients using the feedback signals of the first and second transmission signals while switching the selection between the first and second bands. As illustrated in FIG. 13, the radio equipment 1 according to the present embodiment includes the feedback unit 20 and the coefficient updating unit 30.

The BPF 215 receives input of the amplifier output signal and switches between the frequency range of the first band and the frequency range of the second band to pass a signal at a predetermined timing.

A selector 27 selects the local signal with frequency f_{L} in the first band from the local oscillator 181 or the local signal with frequency f_{H} in the second band from the local oscillator 182 at a predetermined timing, and sends the selected local signal to the multiplier 216. The multiplier 216 down-converts a signal to a baseband or an intermediate frequency, using the local signal with frequency f_{L} in the first band or the local signal with frequency f_{H} in the second band that is input at a predetermined timing.

The ADC 217 converts the down-converted signal from an analog signal to a digital signal and outputs the converted signal as a feedback signal.

The selector 302 switches between the first transmission signal acquired from the signal path P1 and the second transmission signal acquired from the signal path P2 at a predetermined timing, and outputs the first or second transmission signal to the updating unit 313.

The selector 301 switches the connection of the updating unit 313 to the LUTs 211 to 213 or to the LUTs 221 to 223 at a predetermined timing.

The updating unit 313 updates the distortion compensation coefficients of the LUTs 211 to 213 or the LUTs 221 to 223 using the first or second transmission signal from the selector 302 and the feedback signal of the first or second transmission signal from the ADC 217.

As explained above, the radio equipment 1 according to the present embodiment combines the pre-distortion signals for each band after conversion to analog signals and updates the distortion compensation coefficient using the feedback signal while switching the target band. As a result, the radio equipment 1 can reduce the circuit scale of the digital section in the configuration that combines the pre-distortion signals for each band after conversion to analog signals and updates the distortion compensation coefficients.

### (g) Seventh Embodiment

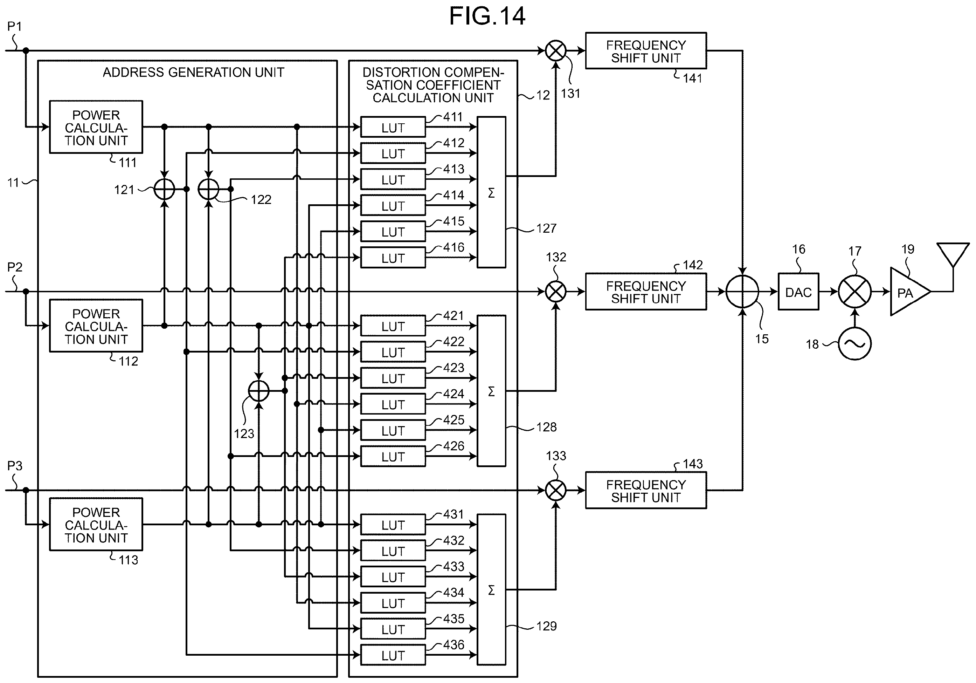

In each of the above embodiments, a case with two bands has been described as an example of multiband, but the radio equipment 1 may perform multiband transmission with three or more bands. In the present embodiment, the radio equipment 1 performs multiband transmission using three bands. FIG. 14 is a block diagram of the radio equipment according to a seventh embodiment.

The address generation unit 11 includes power calculation units 111 to 113 and adders 121 to 123. The distortion compensation coefficient calculation unit 12 includes LUTs 411 to 416, LUTs 421 to 426, LUTs 431 to 436, adders 127 to 129, and multipliers 131 to 133. The radio equipment 1 also includes frequency shift units 141 to 143.

A first transmission signal x₁(n) in a first band is input to a signal path P1. A second transmission signal x₂(n) in a second band is input to a signal path P2. A third transmission signal x₃(n) in a third band is input to a signal path P3.

The address generation unit 11 generates an address A₁₁ corresponding to the power of the first transmission signal itself for the first transmission signal, using the power calculation units 111 to 113. The address generation unit 11 also generates an address A₁₄ corresponding to the power of the second transmission signal for the first transmission signal, using the power calculation units 111 to 113. The address generation unit 11 also generates an address A₁₅ corresponding to the power of the third transmission signal for the first transmission signal, using the power calculation units 111 to 113. The address generation unit 11 also generates an address A₁₂ corresponding to the composite power of the first and second transmission signals for the first transmission signal, using the power calculation units 111 to 113 and the adders 121 to 123. The address generation unit 11 also generates an address A₁₃ corresponding to the composite power of the first and third transmission signals for the first transmission signal, using the power calculation units 111 to 113 and the adders 121 to 123. The address generation unit 11 also generates an address A₁₆ corresponding to the composite power of the second and third transmission signals for the first transmission signal, using the power calculation units 111 to 113 and the adders 121 to 123.

Here, A₁₁ = |x₁(n)|². A₁₂ = |x₁(n)|² + |x₂(n)|². A₁₃ = |x₁(n)|² + |x₃(n)|². A₁₄ = |x₂(n)|². A₁₅ = |x₃(n)|². A₁₆ = |x₂(n)|² + |x₃(n)|².

The address generation unit 11 generates an address A₂₁ corresponding to the power of the second transmission signal itself for the second transmission signal, using the power calculation units 111 to 113. The address generation unit 11 also generates an address A₂₄ corresponding to the power of the first transmission signal for the second transmission signal, using the power calculation units 111 to 113. The address generation unit 11 also generates an address A₂₅ corresponding to the power of the third transmission signal for the second transmission signal, using the power calculation units 111 to 113. The address generation unit 11 also generates an address A₂₂ corresponding to the composite power of the first and second transmission signals for the second transmission signal, using the power calculation units 111 to 113 and the adders 121 to 123. The address generation unit 11 also generates an address A₂₃ corresponding to the composite power of the second and third transmission signals for the second transmission signal, using the power calculation units 111 to 113 and the adders 121 to 123. The address generation unit 11 also generates an address A₂₆ corresponding to the composite power of the first and third transmission signals for the second transmission signal, using the power calculation units 111 to 113 and the adders 121 to 123.

Here, A₂₁= |x₂(n)|². A₂₂ = |x₁(n)|² + |x₂(n)|². A₂₃ = |x₂(n)|² + |x₃(n)|². A₂₄ = |x₁(n)|². A₂₅ = |x₃(n)|². A₂₆ = |x₁(n)|² + |x₃(n)|².

The address generation unit 11 generates an address A₃₁ corresponding to the power of the third transmission signal itself for the third transmission signal, using the power calculation units 111 to 113. The address generation unit 11 also generates an address A₃₄ corresponding to the power of the first transmission signal for the third transmission signal, using the power calculation units 111 to 113. The address generation unit 11 also generates an address A₃₅ corresponding to the power of the second transmission signal for the third transmission signal, using the power calculation units 111 to 113. The address generation unit 11 also generates an address A₃₂ corresponding to the composite power of the first and third transmission signals for the third transmission signal, using the power calculation units 111 to 113 and the adders 121 to 123. The address generation unit 11 also generates an address A₃₃ corresponding to the composite power of the second and third transmission signals for the third transmission signal, using the power calculation units 111 to 113 and the adders 121 to 123. The address generation unit 11 also generates an address A₃₆ corresponding to the composite power of the first and second transmission signals for the third transmission signal, using the power calculation units 111 to 113 and the adders 121 to 123.

Here, A₃₁ = |x₃(n)|². A₃₂ = |x₁(n)|² + |x₃(n)|². A₃₃ = |x₂(n)|² + |x₃(n)|². A₃₄ = |x₁(n)|². A₃₅ = |x₂(n)|². A₃₆ = |x₁(n)|² + |x₂(n)|².

The LUT 411 is a table in which a distortion compensation coefficient for distortion compensation for the first transmission signal with respect to the power of the first transmission signal itself is stored in association with the address of the first transmission signal. The LUT 411 outputs a distortion compensation coefficient LUT_{1,1}(A₁₁) for input of the address A₁₁. The LUT 414 is a table in which a distortion compensation coefficient for distortion compensation for the first transmission signal with respect to the power of the second transmission signal is stored in association with the address of the second transmission signal. The LUT 414 outputs a distortion compensation coefficient LUT_{1,4}(A₁₄) for input of the address A₁₄. The LUT 415 is a table in which a distortion compensation coefficient for distortion compensation for the first transmission signal with respect to the power of the third transmission signal is stored in association with the address of the third transmission signal. The LUT 415 outputs a distortion compensation coefficient LUT_{1,5}(A₁₅) for input of the address A₁₅.

The LUT 412 is a table in which a distortion compensation coefficient for distortion compensation for the first transmission signal with respect to the composite power of the first and second transmission signals is stored in association with the address of the composite power. The LUT 412 outputs a distortion compensation coefficient LUT_{1,2}(A₁₂) for input of the address A₁₂. The LUT 413 is a table in which a distortion compensation coefficient for distortion compensation for the first transmission signal with respect to the composite power of the first and third transmission signals is stored in association with the address of the composite power. The LUT 413 outputs a distortion compensation coefficient LUT_{1,3}(A₁₃) for input of the address A₁₃. The LUT 416 is a table in which a distortion compensation coefficient for distortion compensation for the first transmission signal with respect to the composite power of the second and third transmission signals is stored in association with the address of the composite power. The LUT 416 outputs a distortion compensation coefficient LUT_{1,6}(A₁₆) for input of the address A₁₆.

The LUT 421 is a table in which a distortion compensation coefficient for distortion compensation for the second transmission signal with respect to the power of the second transmission signal itself is stored in association with the address of the second transmission signal. The LUT 421 outputs a distortion compensation coefficient LUT_{2,1}(A₂₁) for input of the address A₂₁. The LUT 424 is a table in which a distortion compensation coefficient for distortion compensation for the second transmission signal with respect to the power of the first transmission signal is stored in association with the address of the first transmission signal. The LUT 424 outputs a distortion compensation coefficient LUT_{2,4}(A₂₄) for input of the address A₂₄. The LUT 425 is a table in which a distortion compensation coefficient for distortion compensation for the second transmission signal with respect to the power of the third transmission signal is stored in association with the address of the third transmission signal. The LUT 425 outputs a distortion compensation coefficient LUT_{2,5}(A₂₅) for input of the address A₂₅.

The LUT 422 is a table in which a distortion compensation coefficient for distortion compensation for the second transmission signal with respect to the composite power of the first and second transmission signals is stored in association with the address of the composite power. The LUT 422 outputs a distortion compensation coefficient LUT_{2,2}(A₂₂) for input of the address A₂₂. The LUT 423 is a table in which a distortion compensation coefficient for distortion compensation for the second transmission signal with respect to the composite power of the second and third transmission signals is stored in association with the address of the composite power. The LUT 423 outputs a distortion compensation coefficient LUT_{2,3}(A₂₃) for input of the address A₂₃. The LUT 426 is a table in which a distortion compensation coefficient for distortion compensation for the second transmission signal with respect to the composite power of the first and third transmission signals is stored in association with the address of the composite power. The LUT 426 outputs a distortion compensation coefficient LUT_{2,6}(A₂₆) for input of the address A₂₆.

The LUT 431 is a table in which a distortion compensation coefficient for distortion compensation for the third transmission signal with respect to the power of the third transmission signal itself is stored in association with the address of the third transmission signal. The LUT 431 outputs a distortion compensation coefficient LUT_{3,1}(A₃₁) for input of the address A₃₁. The LUT 434 is a table in which a distortion compensation coefficient for distortion compensation for the third transmission signal with respect to the power of the first transmission signal is stored in association with the address of the first transmission signal. The LUT 434 outputs a distortion compensation coefficient LUT_{3,4}(A₃₄) for input of the address A₃₄. The LUT 435 is a table in which a distortion compensation coefficient for distortion compensation for the third transmission signal with respect to the power of the second transmission signal is stored in association with the address of the second transmission signal. The LUT 435 outputs a distortion compensation coefficient LUT_{3,5}(A₃₅) for input of the address A₃₅.

The LUT 432 is a table in which a distortion compensation coefficient for distortion compensation for the third transmission signal with respect to the composite power of the first and third transmission signals is stored in association with the address of the composite power. The LUT 432 outputs a distortion compensation coefficient LUT_{3,2}(A₃₂) for input of the address A₃₂. The LUT 433 is a table in which a distortion compensation coefficient for distortion compensation for the third transmission signal with respect to the composite power of the second and third transmission signals is stored in association with the address of the composite power. The LUT 433 outputs a distortion compensation coefficient LUT_{3,3}(A₃₃) for input of the address A₃₃. The LUT 436 is a table in which a distortion compensation coefficient for distortion compensation for the third transmission signal with respect to the composite power of the first and second transmission signals is stored in association with the address of the composite power. The LUT 436 outputs a distortion compensation coefficient LUT_{3,6}(A₃₆) for input of the address A₃₆.

The adder 127 calculates the distortion compensation coefficient of the first transmission signal as LUT_{SUM-1} = LUT_{1,1}(A₁₁) + LUT_{1,2}(A₁₂) + LUT_{1,3}(A₁₃) + LUT_{1,4}(A₁₄) + LUT_{1,5}(A₁₅) + LUT_{1,6}(A₁₆). The adder 128 calculates the distortion compensation coefficient of the second transmission signal as LUT_{SUM-2} = LUT_{2,1}(A₂₁) + LUT_{2,2}(A₂₂) + LUT_{2,3}(A₂₃) + LUT_{2,4}(A₂₄) + LUT_{2,5}(A₂₅) + LUT_{2,6}(A₂₆). The adder 129 calculates the distortion compensation coefficient of the third transmission signal as LUT_{SUM-3} = LUT_{3,1}(A₃₁) + LUT_{3,2}(A₃₂) + LUT_{3,3}(A₃₃) + LUT_{3,4}(A₃₄) + LUT_{3,5}(A₃₅) + LUT_{3,6}(A₃₆).

The multiplier 131 multiplies the distortion compensation coefficient LUT_{SUM-1} input from the adder 127 and the first transmission signal x₁(n) to calculate a pre-distortion signal u₁(n) of the first transmission signal in the first band. In other words, u₁(n) = x₁(n) ·LUT_{SUM-1}.

The multiplier 132 multiplies the distortion compensation coefficient LUT_{SUM-2} input from the adder 128 and the second transmission signal x₂(n) to calculate a pre-distortion signal u₂(n) of the second transmission signal in the second band. In other words, u₂(n) = x₂(n) ·LUT_{SUM-2} .

The multiplier 133 multiplies the distortion compensation coefficient LUT_{SUM-3} input from the adder 129 and the third transmission signal x₃(n) to calculate a pre-distortion signal u₃(n) of the third transmission signal in the third band. In other words, u₃(n) = x₃(n) ·LUT_{SUM-3}.

Although the case of using three bands is described here, the radio equipment 1 may perform distortion compensation similarly for four or more bands.

### Modification 7-1

Modification 7-1 of the seventh embodiment will now be described. The configuration according to the seventh embodiment can be combined with the configuration in the second embodiment. For example, an example in combination with the first to third examples of the second embodiment will be described below. In this case, the radio equipment 1 has the delay addition unit 101 between the power calculation unit 111 and the distortion compensation coefficient calculation unit 12. The radio equipment 1 has the delay addition unit 102 between the power calculation unit 112 and the distortion compensation coefficient calculation unit 12. The radio equipment 1 has A delay addition unit 103 between the power calculation unit 113 and the distortion compensation coefficient calculation unit 12. The radio equipment 1 has the delay addition unit 134 between a branch point to the power calculation unit 111 in the signal path P1 and the multiplier 131. The radio equipment 1 has the delay addition unit 135 between a branch point to the power calculation unit 112 in the signal path P2 and the multiplier 132. The radio equipment 1 has A delay addition unit 136 between a branch point to the power calculation unit 113 in the signal path P3 and the multiplier 133.

A case in combination with the first example in the second embodiment will be described. In each of the first to third transmission signals, the delay amount qpw1 of the power |x₁(n)|² of the first transmission signal in the first band, the delay amount qpw2 of the power |x₂(n)|² of the second transmission signal in the second band, and the delay amount qpw3 of the power |x₃(n)|² of the third transmission signal in the third band are the same. In other words, qpw1 = qpw2 = qpw3 = qpw. Here, suppose that the delay amount of the power |x₁(n)|² of the first transmission signal, the delay amount of the power |x₂(n)|² of the second transmission signal, and the delay amount of the power |x₃(n)|². of the third transmission signal in the first transmission signal are a changeable delay amount q11. The delay amount of the power |x₁(n)|² of the first transmission signal, the delay amount of the power |x₂(n)|² of the second transmission signal, and the delay amount of the power |x₃(n)|². of the third transmission signal in the second transmission signal are a changeable delay amount q21. The delay amount of the power |x₁(n)|² of the first transmission signal, the delay amount of the power |x₂(n)|² of the second transmission signal, and the delay amount of the power |x₃(n)|² of the third transmission signal in the third transmission signal are a changeable delay amount q31. The delay amount qtx1 of the first transmission signal is a changeable delay amount q12, the delay amount qtx2 of the second transmission signal is a changeable delay amount q22, and the delay amount qtx3 of the third transmission signal is a changeable delay amount q32.

The delay addition unit 134 applies the delay amount q12 to the first transmission signal x₁(n) and outputs x₁(n-q12). The delay addition unit 135 applies the delay amount q22 to the second transmission signal x₂(n) and outputs x₂(n-q22). The delay addition unit 136 applies the delay amount q32 to the third transmission signal x₃(n) and outputs x₃(n-q32).

The address generation unit 11 generates the following addresses A₁₁ to A₁₆ for the first transmission signal. In other words, the address generation unit 11 generates an address A_{11,q11} = |x₁(n-q11)|² of the first transmission signal, an address A_{14,q11} = |x₂(n-q11)|² of the second transmission signal, and an address A_{15,q11} = |x₃(n-q11)|² of the third transmission signal. The address generation unit 11 also generates an address A_{12,q11} = |x₁(n-q11)|² + |x₂(n-q11)|² of the composite power of the first and second transmission signals. The address generation unit 11 also generates an address A_{13,q11} = |x₁(n-q11)|² + |x₃(n-q11)|² of the composite power of the first and third transmission signals. The address generation unit 11 also generates an address A_{16,q11} = |x₂(n-q11)|² + |x₃(n-q11)|² of the composite power of the second and third transmission signals.

The address generation unit 11 generates the following addresses A₂₁ to A₂₆ for the second transmission signal. In other words, the address generation unit 11 generates an address A_{21,q21} = |x₂(n-q21)|² of the second transmission signal, an address A_{24,q21} = |x₁(n-q21)|² of the first transmission signal, and an address A_{25,q21} = |x₃(n-q21)|² of the third transmission signal. The address generation unit 11 also generates an address A_{22,q21} = |x₁(n-q21)|² + |x₂(n-q21)|² of the composite power of the first and second transmission signals. The address generation unit 11 also generates an address A_{23,q21} = |x₂(n-q21)|² + |x₃(n-q21)|² of the composite power of the second and third transmission signals. The address generation unit 11 also generates an address A_{26,q21} = |x₁(n-q21)|² + |x₃(n-q21)|² of the composite power of the first and third transmission signals.

The address generation unit 11 generates the following addresses A₃₁ to A₃₆ for the third transmission signal. In other words, the address generation unit 11 generates an address A_{31,q31} = |x₃(n-q31)|² of the third transmission signal, an address A_{34,q31} = |x₁(n-q31)|² of the first transmission signal, and an address A_{35,q31} = |x₂(n-q31)|² of the second transmission signal. The address generation unit 11 also generates an address A_{32,q31} = |x₁(n-q31)|² + |x₃(n-q31)|² of the composite power of the first and third transmission signals. The address generation unit 11 also generates an address A_{33,q31} = |x₂(n-q31)|² + |x₃(n-q31)|² of the composite power of the second and third transmission signals. The address generation unit 11 also generates an address A_{36,q31} = |x₁(n-q31)|² + |x₂(n-q31)|² of the composite power of the first and second transmission signals.

The LUT 411 outputs LUT_{1,1,q11,q12}(A_{11,q11}) for input of the address A_{11,q11}. The LUT 412 outputs LUT_{1,2,q11,q12}(A_{12,q11}) for input of the address A_{12,q11}. The LUT 413 outputs LUT_{1,3,q11,q12}(A_{13,q11}) for input of the address A_{13,q11}. The LUT 414 outputs LUT_{1,4,q11,q12}(A_{14,q11}) for input of the address A_{14,q11}. The LUT 415 outputs LUT_{1,5,q11,q12}(A_{15,q11}) for input of the address A_{15,q11}. The LUT 416 outputs LUT_{1,6,q11,q12}(A_{16,q11}) for input of the address A_{16,q11}.

The LUT 421 outputs LUT_{2,1,q21,q22}(A_{21,q21}) for input of the address A_{21,q21}. The LUT 422 outputs LUT_{2,2,q21,q22}(A_{22,q21}) for input of the address A_{22,q21}. The LUT 423 outputs LUT_{2,3,q21,q22}(A_{23,q21)} for input of the address A_{23,q21}. The LUT 424 outputs LUT_{2,4,q21,q22}(A_{24,q21}) for input of the address A_{24,q21}. The LUT 425 outputs LUT_{2,5,q21,q22}(A_{25,q21}) for input of the address A_{25,q21}. The LUT 426 outputs LUT_{2,6,q21,q22}(A_{26,q21)} for input of the address A_{26,q21}.

The LUT 431 outputs LUT_{3,1,q31,q32}(A_{31,q31}) for input of the address A_{31,q31}. The LUT 432 outputs LUT_{3,2,q31,q32}(A_{32,q31}) for input of the address A_{32,q31}. The LUT 433 outputs LUT_{3,3,q31,q32}(A_{33,q31}) for input of the address A_{33,q31}. The LUT 434 outputs LUT_{3,4,q31,q32}(A_{34,q31}) for input of the address A_{34,q31}. The LUT 435 outputs LUT_{3,5,q31,q32}(A_{35,q31}) for input of the address A_{35,q31}. The LUT 436 outputs LUT_{3,6,q31,q32}(A_{36,q31}) for input of the address A_{36,q31}.

The adder 127 calculates a distortion compensation coefficient LUT_{SUM-1,q12} of the first transmission signal according to the following equation (10). Here, the radio equipment 1 varies q11 from -Q_{1,1} to +Q_{1,1}.$\begin{matrix}{LUT}_{SUM - 1 , {q}_{12}} \\ = {\sum }_{{q}_{11} = - {Q}_{1 , 1}}^{+ {Q}_{1 , 1}} \left\{\begin{matrix}{LUT}_{1 , 1 , {q}_{11} , {q}_{12}} \left[{A}_{11 , {q}_{11}}\right] + {LUT}_{1 , 2 , {q}_{11} , {q}_{12}} \left[{A}_{12 , {q}_{11}}\right] + {LUT}_{1 , 3 , {q}_{11} , {q}_{12}} \left[{A}_{13 , {q}_{11}}\right] \\ + {LUT}_{1 , 4 , {q}_{11} , {q}_{12}} \left[{A}_{14 , {q}_{11}}\right] + {LUT}_{1 , 5 , {q}_{11} , {q}_{12}} \left[{A}_{15 , {q}_{11}}\right] + {LUT}_{1 , 6 , {q}_{11} , {q}_{12}} \left[{A}_{16 , {q}_{11}}\right]\end{matrix}\right\}\end{matrix}$

The adder 128 calculates a distortion compensation coefficient LUT_{SUM-2,q22} of the second transmission signal according to the following equation (11). Here, the radio equipment 1 varies q21 from -Q_{2,1} to +Q_{2,1}. $\begin{matrix}{LUT}_{SUM - 2 , {q}_{22}} \\ = {\sum }_{{q}_{21} = - {Q}_{2 , 1}}^{+ {Q}_{2 , 1}} \left\{\begin{matrix}{LUT}_{2 , 1 , {q}_{21} , {q}_{22}} \left[{A}_{21 , {q}_{21}}\right] + {LUT}_{2 , 2 , {q}_{21} , {q}_{22}} \left[{A}_{22 , {q}_{21}}\right] + {LUT}_{2 , 3 , {q}_{21} , {q}_{22}} \left[{A}_{23 , {q}_{21}}\right] \\ + {LUT}_{2 , 4 , {q}_{21} , {q}_{22}} \left[{A}_{24 , {q}_{21}}\right] + {LUT}_{2 , 5 , {q}_{21} , {q}_{22}} \left[{A}_{25 , {q}_{21}}\right] + {LUT}_{2 , 6 , {q}_{21} , {q}_{22}} \left[{A}_{26 , {q}_{21}}\right]\end{matrix}\right\}\end{matrix}$

The adder 129 calculates a distortion compensation coefficient LUT_{SUM-3,q32} of the first transmission signal according to the following equation (12). Here, the radio equipment 1 varies q31 from -Q_{3,1} to +Q_{3,1}.$\begin{matrix}{LUT}_{SUM - 3 , {q}_{32}} \\ = {\sum }_{{q}_{31} = - {Q}_{3 , 1}}^{+ {Q}_{3 , 1}} \left\{\begin{matrix}{LUT}_{3 , 1 , {q}_{31} , {q}_{32}} \left[{A}_{31 , {q}_{31}}\right] + {LUT}_{3 , 2 , {q}_{31} , {q}_{32}} \left[{A}_{32 , {q}_{31}}\right] + {LUT}_{3 , 3 , {q}_{31} , {q}_{32}} \left[{A}_{33 , {q}_{31}}\right] \\ + {LUT}_{3 , 4 , {q}_{31} , {q}_{32}} \left[{A}_{34 , {q}_{31}}\right] + {LUT}_{3 , 5 , {q}_{31} , {q}_{32}} \left[{A}_{35 , {q}_{31}}\right] + {LUT}_{3 , 6 , {q}_{31} , {q}_{32}} \left[{A}_{36 , {q}_{31}}\right]\end{matrix}\right\}\end{matrix}$

The multiplier 131 multiplies x₁(n-q12) output from the delay addition unit 134 and LUT_{SUM-1,q12} output from the distortion compensation coefficient calculation unit 12 and outputs a pre-distortion signal expressed by the following equation (13). Here, the radio equipment 1 varies q12 from -Q_{1,2} to +Q_{1,2}.${u}_{1} \left(n\right) = {\sum }_{{q}_{12} = - {Q}_{1 , 2}}^{+ {Q}_{1 , 2}} {x}_{1} \left(n-{q}_{12}\right) ⋅ {LUT}_{SUM - 1 , {q}_{12}}$

The multiplier 132 multiplies x₂(n-q22) output from the delay addition unit 135 and LUT_{SUM-2,q22} output from the distortion compensation coefficient calculation unit 12 and outputs a pre-distortion signal expressed by the following equation (14). Here, the radio equipment 1 varies q22 from -Q_{2,2} to +Q_{2,2}.${u}_{2} \left(n\right) = {\sum }_{{q}_{22} = - {Q}_{2 , 2}}^{+ {Q}_{2 , 2}} {x}_{2} \left(n-{q}_{22}\right) ⋅ {LUT}_{SUM - 1 , {q}_{22}}$

The multiplier 133 multiplies x₃(n-q32) output from the delay addition unit 136 and LUT_{SUM-3,q32} output from the distortion compensation coefficient calculation unit 12 and outputs a pre-distortion signal expressed by the following equation (15). Here, the radio equipment 1 varies q32 from -Q_{3,2} to +Q_{3,2}.${u}_{3} \left(n\right) = {\sum }_{{q}_{32} = - {Q}_{3 , 2}}^{+ {Q}_{3 , 2}} {x}_{3} \left(n-{q}_{32}\right) ⋅ {LUT}_{SUM - 3 , {q}_{32}}$

A case in combination with the second example in the second embodiment will be described. In each of the first to third transmission signals, the delay amount pqw1 of the power |x₁(n)|² of the first transmission signal, the delay amount pqw2 of the power |x₂(n)|² of the second transmission signal, and the delay amount qpw3 of the power |x₃(n)|². of the third transmission signal in the third band are different from each other. Here, let q11 be the variable delay amount of the power |x₁(n)|² of the first transmission signal, q13 be the variable delay amount of the power |x₂(n)|² of the second transmission signal, and q14 be the variable delay amount of the power |x₃(n)|² of the third transmission signal, in the first transmission signal. Let q21 be the variable delay amount of the power |x₂(n)|² of the second transmission signal, q23 be the variable delay amount of the power |x₁(n)|² of the first transmission signal, and q24 be the variable delay amount of the power |x₃(n)|² of the third transmission signal, in the second transmission signal. Let q31 be the variable delay amount of the power |x₃(n)|² of the third transmission signal, q33 be the variable delay amount of the power |x₁(n)|² of the first transmission signal, and q34 be the variable delay amount of the power |x₂(n)|² of the second transmission signal, in the third transmission signal. Let q12 be the variable delay amount qtx1 of the first transmission signal, q22 be the variable delay amount qtx2 of the second transmission signal, and q32 be the variable delay amount qtx3 of the third transmission signal.

The address generation unit 11 generates the following addresses A₁₁ to A₁₆ for the first transmission signal. In other words, the address generation unit 11 generates an address A_{11,q11} = |x₁(n-q11)|² of the first transmission signal, an address A_{14,q13} = |x₂(n-q13)|² of the second transmission signal, and an address A_{15,q14} = |x₃(n-q14)|² of the third transmission signal. The address generation unit 11 also generates an address A_{12,q11,q13} = |x₁(n-q11)|² + |x₂(n-q13)|² of the composite power of the first and second transmission signals. The address generation unit 11 also generates an address A_{13,q11,q14} = |x₁(n-q11)|² + |x₃(n-q14)|² of the composite power of the first and third transmission signals. The address generation unit 11 also generates an address A_{16,q13,q14} = |x₂(n-q13)|² + |x₃(n-q14)|² of the composite power of the second and third transmission signals.

The address generation unit 11 generates the following addresses A₂₁ to A₂₆ for the second transmission signal. In other words, the address generation unit 11 generates an address A_{21,q21} = |x₂(n-q21)|² of the second transmission signal, an address A_{24,q23} = |x₁(n-q23)|² of the first transmission signal, and an address A_{25,q24} = |x₃(n-q24)|² of the third transmission signal. The address generation unit 11 also generates an address A_{22,q21,q23} = |x₁(n-q23)|² + |x₂(n-q21)|² of the composite power of the first and second transmission signals. The address generation unit 11 also generates an address A_{23,q21,q24} = |x₂(n-q21)|² + |x₃(n-q24)|² of the composite power of the second and third transmission signals. The address generation unit 11 also generates an address A_{26,q23,q24} = |x₁(n-q23)|² + |x₃(n-q24)|² of the composite power of the first and third transmission signals.

The address generation unit 11 generates the following addresses A₃₁ to A₃₆ for the third transmission signal. In other words, the address generation unit 11 generates an address A_{31,q31} = |x₃(n-q31)|² of the third transmission signal, an address A_{34,q33} = |x₁(n-q33)|² of the first transmission signal, and an address A_{35,q34} = |x₂(n-q34)|² of the second transmission signal. The address generation unit 11 also generates an address A_{32,q31,q33} = |x₁(n-q33)|² + |x₃(n-q31)|² of the composite power of the first and third transmission signals. The address generation unit 11 also generates an address A_{33,q31,q34} = |x₂(n-q34)|² + |x₃(n-q31)|² of the composite power of the second and third transmission signals. The address generation unit 11 also generates an address A_{36,q33,q34} = |x₁(n-q33)|² + |x₂(n-q34)|² of the composite power of the first and second transmission signals.

The LUT 411 outputs LUT_{1,1,q11,q12,q13,q14}(A_{11,q11}) for input of the address A_{11,q11}. The LUT 412 outputs LUT_{1,2,q11,q12,q13,q14}(A_{12,q11,q13}) for input of the address A_{12,q11,q13}. The LUT 413 outputs LUT_{1,3,q11,q12,q13,q14}(A_{13,q11,q14}) for input of the address A_{13,q11,q14}. The LUT 414 outputs LUT_{1,4,q11,q12,q13,q14}(A_{14,q13}) for input of the address A_{14,q13}. The LUT 415 outputs LUT_{1,5,q11,q12,q13,q14}(A_{15,q14}) for input of the address A_{15,q14}. The LUT 416 outputs LUT_{1,6,q11,q12,q13,q14}(A_{16,q13,q14}) for input of the address A16, q13, q14 .

The LUT 421 outputs LUT_{2,1,q21,q22,q23,q24}(A_{21,q21}) for input of the address A_{21,q21}. The LUT 422 outputs LUT_{2,2,q21,q22,q23,q24}(A_{22,q21,q23}) for input of the address A_{22,q21,q23}. The LUT 423 outputs LUT_{2,3,q21,q22,q23,q24}(A_{23,q21,q24}) for input of the address A_{23,q21,q24}. The LUT 424 outputs LUT_{2,4,q21,q22,q23,q24}(A_{24,q23}) for input of the address A_{24,q23}. The LUT 425 outputs LUT_{2,5,q21,q22,q23,q24}(A_{25,q24}) for input of the address A_{25,q24}. The LUT 426 outputs LUT_{2,6,q21,q22,q23,q24}(A_{26,q23,q24}) for input of the address A_{26,q23,q24}.

The LUT 431 outputs LUT_{3,1,q31,q32,q33,q34}(A_{31,q31}) for input of the address A_{31,q31}. The LUT 432 outputs LUT_{3,2,q31,q32,q33,q34}(A_{32,q31,q33}) for input of the address A_{32,q31,q33}. The LUT 433 outputs LUT_{3,3,q31,q32,q33,q34}(A_{33,q31,q34}) for input of the address A_{33,q31,q34}. The LUT 434 outputs LUT_{3,4,q31,q32,q33,q34}(A_{34,q33}) for input of the address A_{34,q33}. The LUT 435 outputs LUT_{3,5,q31,q32,q33,q34}(A_{35,q34}) for input of the address A_{35,q34}. The LUT 436 outputs LUT_{3,6,q31,q32,q33,q34}(A_{36,q33,q34}) for input of the address A_{36,q33,q34}.

The adder 127 calculates a distortion compensation coefficient LUT_{SUM-1,q12} of the first transmission signal according to the following equation (16). Here, the radio equipment 1 varies q11 from -Q_{1,1} to +Q_{1,1}, q13 from -Q_{1,3} to +Q_{1,3}, and q14 from -Q_{1,4} to +Q_{1,4}.${LUT}_{SUM - 1 , {q}_{12}} = {\sum }_{{q}_{11} = - {Q}_{1 , 1}}^{+ {Q}_{1 , 1}} {\sum }_{{q}_{13} = - {Q}_{1 , 3}}^{+ {Q}_{1 , 3}} {\sum }_{{q}_{14} = - {Q}_{1 , 4}}^{+ {Q}_{1 , 4}} \left\{\begin{matrix}{LUT}_{1 , 1 , {q}_{11} , {q}_{12} , {q}_{13} , {q}_{14}} \left[{A}_{11 , {q}_{11}}\right] \\ + {LUT}_{1 , 2 , {q}_{11} , {q}_{12} , {q}_{13} , {q}_{14}} \left[{A}_{12 , {q}_{11} , {q}_{13}}\right] + {LUT}_{1 , 3 , {q}_{11} , {q}_{12} , {q}_{13} , {q}_{14}} \left[{A}_{13 , {q}_{11} , {q}_{14}}\right] \\ + {LUT}_{1 , 4 , {q}_{11} , {q}_{12} , {q}_{13} , {q}_{14}} \left[{A}_{14 , {q}_{13}}\right] + {LUT}_{1 , 5 , {q}_{11} , {q}_{12} , {q}_{13} , {q}_{14}} \left[{A}_{15 , {q}_{14}}\right] \\ + {LUT}_{1 , 6 , {q}_{11} , {q}_{12} , {q}_{13} , {q}_{14}} \left[{A}_{16 , {q}_{13} , {q}_{14}}\right]\end{matrix}\right\}$

The adder 128 calculates a distortion compensation coefficient LUT_{SUM-2,q22} of the second transmission signal according to the following equation (17). Here, the radio equipment 1 varies q21 from -Q_{2,1} to +Q_{2,1}, q23 from -Q_{2,3} to +Q_{2,3}, and q24 from -Q_{2,4} to +Q_{2,4}.${LUT}_{SUM - 2 , {q}_{22}} = {\sum }_{{q}_{21} = - {Q}_{2 , 1}}^{+ {Q}_{2 , 1}} {\sum }_{{q}_{23} = - {Q}_{2 , 3}}^{+ {Q}_{2 , 3}} {\sum }_{{q}_{24} = - {Q}_{2 , 4}}^{+ {Q}_{2 , 4}} \left\{\begin{matrix}{LUT}_{2 , 1 , {q}_{21} , {q}_{22} , {q}_{23} , {q}_{24}} \left[{A}_{21 , {q}_{21}}\right] \\ + {LUT}_{2 , 2 , {q}_{21} , {q}_{22} , {q}_{23} , {q}_{24}} \left[{A}_{22 , {q}_{21} , {q}_{23}}\right] + {LUT}_{2 , 3 , {q}_{21} , {q}_{22} , {q}_{23} , {q}_{24}} \left[{A}_{23 , {q}_{21} , {q}_{24}}\right] \\ + {LUT}_{2 , 4 , {q}_{21} , {q}_{22} , {q}_{23} , {q}_{24}} \left[{A}_{24 , {q}_{23}}\right] + {LUT}_{2 , 5 , {q}_{21} , {q}_{22} , {q}_{23} , {q}_{24}} \left[{A}_{25 , {q}_{24}}\right] \\ + {LUT}_{2 , 6 , {q}_{21} , {q}_{22} , {q}_{23} , {q}_{24}} \left[{A}_{26 , {q}_{23} , {q}_{24}}\right]\end{matrix}\right\}$

The adder 129 calculates a distortion compensation coefficient LUT_{SUM-3,q32} of the third transmission signal according to the following equation (18). Here, the radio equipment 1 varies q31 from -Q_{3,1} to +Q_{3,1}, q33 from -Q_{3,3} to +Q_{3,3}, and q34 from -Q_{3,4} to +Q_{3,4}.${LUT}_{SUM - 3 , {q}_{32}} = {\sum }_{{q}_{31} = - {Q}_{3 , 1}}^{+ {Q}_{3 , 1}} {\sum }_{{q}_{33} = - {Q}_{3 , 3}}^{+ {Q}_{3 , 3}} {\sum }_{{q}_{34} = - {Q}_{3 , 4}}^{+ {Q}_{3 , 4}} \left\{\begin{matrix}{LUT}_{3 , 1 , {q}_{31} , {q}_{32} , {q}_{33} , {q}_{34}} \left[{A}_{31 , {q}_{31}}\right] \\ + {LUT}_{3 , 2 , {q}_{31} , {q}_{32} , {q}_{33} , {q}_{34}} \left[{A}_{32 , {q}_{31} , {q}_{33}}\right] + {LUT}_{3 , 3 , {q}_{31} , {q}_{32} , {q}_{33} , {q}_{34}} \left[{A}_{33 , {q}_{31} , {q}_{34}}\right] \\ + {LUT}_{3 , 4 , {q}_{31} , {q}_{32} , {q}_{33} , {q}_{34}} \left[{A}_{34 , {q}_{33}}\right] + {LUT}_{3 , 5 , {q}_{31} , {q}_{32} , {q}_{33} , {q}_{34}} \left[{A}_{35 , {q}_{34}}\right] \\ + {LUT}_{3 , 6 , {q}_{31} , {q}_{32} , {q}_{33} , {q}_{34}} \left[{A}_{36 , {q}_{33} , {q}_{34}}\right]\end{matrix}\right\}$

The multiplier 131 multiplies x₁(n-q12) output from the delay addition unit 134 and LUT_{SUM-1,q12} output from the distortion compensation coefficient calculation unit 12 and outputs a pre-distortion signal expressed by the above equation (13). Here, the radio equipment 1 varies q12 from -Q_{1,2} to +Q_{1,2}.

The multiplier 132 multiplies x₂(n-q22) output from the delay addition unit 135 and LUT_{SUM-2,q22} output from the distortion compensation coefficient calculation unit 12 and outputs a pre-distortion signal expressed by the above equation (14). Here, the radio equipment 1 varies q22 from -Q_{2,2} to +Q_{2,2}.

The multiplier 133 multiplies x₃(n-q32) output from the delay addition unit 136 and LUT_{SUM-3,q32} output from the distortion compensation coefficient calculation unit 12 and outputs a pre-distortion signal expressed by the above equation (15). Here, the radio equipment 1 varies q32 from -Q_{3,2} to +Q_{3,2}.

Next, a case in combination with the third example in the second embodiment will be described. In this case, LUT_{1,1,q11,q12,q13,q14}(A_{11,q11}) in the case in combination with the second example in the second embodiment becomes LUT_{1,1,q11,q12}(A_{11,q11}), which does not include q13 and q14 as variables. LUT_{1,2,q11,q12,q13,q14}(A_{12,q11,q13}) becomes LUT_{1,2,q11,q12,q13}(A_{12,q11,q13}), which does not include q14 as a variable. LUT_{1,3,q11,q12,q13,q14}(A_{13,q11,q14}) becomes LUT_{1,3,q11,q12,q14}(A_{13,q11,q14}), which does not include q13 as a variable. LUT_{1,4,q11,q12,q13,q14}(A_{14,q13}) becomes LUT_{1,4,q12,q13}(A_{14,q13}), which does not include q11 and q14 as variables. LUT_{1,5,q11,q12,q13,q14}(A_{15,q14}) becomes LUT_{1,4,q12,q14}(A_{15,q14}), which does not include q11 and q13 as variables. LUT_{1,6,q11,q12,q13,q14}(A_{16,q13,q14}) becomes LUT_{1,6,q12,q13,q14}(A_{16,q13,q14}), which does not include q11 as a variable.

LUT_{2,1,q21,q22,q23,q24}(A_{21,q21}) becomes LUT_{2,1,q21,q22}(A_{21,q21}), which does not include q23 and q24 as variables. LUT_{2,2,q21,q22,q23,q24}(A_{22,q21,q23}) becomes LUT_{2,2,q21,q22,q23}(A_{22,q21,q23}), which does not include q24 as a variable. LUT_{2,3,q21,q22,q23,q24}(A_{23,q21,q24}) becomes LUT_{2,3,q21,q22,q24}(A_{23,q21,q24}), which does not include q23 as a variable. LUT_{2,4,q21,q22,q23,q24}(A_{24,q23}) becomes LUT_{2,4,q22,q23}(A_{24,q23}), which does not include q21 and q24 as variables. LUT_{2,5,q21,q22,q23,q24}(A_{25,q24}) becomes LUT_{2,5,q22,q24}(A_{25,q24}), which does not include q21 and q23 as variables. LUT_{2,6,q21,q22,q23,q24}(A_{26,q23,q24}) becomes LUT_{2,6,q22,q23,q24}(A_{26,q23,q24}), which does not include q21 as a variable.

LUT_{3,1,q31,q32,q33,q34}(A_{31,q31}) becomes LUT_{3,1,q31, q32}(A_{31,q31}), which does not include q33 and q34 as variables. LUT_{3,2,q31,q32,q33,q34}(A_{32,q31,q33}) becomes LUT_{3,2,q31,q32,q33}(A_{32,q31,q33}), which does not include q34 as a variable. LUT_{3,3,q31,q32,q33,q34}(A_{33,q31,q34}) becomes LUT_{3,3,q31,q32,q34}(A_{33,q31,q34}), which does not include q33 as a variable. LUT_{3,4,q31,q32,q33,q34}(A_{34,q33}) becomes LUT_{3,4,q32,q33}(A_{34,q33}), which does not include q31 and q34 as variables. LUT_{3,5,q31,q32,q33,q34}(A_{35,q34}) becomes LUT_{3,5,q32,q34}(A_{35,q34}), which does not include q31 and q33 as variables. LUT_{3,6,q31,q32,q33,q34}(A_{36,q33,q34}) becomes LUT_{3,6,q32,q33,q34}(A_{36,q33,q34}), which does not include q31 as a variable.

The adder 127 calculates a distortion compensation coefficient LUT_{SUM-1,q12} of the first transmission signal according to the following equation (19). Here, the radio equipment 1 varies q11 from -Q_{1,1} to +Q_{1,1}, q13 from -Q_{1,3} to +Q_{1,3}, and q14 from -Q_{1,4} to +Q_{1,4}. $\begin{matrix}{LUT}_{SUM - 1 , {q}_{12}} = {\sum }_{{q}_{11} = - {Q}_{1 , 1}}^{+ {Q}_{1 , 1}} \left\{{LUT}_{1 , 1 , {q}_{11} , {q}_{12}}\left[{A}_{11 , {q}_{11}}\right]\right\} + {\sum }_{{q}_{11} = - {Q}_{1 , 1}}^{+ {Q}_{1 , 1}} {\sum }_{{q}_{13} = - {Q}_{1 , 3}}^{+ {Q}_{1 , 3}} \left\{{LUT}_{1 , 2 , {q}_{11} , {q}_{12} , {q}_{13}}\left[{A}_{12 , {q}_{11} , {q}_{13}}\right]\right\} \\ + {\sum }_{{q}_{11} = - {Q}_{1 , 1}}^{+ {Q}_{1 , 1}} {\sum }_{{q}_{14} = - {Q}_{1 , 4}}^{+ {Q}_{1 , 4}} \left\{{LUT}_{1 , 3 , {q}_{11} , {q}_{12} , {q}_{14}}\left[{A}_{13 , {q}_{11} , {q}_{14}}\right]\right\} + {\sum }_{{q}_{13} = - {Q}_{1 , 3}}^{+ {Q}_{1 , 3}} \left\{{LUT}_{1 , 4 , {q}_{12} , {q}_{13}}\left[{A}_{14 , {q}_{13}}\right]\right\} \\ + {\sum }_{{q}_{14} = - {Q}_{1 , 4}}^{+ {Q}_{1 , 4}} \left\{{LUT}_{1 , 5 , {q}_{12} , {q}_{14}}\left[{A}_{15 , {q}_{14}}\right]\right\} + {\sum }_{{q}_{13} = - {Q}_{1 , 3}}^{+ {Q}_{1 , 3}} {\sum }_{{q}_{14} = - {Q}_{1 , 4}}^{+ {Q}_{1 , 4}} \left\{{LUT}_{1 , 6 , {q}_{12} , {q}_{13} , {q}_{14}}\left[{A}_{16 , {q}_{12} , {q}_{14}}\right]\right\}\end{matrix}$

The adder 128 calculates a distortion compensation coefficient LUT_{SUM-2,q22} of the second transmission signal according to the following equation (20). Here, the radio equipment 1 varies q21 from -Q_{2,1} to +Q_{2,1}, q23 from -Q_{2,3} to +Q_{2,3}, and q24 from -Q_{2,4} to +Q_{2,4}.$\begin{matrix}{LUT}_{SUM - 2 , {q}_{22}} = {\sum }_{{q}_{21} = - {Q}_{2 , 1}}^{+ {Q}_{2 , 1}} \left\{{LUT}_{2 , 1 , {q}_{21} , {q}_{22}}\left[{A}_{21 , {q}_{21}}\right]\right\} + {\sum }_{{q}_{21} = - {Q}_{2 , 1}}^{+ {Q}_{2 , 1}} {\sum }_{{q}_{23} = - {Q}_{2 , 3}}^{+ {Q}_{2 , 3}} \left\{{LUT}_{2 , 2 , {q}_{21} , {q}_{22} , {q}_{23}}\left[{A}_{22 , {q}_{21} , {q}_{23}}\right]\right\} \\ + {\sum }_{{q}_{21} = - {Q}_{2 , 1}}^{+ {Q}_{2 , 1}} {\sum }_{{q}_{24} = - {Q}_{2 , 4}}^{+ {Q}_{2 , 4}} \left\{{LUT}_{2 , 3 , {q}_{21} , {q}_{22} , {q}_{24}}\left[{A}_{23 , {q}_{21} , {q}_{24}}\right]\right\} + {\sum }_{{q}_{23} = - {Q}_{2 , 3}}^{+ {Q}_{2 , 3}} \left\{{LUT}_{2 , 4 , {q}_{22} , {q}_{23}}\left[{A}_{24 , {q}_{23}}\right]\right\} \\ + {\sum }_{{q}_{24} = - {Q}_{2 , 4}}^{+ {Q}_{2 , 4}} \left\{{LUT}_{2 , 5 , {q}_{22} , {q}_{24}}\left[{A}_{25 , {q}_{24}}\right]\right\} + {\sum }_{{q}_{23} = - {Q}_{2 , 3}}^{+ {Q}_{2 , 3}} {\sum }_{{q}_{24} = - {Q}_{2 , 4}}^{+ {Q}_{2 , 4}} \left\{{LUT}_{2 , 6 , {q}_{22} , {q}_{23} , {q}_{24}}\left[{A}_{26 , {q}_{22} , {q}_{24}}\right]\right\}\end{matrix}$

The adder 129 calculates a distortion compensation coefficient LUT_{SUM-3,q32} of the third transmission signal according to the following equation (21). Here, the radio equipment 1 varies q31 from -Q_{3,1} to +Q_{3,1}, q33 from -Q_{3,3} to +Q_{3,3}, and q34 from -Q_{3,4} to +Q_{3,4}. $\begin{matrix}{LUT}_{SUM - 3 , {q}_{32}} = {\sum }_{{q}_{31} = - {Q}_{3 , 1}}^{+ {Q}_{3 , 1}} \left\{{LUT}_{3 , 1 , {q}_{31} , {q}_{32}}\left[{A}_{31 , {q}_{31}}\right]\right\} + {\sum }_{{q}_{31} = - {Q}_{3 , 1}}^{+ {Q}_{3 , 1}} {\sum }_{{q}_{33} = - {Q}_{3 , 3}}^{+ {Q}_{3 , 3}} \left\{{LUT}_{3 , 2 , {q}_{31} , {q}_{32} , {q}_{33}}\left[{A}_{32 , {q}_{31} , {q}_{33}}\right]\right\} \\ + {\sum }_{{q}_{31} = - {Q}_{3 , 1}}^{+ {Q}_{3 , 1}} {\sum }_{{q}_{34} = - {Q}_{3 , 4}}^{+ {Q}_{3 , 4}} \left\{{LUT}_{3 , 3 , {q}_{31} , {q}_{32} , {q}_{34}}\left[{A}_{33 , {q}_{31} , {q}_{34}}\right]\right\} + {\sum }_{{q}_{33} = - {Q}_{3 , 3}}^{+ {Q}_{3 , 3}} \left\{{LUT}_{3 , 4 , {q}_{32} , {q}_{33}}\left[{A}_{34 , {q}_{33}}\right]\right\} \\ + {\sum }_{{q}_{34} = - {Q}_{3 , 4}}^{+ {Q}_{3 , 4}} \left\{{LUT}_{3 , 5 , {q}_{32} , {q}_{34}}\left[{A}_{35 , {q}_{34}}\right]\right\} + {\sum }_{{q}_{33} = - {Q}_{3 , 3}}^{+ {Q}_{3 , 3}} {\sum }_{{q}_{34} = - {Q}_{3 , 4}}^{+ {Q}_{3 , 4}} \left\{{LUT}_{3 , 6 , {q}_{32} , {q}_{33} , {q}_{34}}\left[{A}_{36 , {q}_{32} , {q}_{34}}\right]\right\}\end{matrix}$

The multiplier 131 multiplies x₁(n-q12) output from the delay addition unit 134 and LUT_{SUM-1,q12} output from the distortion compensation coefficient calculation unit 12 and outputs a pre-distortion signal expressed by the above equation (13). Here, the radio equipment 1 varies q12 from -Q_{1,2} to +Q_{1,2}.

The multiplier 132 multiplies x₂(n-q22) output from the delay addition unit 135 and LUT_{SUM-2,q22} output from the distortion compensation coefficient calculation unit 12 and outputs a pre-distortion signal expressed by the above equation (14). Here, the radio equipment 1 varies q22 from -Q_{2,2} to +Q_{2,2}.

The multiplier 133 multiplies x₃(n-q32) output from the delay addition unit 136 and LUT_{SUM-3,q32} output from the distortion compensation coefficient calculation unit 12 and outputs a pre-distortion signal expressed by the above equation (15). Here, the radio equipment 1 varies q32 from -Q_{3,2} to +Q_{3,2}.

### Modification 7-2

Modification 7-2 of the seventh embodiment will now be described. The configuration according to the seventh embodiment can be combined with the configuration in the fourth embodiment. In other words, the radio equipment 1 adaptively updates a distortion compensation coefficient using a feedback signal that feeds back a portion of the amplifier output signal. For example, an example in combination with the first to third examples of the second embodiment will be described below. In this case, the radio equipment 1 includes the feedback unit 20 and the coefficient updating unit 30.

For example, let y₁(n) be the feedback signal corresponding to the first transmission signal x₁(n). Let y₂(n) be the feedback signal corresponding to the second transmission signal x₂(n). Let y₃(n) be the feedback signal corresponding to the third transmission signal x₃(n). The calculation of the distortion compensation coefficients by the coefficient updating unit 30 in this case will be described. The addresses input to the LUTs 411 to 416 are A₁₁ to A₁₆, respectively, the addresses input to the LUTs 421 to 426 are A₂₁ to A₂₆, respectively, and the addresses input to the LUTs 431 to 436 are A₃₁ to A₃₆, respectively.

For example, the coefficient updating unit 30 calculates a new distortion compensation coefficient LUT_{1,1}(A₁₁) of the LUT 411 as LUT_{1,1}(A₁₁) = LUT_{1,1}(A₁₁) + µ·e₁(n)·(y₁(n))*. The coefficient updating unit 30 calculates a new distortion compensation coefficient LUT_{1,2}(A₁₂) of the LUT 412 as LUT_{1,2}(A₁₂) = LUT_{1,2}(A₁₂) + µ·e₁(n)·(y₁(n))*. The coefficient updating unit 30 calculates a new distortion compensation coefficient LUT_{1,3}(A₁₃) of the LUT 413 as LUT_{1,3}(A₁₃) = LUT_{1,3}(A₁₃) + µ·e₁(n)·(y₁(n))*. The coefficient updating unit 30 calculates a new distortion compensation coefficient LUT_{1,4}(A₁₄) of the LUT 414 as LUT_{1,4}(A₁₄) = LUT_{1,4}(A₁₄) + µ·e₁(n)·(y₁(n))*. The coefficient updating unit 30 calculates a new distortion compensation coefficient LUT_{1,5}(A₁₅) of the LUT 415 as LUT_{1,5}(A₁₅) = LUT_{1,5}(A₁₅) + µ·e₁(n) ·(y₁(n))*. The coefficient updating unit 30 calculates a new distortion compensation coefficient LUT_{1,6}(A₁₆) of the LUT 416 as LUT_{1,6}(A₁₆)= LUT_{1,6}(A₁₆) + µ·e₁(n)·(y₁(n))*.

For example, the coefficient updating unit 30 calculates a new distortion compensation coefficient LUT_{2,1}(A₂₁) of the LUT 421 as LUT_{2,1}(A₂₁) = LUT_{2,1}(A₂₁) + µ·e₂(n)·(y₂(n))*. The coefficient updating unit 30 calculates a new distortion compensation coefficient LUT_{2,2}(A₂₂) of the LUT 422 as LUT_{2,2}(A₂₂) = LUT_{2,2}(A₂₂) + µ·e₂(n)·(y₂(n))*. The coefficient updating unit 30 calculates a new distortion compensation coefficient LUT_{2,3}(A₂₃) of the LUT 423 as LUT_{2,3}(A₂₃) = LUT_{2,3}(A₂₃) + µ·e₂(n)·(y₂(n))*. The coefficient updating unit 30 calculates a new distortion compensation coefficient LUT_{2,4}(A₂₄) of the LUT 424 as LUT_{2,4}(A₂₄) = LUT_{2,4}(A₂₄) + µ·e₂(n)·(y₂(n))*. The coefficient updating unit 30 calculates a new distortion compensation coefficient LUT_{2,5}(A₂₅) of the LUT 425 as LUT_{2,5}(A₂₅) = LUT_{2,5}(A₂₅) + µ·e₂(n)·(y₂(n))*. The coefficient updating unit 30 calculates a new distortion compensation coefficient LUT_{2,6}(A₂₆) of the LUT 426 as LUT_{2,6}(A₂₆) = LUT_{2,6}(A₂₆) + µ·e₂(n)·(y₂(n))*.

For example, the coefficient updating unit 30 calculates a new distortion compensation coefficient LUT_{3,1}(A₃₁) of the LUT 431 as LUT_{3,1}(A₃₁) = LUT_{3,1}(A₃₁) + µ·e₃(n)·(y₃(n))*. The coefficient updating unit 30 calculates a new distortion compensation coefficient LUT_{3,2}(A₃₂) of the LUT 432 as LUT_{3,2}(A₃₂) = LUT_{3,2}(A₃₂) + µ·e₃(n)·(y₃(n))*. The coefficient updating unit 30 calculates a new distortion compensation coefficient LUT_{3,3}(A₃₃) of the LUT 433 as LUT_{3,3}(A₃₃) = LUT_{3,3}(A₃₃) + µ·e₃(n)·(y₃(n))*. The coefficient updating unit 30 calculates a new distortion compensation coefficient LUT_{3,4}(A₃₄) of the LUT 434 as LUT_{3,4}(A₃₄) = LUT_{3,4}(A₃₄) + µ·e₃(n)·(y₃(n))*. The coefficient updating unit 30 calculates a new distortion compensation coefficient LUT_{3,5}(A₃₅) of the LUT 435 as LUT_{3,5}(A₃₅) = LUT_{3,5}(A₃₅) + µ·e₃(n)·(y₃(n))*. The coefficient updating unit 30 calculates a new distortion compensation coefficient LUT_{3,6}(A₃₆)of the LUT 436 as LUT_{3,6}(A₃₆)= LUT_{3,6}(A₃₆)+ µ·e₃(n)·(y₃(n))*.

Furthermore, in addition to compensating for the memory effect, the radio equipment 1 may adaptively update a distortion compensation coefficient using a feedback signal that feeds back a portion of the amplifier output signal.

For example, a combination with the case in combination with the first example in the second embodiment in modification 7-1 described above will be described. In this case, the coefficient updating unit 30 updates each distortion compensation coefficient as follows. 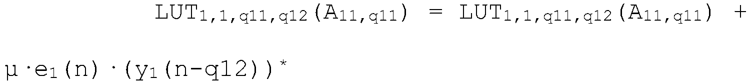 LUT1,1,q11,q12(A11,q11) = LUT1,1,q11,q12 (A11,q11) + µ·e1(n)·(y1(n-q12))* 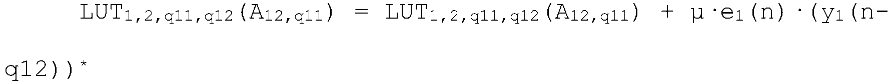 LUT1,2,q11,q12(A12,q11) = LUT1,2,q11,q12(A12,q11) + µ·e1(n)·(y1(n-q12))* 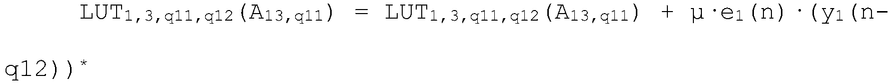 LUT1,3,q11,q12(A13,q11) = LUT1,3,q11,q12(A13,q11) + µ·e1(n)·(y1(n-q12))* 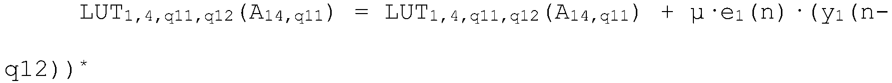 LUT1,4,q11,q12(A14,q11) = LUT1,4,q11,q12(A14,q11) + µ·e1(n)·(y1(n-q12))* 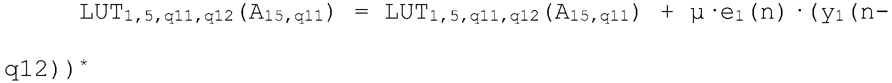 LUT1,5,q11,q12(A15,q11) = LUT1,5,q11,q12(A15,q11) + µ·e1(n)·(y1(n-q12))* 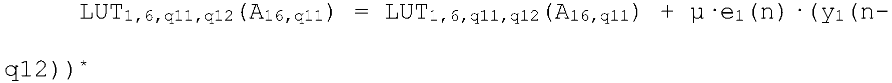 LUT1,6,q11,q12(A16,q11) = LUT1,6,q11,q12(A16,q11) + µ·e1(n)·(y1(n-q12))* 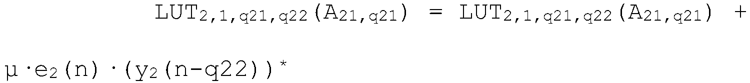 LUT2,1,q21,q22(A21,q21) = LUT2,1,q21,q22(A21,q21) + µ·e2(n)·(y2(n-q22))* 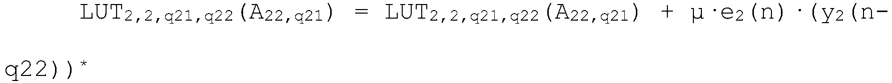 LUT2,2,q21,q22(A22,q21) = LUT2,2,q21,q22(A22,q21) + µ·e2(n)·(y2(n-q22))* 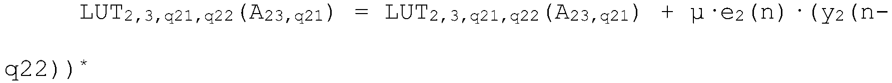 LUT2,3,q21,q22(A23,q21) = LUT2,3,q21,q22(A23,q21) + µ·e2(n)·(y2(n-q22))* 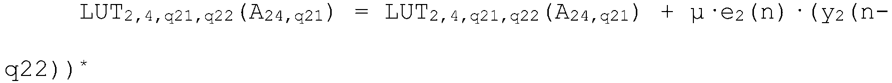 LUT2,4,q21,q22(A24,q21) = LUT2,4,q21,q22(R24,q21) + µ·e2(n)·(y2(n-q22))* 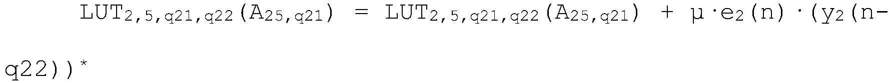 LUT2,5,q21,q22(A25,q21) = LUT2,5,q21,q22(A25,q21) + µ·e2(n)·(y2(n-q22))* 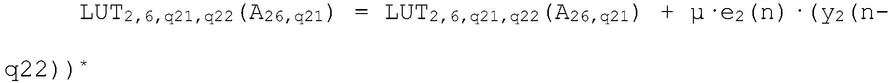 LUT2,6,q21,q22(A26,q21) = LUT2,6,q21,q22(A26,q21) + µ·e2(n)·(y2(n-q22))* 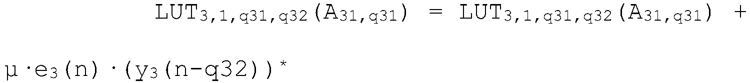 LUT3,1,q31,q32(A31,q31) = LUT3,1,q31,q32 (A31,q31) + µ·e3(n)·(y3(n-q32))* 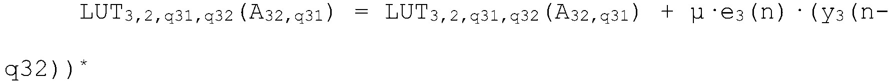 LUT3,2,q31,q32(A32,q31) = LUT3,2,q31,q32(A32,q31) + µ·e3(n)·(y3(n-q32))* 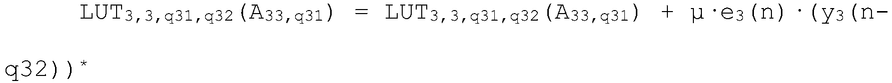 LUT3,3,q31,q32(A33,q31) = LUT3,3,q31,q32(A33,q31) + µ·e3(n)·(y3(n-q32))* 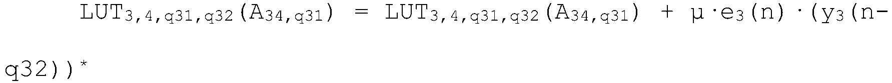 LUT3,4,q31,q32(A34,q31) = LUT3,4,q31,q32(A34,q31) + µ·e3(n)·(y3(n-q32))* 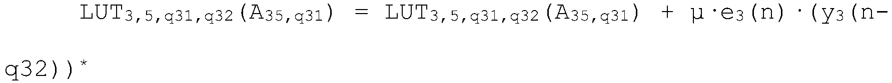 LUT3,5,q31,q32(A35,q31) = LUT3,5,q31,q32(A35,q31) + µ·e3(n)·(y3(n-q32))* 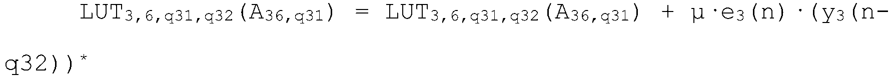 LUT3,6,q31,q32(A36,q31) = LUT3,6,q31,q32(A36,q31) + µ·e3(n)·(y3(n- q32))*

A combination with the case in combination with the second example in the second embodiment in modification 7-1 described above will be described. In this case, the coefficient updating unit 30 updates each distortion compensation coefficient as follows. 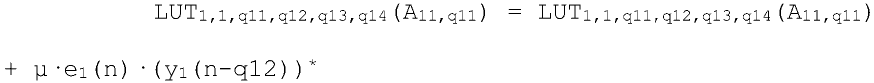 LUT1,1,q11,q12,q13,q14(A11,q11) = LUT1,1,q11,q12,q13,q14(A11,q11) + µ·e1(n) ·e1(n) · (y1(n-q12))* 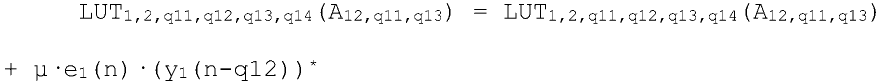 LUT1,2,q11,q12,q13,q14(A12,q11,q13) = LUT1,2,q11,q12,q13,q14(A12,q11,q13) + µ·e1(n) · (y1(n-q12))* 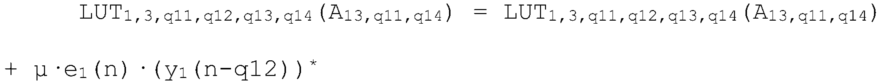 LUT1,3,q11,q12,q13,q14(A13,q11,q14) = LUT1,3,q11,q12,q13,q14(A13,q11,q14) + µ·e1(n) · (y1(n-q12))* 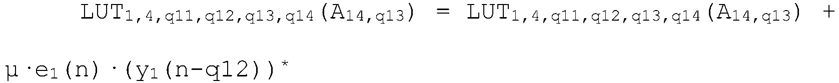 LUT1,4,q11,q12,q13,q14(A14,q13) = LUT1,4,q11,q12,q13,q14(A14,q13) + µ·e1(n) · (y1(n-q12))* 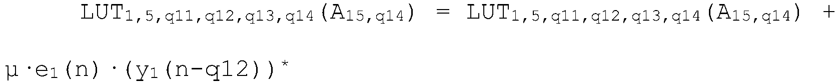 LUT1,5,q11,q12,q13,q14(A15,q14) = LUT1,5,q11,q12,q13,q14(A15,q14) + µ·e1(n) · (y1(n-q12))* 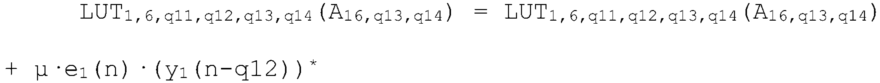 LUT1,6,q11,q12,q13,q14(A16,q13,q14) = LUT1,6,q11,q12,q13,q14(A16,q13,q14) + µ·e1(n) · (y1(n-q12))* 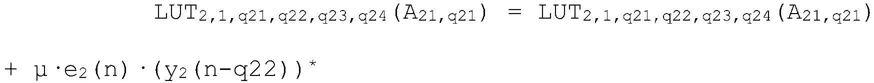 LUT2,1,q21,q22,q23,q24(A21,q21) = LUT2,1,q21,q22,q23,q24(A21,q21) + µ·e2(n) · (y2(n-q22))* 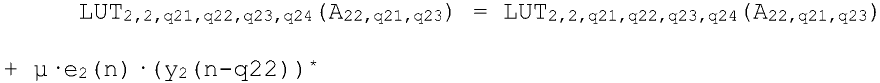 UT2,2,q21,q22,q23,q24(A22,q21,q23) = LUT2,2,q21,q22,q23,q24(A22,q21,q23) + µ·e2(n) · (y2(n-q22))* 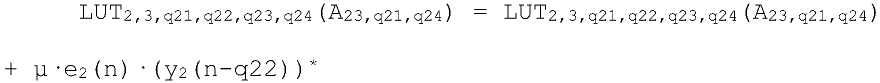 LUT2,3,q21,q22,q23,q24(A23,q21,q24) = LUT2,3,q21,q22,q23,q24(A23,q21,q24) + µ·e2(n) · (y2(n-q22))* 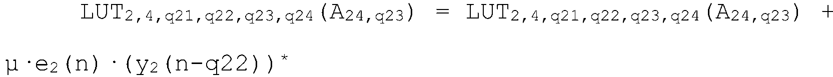 LUT2,4,q21,q22,q23,q24(A24,q23) = LUT2,4,q21,q22,q23,q24(A24,q23) + µ·e2(n) · (y2(n-q22))* 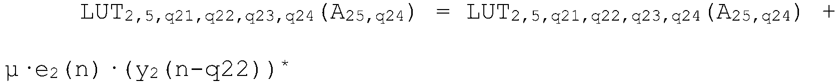 LUT2,5,q21,q22,q23,q24(A25,q24) = LUT2,5,q21,q22,q23,q24(A25,q24) + µ·e2(n) · (y2(n-q22))* 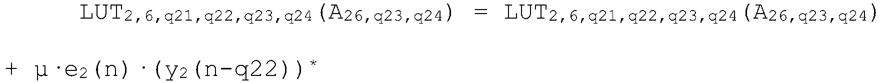 LUT2,6,q21,q22,q23,q24(A26,q23,q24) = LUT2,6,q21,q22,q23,q24(A26,q23,q24) + µ·e2(n) · (y2(n-q22))* 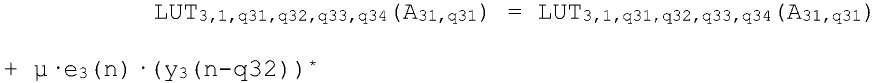 LUT3,1,q31,q32,q33,q34(A31,q31) = LUT3,1,q31,q32,q33,q34(A31,q31) + µ·e3(n) · (y3(n-q32))* 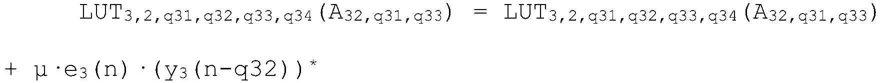 LUT3,2,q31,q32,q33,q34(A32,q31,q33) = LUT3,2,q31,q32,q33,q34(A32,q31,q33) + µ·e3(n) · (y3(n-q32))* 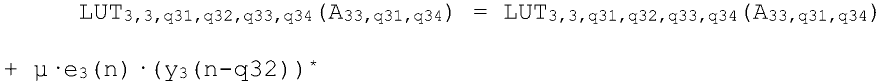 LUT3,3,q31,q32,q33,q34(A33,q31,q34) = LUT3,3,q31,q32,q33,q34(A33,q31,q34) + µ·e3(n) · (y3(n-q32))* 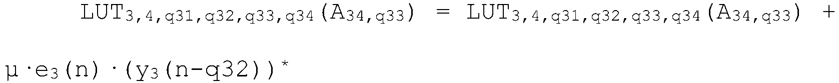 LUT3,4,q31,q32,q33,q34(A34,q33) = LUT3,4,q31,q32,q33,q34(A34,q33)+ µ·e3(n) · (y3(n-q32))* 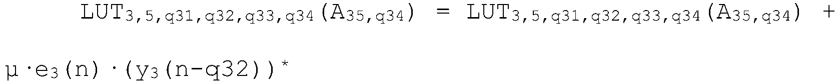 LUT3,5,q31,q32,q33,q34(A35,q34) = LUT3,5,q31,q32,q33,q34(A35,q34)+ µ·e3(n) · (y3(n-q32))* 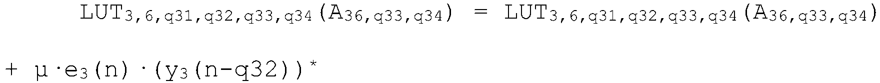 LUT3,6,q31,q32,q33,q34(A36,q33,q34) = LUT3,6,q31,q32,q33,q34(A36,q33,q34) + µ·e3(n) · (y3(n-q32))*

A combination with the case in combination with the third example in the second embodiment in modification 7-1 described above will be described. In this case, the coefficient updating unit 30 updates each distortion compensation coefficient as follows. 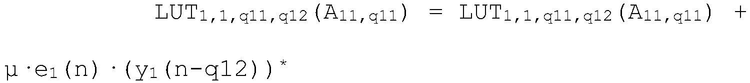 LUT1,1,q11,q12(A11,q11) = LUT1,1,q11,q12(A11,q11) + µ·e1(n) · (y1(n-q12))* 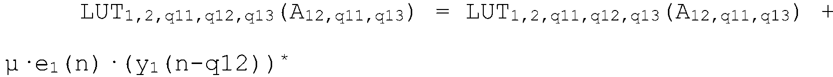 LUT1,2,q11,q12,q13(A12,q11,q13) = LUT1,2,q11,q12,q13(A12,q11,q13)+ µ·e1(n) · (y1(n-q12))* 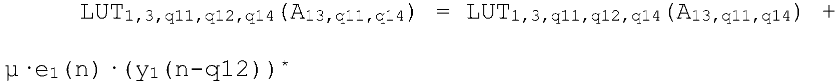 UT1,3,q11,q12,q14(A13,q11,q14) = LUT1,3,q11,q12,q14(A13,q11,q14) + µ·e1(n) · (y1(n-q12))* 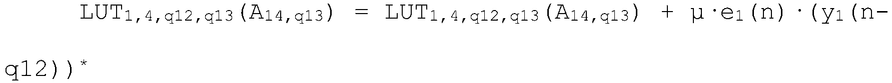 LUT1,4,q12,q13(A14,q13) = LUT1,4,q12,q13(A14,q13) + µ·e1(n) · (y1(n-q12))* 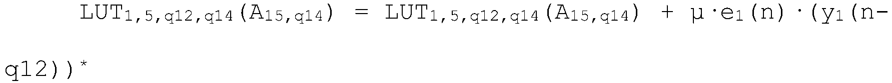 LUT1,5,q12,q14(A15,q14) = LUT1,5,q12,q14(A15,q14) + µ·e1(n) · (y1(n-q12))* 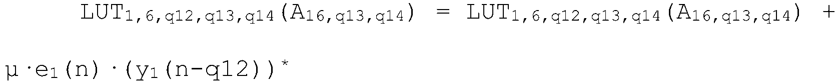 UT1,6,q12,q13,q14(A16,q13,q14) = LUT1,6,q12,q13,q14(A16,q13,q14) + µ·e1(n) · (y1(n-q12))* 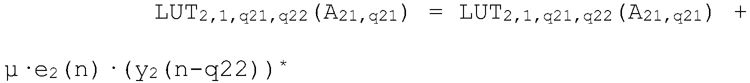 LUT2,1,q21,q22(A21,q21) = LUT2,1,q21,q22(A21,q21)+ µ·e2(n) · (y2(n-q22))* 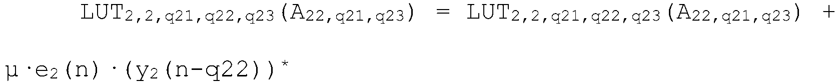 LUT2,2,q21,q22,q23(A22,q21,q23) = LUT2,2,q21,q22,q23(A22,q21,q23) + µ·e2(n) · (y2(n-q22))* 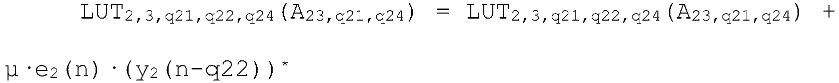 UT2,3,q21,q22,q24(A23,q21,q24) = LUT2,3,q21,q22,q24(A23,q21,q24) + µ·e2(n) · (y2(n-q22))* 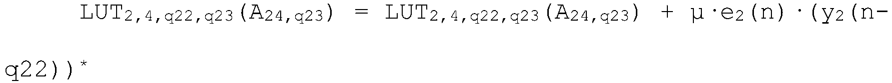 LUT2,4,q22,q23(A24,q23) = LUT2,4,q22,q23(A24,q23) + µ·e2(n) · (y2(n-q22))* 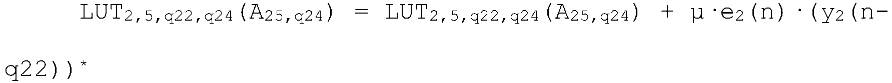 LUT2,5,q22,q24(A25,q24) = LUT2,5,q22,q24(A25,q24) + µ·e2(n) · (y2(n-q22))* 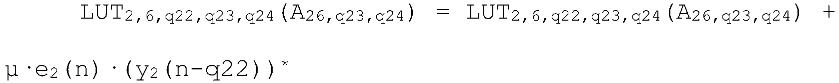 LUT2,6,q22,q23,q24(A26,q23,q24) = LUT2,6,q22,q23,q24(A26,q23,q24) + µ·e2(n) · (y2(n-q22))* 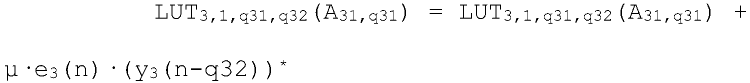 LUT3,1,q31,q32(A31,q31) = LUT3,1,q31,q32(A31,q31) + µ·e3(n) · (y3(n-q32))* 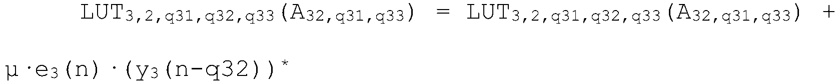 UT3,2,q31,q32,q33(A32,q31,q33) = LUT3,2,q31,q32,q33(A32,q31,q33) + µ·e3(n) · (y3(n-q32))* 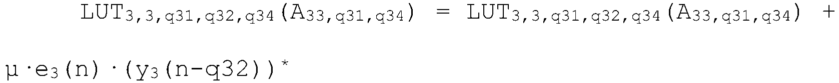 LUT3,3,q31,q32,q34(A33,q31,q34) = LUT3,3,q31,q32,q34(A33,q31,q34) + µ·e3(n) · (y3(n-q32))* 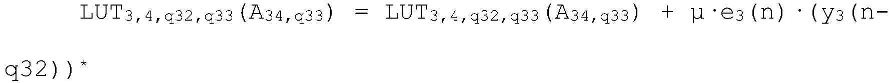 LUT3,4,q32,q33(A34,q33) = LUT3,4,q32,q33(A34,q33) +µ·e3(n)·(y3(n-q32))* 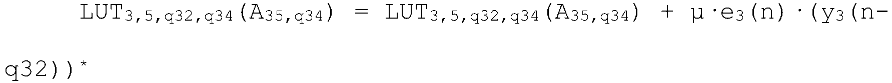 UT3,5,q32,q34(A35,q34) =LUT3,5,q32,q34(A35,q34)+µ·e3(n) · (y3(n-q32))* 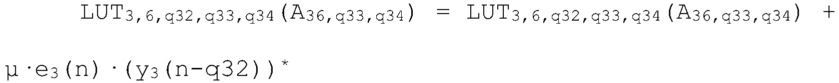 LUT3,6,q32,q33,q34(A36,q33,q34) = LUT3,6,q32,q33,q34(A36,q33,q34) + µ·e3(n) · (y3(n-q32))*

### (h) Eighth Embodiment

In each of the above embodiments, the case where distortion compensation is performed for each band has been described as an example, but the radio equipment 1 may perform distortion compensation for each carrier. Bands have bandwidths allocated to mobile operators. The mobile operators are free to determine the placement of carriers within each band.

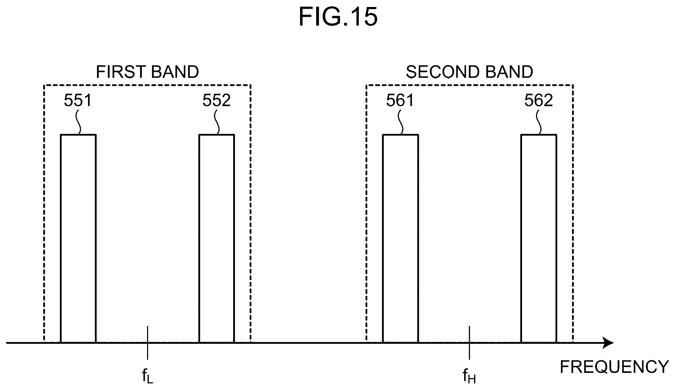

FIG. 15 is a diagram illustrating the relationship between bands and carriers. The radio equipment 1 can handle transmission signals, for example, with respect to two carriers in each of the first and second bands.

The address generation unit 11, the distortion compensation coefficient calculation unit 12, and the multiplier 131 of the radio equipment 1 can perform the distortion compensation process collectively for the respective transmission signals of carriers 551 and 552 in the first band. The address generation unit 11, the distortion compensation coefficient calculation unit 12, and the multiplier 132 can perform the distortion compensation process collectively for the respective transmission signals of carriers 561 and 562 in the second band.

When the distortion compensation process for a first carrier is performed, the address generation unit 11, the distortion compensation coefficient calculation unit 12, and the multiplier 131 may perform the distortion compensation process for the carrier 551 as a transmission signal and, independently of it, perform the distortion compensation process for the carrier 552 as a transmission signal. Similarly, when the distortion compensation process for a second carrier is performed, the address generation unit 11, the distortion compensation coefficient calculation unit 12, and the multiplier 132 may perform the distortion compensation process for the carrier 561 as a transmission signal and, independently of it, perform the distortion compensation process for the carrier 562 as a transmission signal.

In each of the above embodiments and each of the above modifications, the radio equipment 1 may perform distortion compensation for each carrier.

### (i) Ninth Embodiment

A ninth embodiment will now be described. In the radio equipment 1 according to each of the above embodiments, nonlinear distortion is suppressed in the vicinity of the first and second bands. For example, if the first transmission signal is transmitted in a bandwidth BW1 and the second transmission signal is transmitted in a bandwidth BW2, linear distortion within bandwidths DPD-BW1 and DPD-BW2, which are three to five times wider than the bandwidths BW1 and BW2, is suppressed. However, third-order distortion occurs in 2f_{L}-f_{H} and 2f_{H}-f_{L} bands. Fifth-order distortion occurs in 3f_{L}-2f_{H} and 3f_{H}-2f_{L} bands. There is a possibility that nonlinear distortion that occurs in the bands away from the bandwidths BW1 and BW2, such as third-order and fifth-order distortions, is not suppressed. The radio equipment 1 according to the present embodiment then suppresses the nonlinear distortion that occurs in the bands away from the bandwidths BW1 and BW2.

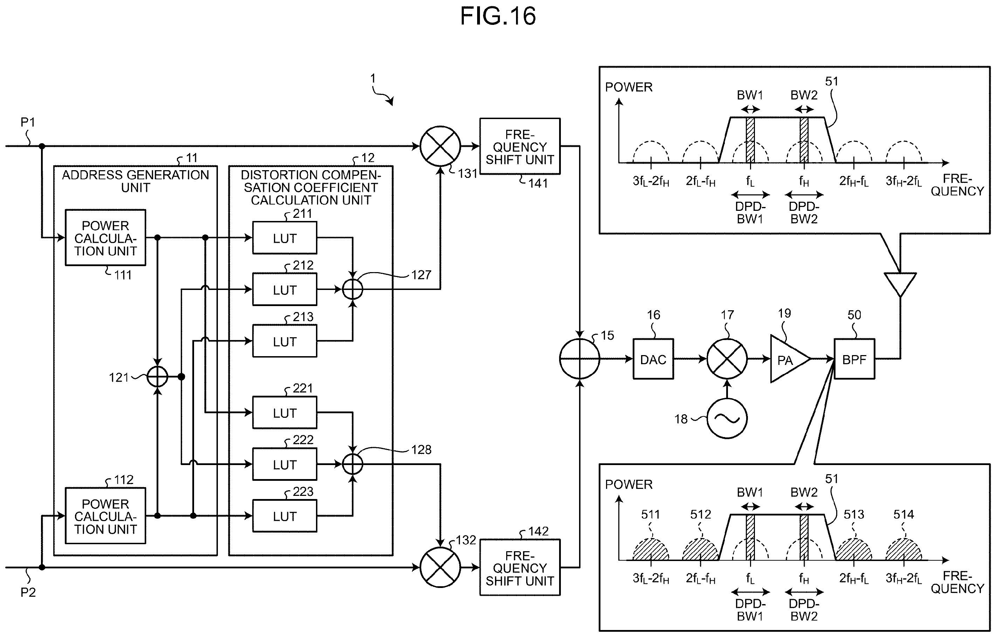

FIG. 16 is a diagram illustrating the suppression of unnecessary waves outside the band of the transmission signal. The radio equipment 1 according to the present embodiment includes a BPF 50 between the PA 19 and the antenna.

The BPF 50 has a passband characteristic that attenuates nonlinear distortion in the bands away from the bandwidths BW1 and BW2. For example, the BPF 50 has a passband characteristic 51 in FIG. 16.

The BPF 50 attenuates a signal outside the range of the passband characteristic 51. With this configuration, the BPF 50 can attenuate third-order distortions 512 and 513 and fifth-order distortions 511 and 514 in the bands away from the bandwidths BW1 and BW2 of the first and second transmission signals, in a signal passing through. The signal with attenuated nonlinear distortion in the bands away from the bandwidths BW1 and BW2 of the first and second transmission signals is then emitted into space as a radio wave from the antenna.

The BPF 50 can be applied to any of the above embodiments and modifications.

As explained above, the radio equipment 1 according to the present embodiment can attenuate nonlinear distortion in the bands away from the bandwidth of a transmission signal and enable transmission of a less distorted signal.

In one aspect, the present invention can suppress the leakage power of adjacent channels.
In any of the above aspects, the various features may be implemented in hardware, or as software modules running on one or more processors/computers.
The invention also provides a computer program or a computer program product comprising instructions which, when executed by a computer, cause the computer to carry out any of the methods/method steps described herein, and a non-transitory computer-readable medium comprising instructions which, when executed by a computer, cause the computer to carry out any of the methods/method steps described herein. A computer program embodying the invention may be stored on a non-transitory computer-readable medium, or it could, for example, be in the form of a signal such as a downloadable data signal provided from an Internet website, or it could be in any other form.

## Claims

1. An information processing device (1) comprising:
a first determination unit (212, 222) configured to determine a first distortion compensation coefficient, based on a power or amplitude of a first signal and a power or amplitude of a second signal;
a first signal generation unit (131) configured to generate a third signal, based on the first signal and the first distortion compensation coefficient;
a second signal generation unit (132) configured to generate a fourth signal, based on the second signal and the first distortion compensation coefficient; and
a third signal generation unit (15) configured to generate a fifth signal, based on the third signal and the fourth signal.

2. The information processing device (1) according to claim 1, wherein the first determination unit (212, 222) determines the first distortion compensation coefficient using a look-up table.

3. The information processing device (1) according to claim 1 or claim 2, further comprising a second determination unit (127, 128) configured to determine a second distortion compensation coefficient based on the first signal or the second signal, and determines a third distortion compensation coefficient, based on the first distortion compensation coefficient and the second distortion compensation coefficient, wherein
the first signal generation unit (131) generates the third signal, based on the first signal and the third distortion compensation coefficient, and
the second signal generation unit (132) generates the fourth signal, based on the second signal and the third distortion compensation coefficient.

4. The information processing device (1) according to claim 1 or claim 2, further comprising a third determination unit (127, 128) configured to determine a fourth distortion compensation coefficient based on the first signal, determine a fifth distortion compensation coefficient based on the second signal, and determine a sixth distortion compensation coefficient, based on the first distortion compensation coefficient, the fourth distortion compensation coefficient, and the fifth distortion compensation coefficient, wherein
the first signal generation unit (131) generates the third signal, based on the first signal and the sixth distortion compensation coefficient, and
the second signal generation unit (132) generates the fourth signal, based on the second signal and the sixth distortion compensation coefficient.

5. The information processing device (1) according to any of the preceding claims, further comprising:
a first delay addition unit (134, 135) configured to add a same or different first delay to each of the first signal and the second signal; and
a second delay addition unit (101, 102) configured to add a same or different second delay to each of the power or amplitude of the first signal and the power or amplitude of the second signal, wherein
the first determination unit (212, 222) determines the first distortion compensation coefficient, based on the power or amplitude of the first signal and the power or amplitude of the second signal to which the second delay is added,
the first signal generation unit (131) generates the third signal, based on the first signal to which the first delay is added and the first distortion compensation coefficient, and
the second signal generation unit (132) generates the fourth signal, based on the second signal to which the first delay is added and the first distortion compensation coefficient.

6. The information processing device (1) according to any of the preceding claims, further comprising:
a feedback unit (20) configured to generate a feedback signal from the fifth signal amplified; and
a coefficient updating unit (30) configured to update the first distortion compensation coefficient, based on the feedback signal and the first and second signals.

7. The information processing device (1) according to claim 6, wherein
the coefficient updating unit (30) extracts a first feedback signal corresponding to the first signal by suppressing a signal outside a band of the first signal in the feedback signal by filtering, extracts a second feedback signal corresponding to the second signal by suppressing a signal outside a band of the second signal in the feedback signal by filtering, and updates the first distortion compensation coefficient based on the first signal, the first feedback signal, the second signal, and the second feedback signal.

8. The information processing device (1) according to claim 6, wherein the coefficient updating unit (30) extracts a first feedback signal corresponding to the first signal by excluding the second signal from the feedback signal, extracts a second feedback signal corresponding to the second signal by excluding the first signal from the feedback signal, and updates the first distortion compensation coefficient based on the first signal, the first feedback signal, the second signal, and the second feedback signal.

9. The information processing device (1) according to claim 6, wherein the coefficient updating unit (30) updates the first distortion compensation coefficient by adding a third delay to the feedback signal and/or adding a fourth delay to the first signal and the second signal to align timing and compare the feedback signal and the first and second signals.

10. The information processing device (1) according to any of the preceding claims, further comprising:
an amplifier (19) configured to amplify the fifth signal; and
a suppression unit (50) configured to suppress nonlinear distortion of a signal output from the amplifier (19) in a band a predetermined frequency away from a bandwidth of the first signal and a bandwidth of the second signal.

11. A communication device (1) comprising:
a first determination unit (212, 222) configured to determine a first distortion compensation coefficient, based on a power or amplitude of a first signal and a power or amplitude of a second signal;
a first signal generation unit (131) configured to generate a third signal, based on the first signal and the first distortion compensation coefficient;
a second signal generation unit (132) configured to generate a fourth signal, based on the second signal and the first distortion compensation coefficient;
a third signal generation unit (15) configured to generate a fifth signal, based on the third signal and the fourth signal; and
an amplifier (19) configured to amplify the third signal and outputs the amplified third signal from an antenna.

12. An information processing method carried out by a computer (1) to execute a process comprising:
determining a first distortion compensation coefficient, based on a power or amplitude of a first signal and a power or amplitude of a second signal;
generating a third signal, based on the first signal and the first distortion compensation coefficient;
generating a fourth signal, based on the second signal and the first distortion compensation coefficient; and
generating a fifth signal, based on the third signal and the fourth signal.
